# EUROPÄISCHE PATENTSCHRIFT

(11) **EP 2 007 779 B1**
(45) Veröffentlichungstag und Bekanntmachung des Hinweises auf die Patenterteilung: **21.03.2012**
(21) Anmeldenummer: 07727684.8
(22) Anmeldetag: 03.04.2007
(51) Int. Cl.: C07F 15/00

(54) **HETEROLEPTISCHE ÜBERGANGSMETALL-CARBEN-KOMPLEXE UND DEREN VERWENDUNG IN ORGANISCHEN LEUCHTDIODEN (OLEDS)**
HETEROLEPTIC TRANSITION METAL-CARBENE COMPLEXES AND THEIR USE IN ORGANIC LIGHT-EMITTING DIODES (OLEDS)
COMPLEXES CARBENE-METAL DE TRANSITION HETEROLEPTIQUES ET LEUR UTILISATION DANS DES DIODES ELECTROLUMINESCENTES ORGANIQUES (OLED)

(30) Priorität: 05.04.2006 EP 06112228
(43) Veröffentlichungstag der Anmeldung: 31.12.2008
(73) Patentinhaber: BASF SE, 67056 Ludwigshafen (DE)
(72) Erfinder: FUCHS, Evelyn, 68199 Mannheim (DE); EGEN, Martina, 69221 Dossenheim (DE); KAHLE, Klaus, 67069 Ludwigshafen (DE); LENNARTZ, Christian, 67105 Schifferstadt (DE); MOLT, Oliver, 69493 Hirschberg (DE); NORD, Simon, 67354 Römerberg (DE); KOWALSKY, Wolfgang, 38116 Braunschweig (DE); SCHILDKNECHT, Christian, 38112 Braunschweig (DE); JOHANNES, Hans-Hermann, 38124 Braunschweig (DE)
(86) Internationale Anmeldenummer: PCT/EP2007/053213
(87) Internationale Veröffentlichungsnummer: WO 2007/115970

(56) Entgegenhaltungen:
- WO-A-2006/018292

## Beschreibung

Die vorliegende Erfindung betrifft heteroleptische Carbenkomplexe enthaltend mindestens zwei verschiedene Carbenliganden, ein Verfahren zur Herstellung der heteroleptischen Carbenkomplexe, die Verwendung der heteroleptischen Carbenkomplexe in organischen Leuchtdioden, organische Leuchtdioden enthaltend mindestens einen erfindungsgemäßen heteroleptischen Carbenkomplex, eine Licht-emittierende Schicht, enthaltend mindestens einen erfindungsgemäßen heteroleptischen Carbenkomplex, organische Leuchtdioden, enthaltend mindestens eine erfindungsgemäße Licht-emittierende Schicht sowie Vorrichtungen, die mindestens eine erfindungsgemäße organische Leuchtdiode enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, zum Beispiel für Anwendungen in Handys, Laptops usw.

Die Grundprinzipien der Funktionsweise von OLEDs sowie geeignete Aufbauten (Schichten) von OLEDs sind zum Beispiel in WO 2005/113704 und der darin zitierten Literatur genannt.

Im Stand der Technik wurden bereits zahlreiche Materialien vorgeschlagen, die bei der Anregung durch elektrischen Strom Licht emittieren.

In WO 2005/019373 ist erstmals die Verwendung von neutralen Übergangsmetallkomplexen, die mindestens einen Carbenliganden enthalten, in OLEDs offenbart. Diese Übergangsmetallkomplexe können gemäß WO 2005/019373 in jeder Schicht eines OLEDs eingesetzt werden, wobei das Ligandgerüst oder Zentralmetall zur Anpassung an gewünschte Eigenschaften der Übergangsmetallkomplexe variiert werden kann. Beispielsweise ist der Einsatz der Übergangsmetallkomplexe in einer Blockschicht für Elektronen, einer Blockschicht für Excitonen, einer Blockschicht für Löcher oder der Licht-emittierenden Schicht des OLEDs möglich, wobei die Übergangsmetallkomplexe bevorzugt als Emittermoleküle in OLEDs eingesetzt werden.

WO 2005/113704 betrifft lumineszierende Verbindungen, die Carbenliganden tragen. Gesäß WO 2005/113704 sind zahlreiche Übergangsmetallkomplexe mit verschiedenen Carbenliganden genannt, wobei die Übergangsmetallkomplexe bevorzugt als phosphoreszierendes Licht-emittierendes Material, besonders bevorzugt als Dotiersübstanz, eingesetzt werden.

WO 2006/018292 betrifft die Verwendung von polymeren Materialien enthaltend mindestens einen Übergangsmetallcarbenkomplex in organischen Leuchtdioden. Die Übergangsmetallcarbenkomplexe gemäß WO 2006/018292 können homo- oder heteroleptisch sein.

Obwohl bereits Verbindungen bekannt sind, die zum Einsatz in OLEDs, insbesondere als Licht-emittierende Substanzen, geeignet sind, ist die Bereitstellung von effizienteren Verbindungen, die technisch einsetzbar sind, wünschenswert. Im Sinne der vorliegenden Anmeldung ist unter Elektrolumineszenz sowohl Elektrofluoreszenz als auch Eiektrophosphoreszenz zu verstehen.

Aufgabe der vorliegenden Anmeldung ist daher die Bereitstellung von neuartigen Carbenkomplexen, die zum Einsatz in OLEDs geeignet sind. Insbesondere ist die Bereitstellung von Obergangsmetallkomplexen wünschenswert, die Elektrolumineszenz mit guten Effizienzen zeigen. Des Weiteren soll mit den neuartigen Carbenkomplexen ein "Farb-Finetuning" bei gleichzeitig guter Effizienz ermöglicht werden.

Diese Aufgabe wird durch die Bereitstellung von heteroleptischen Carbenkomplexen der allgemeinen Formel (1) gelöst

M¹[carben]ₙ (I)

enthaltend mindestens zwei verschiedene Carbenliganden,
worin die Symbole die folgenden Bedeutungen aufweisen:
- M¹: Metallatom ausgewählt aus der Gruppe,bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metalle atom möglichen Oxidationsstufe;
- n: Zahl der Carbenliganden, wobei n mindestens 2 ist;
wobei n von der Oxidationsstufe und Koordinationszahl des eingesetzten Metallatoms und von der Zähnigkeit sowie von der Ladung der Liganden carben abhängig ist;
carben Carbenligand der allgemeinen Formel (11) 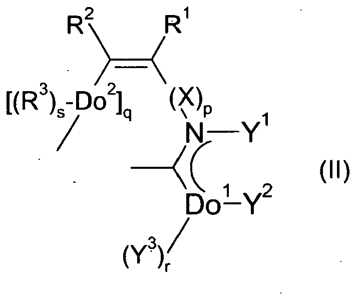 wobei die Symbole in dem Carbenliganden der allgemeinen Formel II die folgenden Bedeutungen aufweisen:
- Do¹: Donoratom ausgewählt aus der Gruppe bestehend aus C, P, N, O, S und Si, bevorzugt P, N, O und S;
- Do²: Donoratom ausgewählt aus der Gruppe bestehend aus C, N, P, O und S;
- r: 2, wenn Do¹ C oder Si ist, 1, wenn Do¹ N oder P ist und 0, wenn Do¹ Ooder S ist;
- s: 2, wenn Do² C ist, 1, wenn Do² N oder P ist und 0, wenn Do² O oder S ist;
- X: Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴ BR¹⁵, O, S, SO, SO₂, CO, CO-O, O-CO ersetzt sein können;
- w: 2 bis 10;
- R¹³, R¹⁴, R¹⁵, R¹⁶, R¹⁷: H, Alkyl, Aryl, Heteroaryl, Alkenyl, Alkinyl;
- p: 0 oder 1;
- q: 0 oder 1;
- Y¹, Y²: jeweils unabhängig voneinander Wasserstoff oder eine kohlenstoffhaltige Gruppe ausgewählt aus der Gruppe bestehend aus Alkyl-, Aryl-, Heteroaryl-, Alkinyl-und Alkenylgruppen;
oder
Y¹ und Y² bilden gemeinsam eine Brücke zwischen dem Donoratom Do¹ und dem Stickstoffatom N, die mindestens zwei Atome aufweist, wovon mindestens eines ein Kohlenstoffatom ist,
- R¹, R²: unabhängig voneinander Wasserstoff, Alkyl-, Aryl-, Heteroaryl-, Alkinyl- oder Alkenylreste,
oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 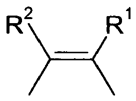 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann und der fünf- bis siebengliedrige Ring gegebenenfalls mit einem oder mehreren weiteren Ringen, bevorzugt sechsgliedrigen aromatischen Ringen, anelliert sein kann;
weiterhin können Y¹ und R¹ über eine Brücke miteinander verknüpft sein, wobei die Brücke die folgenden Bedeutungen aufweisen kann:

Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten;
- R³: Wasserstoff, ein Alkyl-, Aryl-, Heteroaryl-, Alkinyl- oder Alkenylrest;
dadurch gekennzeichnet, dass die mindestens 2 Carbenliganden verschiedene Bedeutungen Y³ aufweisen, wobei
Y³ in mindestens einem ersten Carbenliganden (IIa) die folgende Bedeutung aufweist: Wasserstoff, ein Alkyl-, Alkinyl- oder Alkenylrest,
wobei, wenn Do' C oder Si ist und r 2 bedeutet, beide Reste Y³ die vorstehend genannten Bedeutungen aufweisen;
und
Y³ in mindestens einem zweiten Carbenliganden (IIb) die folgende Bedeutung aufweist: 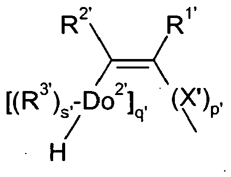 wobei Do², q', s', R^{3'} , R^{1'}, R^{2'}, X' und p' unabhängig die gleichen Bedeutungen wie Do², q, s, R³, R^{1'}, R², X und p aufweisen, und
wenn Do' C oder Si ist und r 2 bedeutet, mindestens einer der beide Resten Y³ die vorstehend genannte Bedeutung aufweist; der zweite Rest Y³ kann die vorstehend genannte Bedeutung oder die bezüglich des ersten Carbenliganden für Y³ genannten Bedeutungen aufweisen; und
Y³ in einem dritten oder weiteren Carbenliganden in heteroleptischen Carbenkomplexen der allgemeinen Formel I worin n > 2 ist, entweder die in dem ersten Carbenliganden (IIa) genannten Bedeutungen oder die in dem zweiten Carbenliganden (IIb) genannte Bedeutung aufweist;
weiterhin können Y³ und Y² in jedem der n Carbenliganden über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
- y: 2 bis 10;
und
- R²⁵, R²⁶, R²⁷, R²⁸, R²⁹, R³², R³³: H, Alkyl, Aryl, Heteroaryl, Alkenyl, Alkinyl
bedeuten;

Somit handelt es sich bei dem Carbenliganden der allgemeinen Formel II in dem Fall, wenn Do' O oder S bedeutet, um einen unsymmetrischen Carbenliganden im Sinne der vorliegenden Anmeldung,.

Die erfindungsgemäßen heteroleptischen Carbenkomplexe der Formel I zeichnen sich somit dadurch aus, dass sie mindestens zwei verschiedene Carbenliganden aufweisen (mindestens einen ersten Carbenliganden IIa und mindestens einen zweiten Carbenliganden IIb). In Abhängigkeit von der Oxidationsstufe und Koordinationszahl des eingesetzten Metallatoms M¹ und von der Zähnigkeit sowie von der Ladung der Liganden Carben können neben dem ersten Carbenliganden IIa und dem zweiten Carbenliganden IIb in dem erfindungsgemäßen heteroleptischen Carbenkomplex weitere Carbenliganden vorliegen. Die Struktur dieser Carbenliganden kann entweder der Struktur des ersten Carbenliganden IIa oder der Struktur des zweiten Carbenliganden IIb entsprechen, wobei die Substitutionsmuster der einzelnen Carbenliganden unterschiedlich sein können.

Der erste Carbenligand IIa wird im Folgenden auch als "unsymmetrischer Carbenligand" bezeichnet, während der zweite Carbenligand IIb als "symmetrischer Carbenligand" bezeichnet wird. Dabei ist unter einem symmetrischen Carbenliganden im Sinne der vorliegenden Anmeldung nicht zu verstehen, dass der Substituent Y³ Identität mit der an das N-Atom des in der allgemeinen Formel II dargestellten Carbenliganden gebundenen Gruppe aufweisen muss bzw. Do¹ N sein muss und/oder Y¹ und Y² identisch sein müssen oder gemeinsam einen exakt symmetrischen Rest bilden müssen. Die Substitutionsmuster der einzelnen Gruppen können durchaus unterschiedlich sein.

Unter einem symmetrischen Carbenliganden im Sinne der vorliegenden Anmeldung ist ein Carbenligand zu verstehen, worin die Grundstruktur des Substituenten Y³ mit der Grundstruktur der an das N-Atom in dem Carbenliganden der allgemeinen Formel II gebunden Gruppe übereinstimmt, wobei die Substitutionsmuster der Gruppen unterschiedlich sein können.

Es wurde gefunden, dass sich die erfindungsgemäßen heteroleptischen Carbenkomplexe, die mindestens einen symmetrischen Carbenliganden (zweiter Carbenligand IIb) und mindestens einen unsymmetrischen Carbenliganden (erster Carbenligand IIa) enthalten, gegenüber entsprechenden Komplexen, die identische Carbenliganden aufweisen, dadurch auszeichnen, dass man durch die unterschiedlichen Liganden (symmetrische und unsymmetrische Carbenliganden in einem Carbenkomplex) eine Feineinstellung der Emissionsfarbe erreichen kann, d. h. eine Mischung der Farben der entsprechenden reinen Carbenkomplexe mit jeweils nur einer Art Ligand, wobei überrraschenderweise die Photolumineszenz-Quantenausbeuten der gemischten Komplexe nicht zwischen den Quantenausbeuten der reinen Komplexe liegen, sondern genauso hoch sind wie die in dem effizienteren der reinen Komplexe. Es wurde somit überraschenderweise gefunden, dass man mit den erfindungsgemäßen heteroleptischen Carbenkomplexen der allgemeinen Formel I die Emissionsfarbe einstellen kann, ohne eine Verschlechterung der Quantenausbeute in Richtung der Quantenausbeute des weniger effizienten Komplexes.

In Abhängigkeit von der Koordinationszahl des eingesetzten Metalls M¹ und der Zahl der eingesetzten Carbenliganden und Nicht-Carbenliganden können verschiedene Isomere der entsprechenden Metallkomplexe bei gleichem Metall M¹ und gleicher Natur der eingesetzten Carbenliganden und Nicht-Carbenliganden vorliegen. Zum Beispiel sind bei Komplexen mit einem Metall M¹ mit der Koordinationszahl 6 (also oktaedrischen Komplexen), zum Beispiel Ir(III)-Komplexen, "fac-mer-Isomere" (facial/meridional-Isomere) möglich, wenn es sich um Komplexe der allgemeinen Zusammensetzung M(AB)₂(CD), wobei AB und CD bidentate Liganden sind, handelt. Dabei sind im Sinne der vorliegenden Anmeldung unter "fac-mer-Isomeren" die im Folgenden dargestellten Isomere zu verstehen:

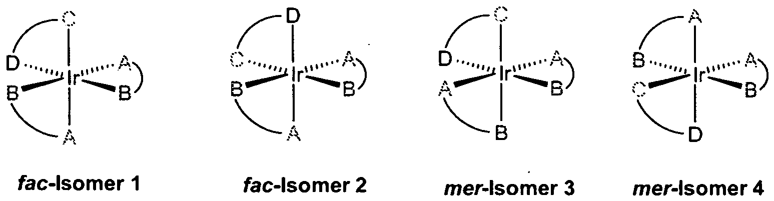

Bei quadratisch planaren Komplexen mit einem Metall M¹ mit der Koordinationszahl 4, zum Beispiel Pt(II)-Komplexen, sind "Isomere" möglich, wenn es sich um Komplexe der allgemeinen Zusammmensetzung M(AB)(CD), wobei AB und CD bidentate Liganden sind, handelt. Dabei sind im Sinne der vorliegenden Anmeldung unter "Isomeren" die im Folgenden dargestellten Isomere zu verstehen:

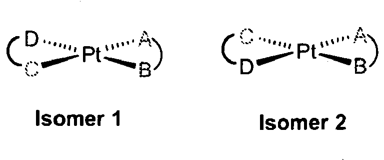

Bei den Symbolen A und B sowie C und D handelt es sich jeweils um eine Bindungsstelle eines Liganden, wobei nur bidentate Liganden vorliegen. Ein bidentater Ligand weist gemäß der vorstehend erwähnten allgemeinen Zusammensetzung eine Gruppe A und eine Gruppe B bzw. eine Gruppe C und eine Gruppe D auf.

Dem Fachmann ist grundsätzlich bekannt, was unter cis/trans- bzw. fac-mer-Isomeren zu verstehen ist. Bei Komplexen der Zusammensetzung MA₃B₃ können drei Gruppen der gleichen Art entweder die Ecken einer Oktaederfläche besetzen (faciales Isomer) oder einen Meridian, das heißt zwei der drei Ligandenbindungsstellen sind zueinander trans-ständig (meridionales Isomer). Bezüglich der Definition von cis/trans-Isomeren bzw. fac-mer-Isomeren in oktaedrischen Metallkomplexen siehe zum Beispiel J. Huheey, E. Keiter, R. Keiter, Anorganische Chemie: Prinzipien von Struktur und Reaktivität, 2., neu bearbeitete Auflage, übersetzt und erweitert von Ralf Steudel, Berlin; New York: de Gruyter, 1995, Seiten 575, 576.

Bei quadratisch planaren Komplexen bedeutet cis-Isomerie, dass bei Komplexen der Zusammensetzung MA₂B₂ sowohl die beiden Gruppen A als auch die beiden Gruppen B benachbarte Ecken eines Quadrats belegen, während sowohl die beiden Gruppen A als auch die beiden Gruppen B bei der trans-tsomerie jeweils die beiden einander diagonal gegenüber liegenden Ecken eines Quadrats belegen. Bezüglich der Definition von cis/trans-Isomeren in quadratisch planaren Metallkomplexen siehe zum Beispiel J. Huheey, E. Keiter, R, Keiter, Anorganische Chemie: Prinzipien von Struktur und Reaktivität, 2., neu bearbeitete Auflage, übersetzt und erweitert von Ralf Stendel, Berlin; New York: de Gruyter, 1995, Seiten 557 bis 559.

Im Allgemeinen können die verschiedenen Isomere der Metallkomplexe der Formel I nach dem Fachmann bekannten Verfahren, zum Beispiel durch Chromatographie, Sublimation oder Kristallisation, getrennt werden.

Die vorliegende Erfindung betrifft somit sowohl jeweils die einzelnen Isomere der Carbenkomplexe der Formel I als auch Gemische verschiedener Isomere in jedem beliebigen Mischungsverhältnis.

Besonders bevorzugt weisen die erfindungsgemäßen heteroleptischen Carbenkomplexe der allgemeinen Formel I ein Metallatom M¹ ausgewählt aus der Gruppe bestehend aus Ir, Os, Rh und Pt auf, wobei Os(II), Rh(III), Ir(III) und Pt(II) bevorzugt sind. Besonders bevorzugt ist Ir(III).

Die Zahl n der-Carbenliganden der allgemeinen Formel II beträgt in den erfindungsgemäßen heteroleptischen Carbenkomplexen der Formel I, worin das Übergangsmetallatom Ir(III) eine Koordinationszahl von 6 aufweist, im Allgemeinen 3, d.h. einen ersten (unsymmetrischen) Carbenliganden (IIa), einen zweiten (symmetrischen) Carbenliganden (IIb) und einen dritten Carbenliganden der allgemeinen Formel II, der entweder symmetrisch oder unsymmetrisch ist.

Die Zahl n der Carbenliganden beträgt in Übergangsmetallkomplexen, worin das Übergangsmetallatom Pt(II) eine Koordinationszahl von 4 aufweist, 2, d.h. einen ersten (unsymmetrischen) Carbenliganden (IIa), einen zweiten (symmetrischen) Carbenliganden (IIb).

Für die Gruppen Y¹ und Y² gilt im Sinne der vorliegenden Anmeldung (sowohl für symmetrische als auch für unsymmetrische Carbenliganden):

die Substituenten der Gruppen Y¹ und Y² können gemeinsam eine Brücke mit insgesamt zwei bis vier, bevorzugt zwei bis drei Atomen, bilden, wovon ein oder zwei Atome Heteroatome, bevorzugt N, sein können und die restlichen Atome Kohlenstoffatome sind, so dass die Gruppierung NCDo¹ gemeinsam mit dieser Brücke einen fünf- bis siebengliedrigen, bevorzugt fünf- bis sechsgliedrigen Ring bilden, der gegebenenfalls zwei - oder im Falle eines sechs- oder siebengliedrigen Rings - drei Doppelbindungen aufweisen kann und gegebenenfalls mit Alkyl- oder Arylgruppen und/oder Gruppen mit Donor- oder Akzeptorwirkung substituiert sein kann und gegebenenfalls Heteroatome, bevorzugt N, enthalten kann, wobei ein fünfgliedriger oder sechsgliedriger aromatischer Ring, der mit Alkyl- oder Arylgruppen und/oder Gruppen mit Donor- oder Akzeptorwirkung substituiert oder unsubstituiert ist, bevorzugt ist, oder der bevorzugte fünfgliedrige oder sechsgliedrige aromatische Ring ist mit weiteren Ringen, die gegebenenfalls mindestens ein Heteroatom, bevorzugt N, enthalten können, bevorzugt sechsgliedrigen aromatischen Ringen, anelliert.

Die Gruppe Y¹ kann mit dem Rest R¹ über eine Brücke verknüpft sein, wobei die Brücke die folgenden Bedeutungen aufweisen kann:

Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten.

In dem Fall, dass Y¹ und Y² gemeinsam eine Brücke bilden, wobei ein fünf- bis siebengliedriger Ring gebildet wird, kann die verknüpfende Brücke zu dem Rest R¹ direkt mit dem fünf- bis siebengliedrigen Ring verknüpft sein oder an einen Substituenten dieses Rings geknüpft sein, wobei eine direkte Verknüpfung mit dem fünf- bis siebengliedrigen Ring bevorzugt ist. Besonders bevorzugt ist das dem N-Atom (in der allgemeinen Formel II) des fünf- bis siebengliedrigen Rings direkt benachbarte Atom über eine Brücke mit R¹ verknüpft, wenn eine solche Verknüpfung vorliegt (siehe z.B. die nachstehend genannten verbrückten Strukturen). In dem Fall, dass der durch eine gemeinsame Brücke von Y¹ und Y² gebildete fünf- bis siebengliedrige Ring mit einem weiteren fünf- bis siebengliedrigen Ring anelliert ist, kann die verknüpfende Brücke mit einem Atom des anellierten Rings verknüpft sein (siehe z.B. die nachstehend genannten verbrückten Strukturen).

Im Folgenden sind bevorzugte verbrückte Strukturen beispielhaft für symmetrische und unsymmetrische Carbenliganden genannt. Die in den dargestellten Ligandsystemen dargestellten Gruppen können z.B. Substituenten tragen oder ein oder mehrere CH-Gruppen in den gezeigten aromatischen Gruppen können durch Heteroatome ersetzt sein. Es ist ebenfalls möglich, dass die Carbenliganden mehrere gleiche oder verschiedene Brücken aufweisen. Die dargestellten Brücken können auch in anderen erfindungsgemäß eingesetzten Ligandsystemen, z.B. in den nachstehend erwähnten Ligandsystemen der Formeln IIaa bis IIae und IIba bis IIbe, vorkommen.

Beispiele für unsymmetrische Carbenliganden mit verbrückten Strukturen:

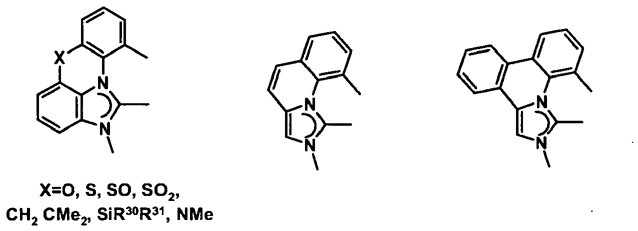

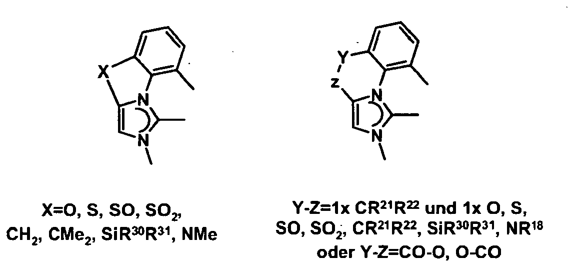

Beispiele für symmetrische Carbenliganden mit verbrückten Strukturen:

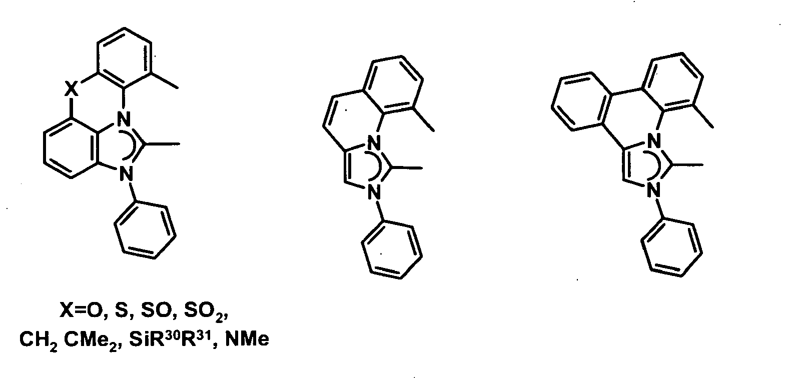

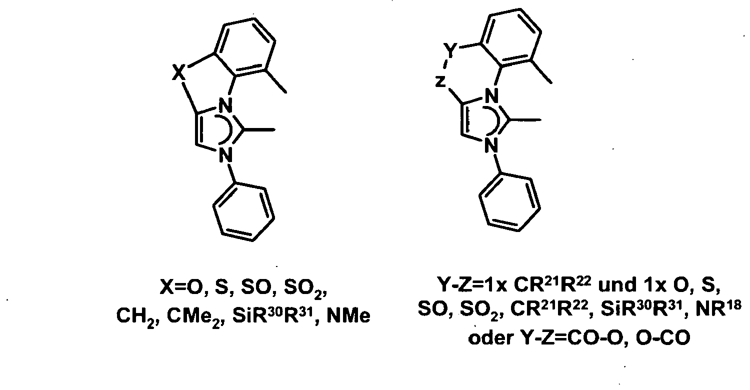

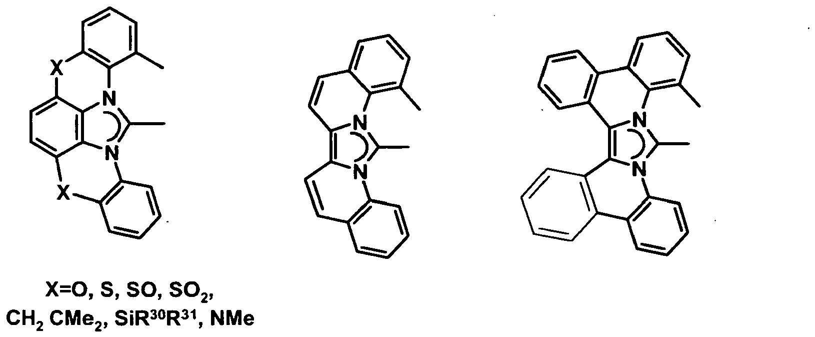

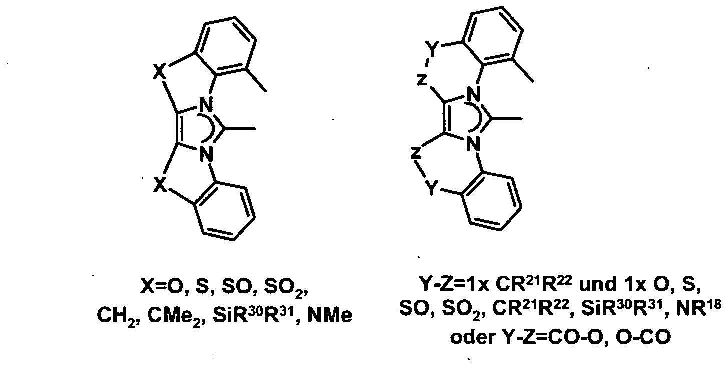

Die Reste R¹⁸, R²¹, R²², R³⁰ und R³¹ wurden bereits vorstehend definiert.

Im Sinne der vorliegenden Anmeldung haben die Begriffe Arylrest oder -gruppe, Heteroarylrest oder -gruppe, Alkylrest oder -gruppe und Alkenylrest oder -gruppe und Alkinylrest oder -gruppe die folgenden Bedeutungen:

Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Geeignete Gruppen, mit Donor- oder Akzeptorwirkung sind nachstehend genannt. Ganz besonders bevorzugt tragen die Arylreste Substituenten ausgewählt aus der Gruppe bestehend aus Methyl, F, Cl, CN, Aryloxy und Alkoxy, Sulfonyl, Heteroaryl. Bevorzugt ist der Arylrest oder die Arylgruppe ein C₆-C₁₈-Arylrest, besonders bevorzugt ein C₆-Arylrest, der gegebenenfalls mit mindestens einem der vorstehend genannten Substituenten substituiert ist. Besonders bevorzugt weist der C₆-C₁₈-Arylrest, bevorzugt C₆-Arylrest, einen oder zwei der vorstehend genannten Substituenten auf, wobei im Falle eines C₆-Arylrests der eine Substituent in ortho-, meta- oder para-Position zur weiteren Verknüpfungsstelle des Arylrestes angeordnet ist, und - im Falle von zwei Substituenten - können diese jeweils in meta-Position oder ortho-Position zur weiteren Verknüpfungsstelle des Arylrestes angeordnet sein oder ein Rest ist in ortho-Position und ein Rest in meta-Position angeordnet oder ein Rest ist in ortho- oder meta-Position angeordnet und der weitere Rest ist in para-Position angeordnet.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus Systemen wie Pyridin und fünfgliedrigen Heteroaromaten wie Pyrrol, Furan, Pyrazol, Imidazol, Thiophen, Oxazol, Thiazol. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere (Hetero-)-Arylgruppen trägt. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl und iso-Propyl.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einem Alkinylrest oder einer Alkinylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Dreifachbindung ersetzt ist. Bevorzugt weist der Alkinylrest eine oder zwei Dreifachbindungen auf.

Die Begriffe Alkylen, Arylen, Heteroarylen, Alkinylen und Alkenylen haben im Sinne der vorliegenden Anmeldung die bezüglich der Alkyl-, Aryl-, Heteroaryl-, Alkinyl- und Alkenylreste genannten Bedeutungen mit dem Unterschied, dass die Alkylen-, Arylen-, Heteroarylen-, Alkinylen- und Alkenylengruppen zwei Bindungsstellen zu Atomen des Liganden der Formel aufweise.

Unter einer aus Y¹ und Y² gebildeten Brücke, die mindestens zwei Atome aufweist, wovon mindestens eines ein Kohlenstoffatom ist und die weiteren Atome bevorzugt Stickstoff- oder Kohlenstoffatome sind, wobei die Brücke gesättigt oder bevorzugt ungesättigt sein kann und die mindestens zwei Atome der Brücke substituiert oder unsubstituiert sein können, sind bevorzugt die folgenden Gruppen zu verstehen:
- Eine Brücke, die zwei Kohlenstoffatome oder ein Kohlenstoffatom und ein Stickstoffatom aufweist, wobei die Kohlenstoffatome bzw. ein Kohlenstoffatom und ein Stickstoffatom durch eine Doppelbindung miteinander verbunden sind, so dass die Brücke eine der folgenden Formeln aufweist, wobei die Brücke bevorzugt zwei Kohlenstoffatome aufweist: 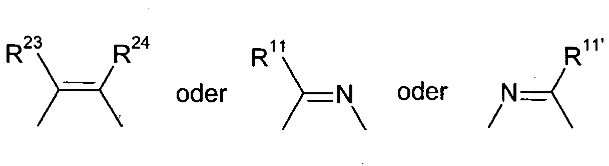 R²³, R²⁴, R¹¹ und R^{11'} bedeuten unabhängig voneinander Wasserstoff, Alkyl, Heteroaryl, Alkenyl, Alkinyl, Aryl oder ein Substituent mit Donor- oder Akzeptorwirkung, oder R²³ und R²⁴ bilden gemeinsam eine Brücke mit insgesamt 3 bis 5, bevorzugt 4, Atomen, wovon gegebenenfalls 1 bis 5 Heteroatome, bevorzugt N, sein können und die restlichen Atome Kohlenstoffatome sind, so dass diese Gruppe einen 5- bis 7-gliedrigen, bevorzugt sechsgliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann. Bevorzugt ist dabei ein sechsgliedriger aromatischer Ring. Dieser kann mit Alkyl- oder Arylgruppen und/oder Gruppen mit Donor- oder Akzeptorwirkung substituiert oder unsubstituiert sein. Des Weiteren ist es möglich, dass an diesem, bevorzugt sechsgliedrigen, aromatischen Ring ein oder mehrere weitere aromatische Ringe anelliert sind. Dabei ist jede denkbare Anellierung möglich. Diese anellierten Reste können wiederum substituiert sein, bevorzugt mit den in der allgemeinen Definition der Arylreste genannten Resten.
- Eine Brücke, die zwei Kohlenstoffatome aufweist, wobei die Kohlenstoffatome durch eine Einfachbindung miteinander verbunden sind, so dass die Brücke die folgende Formel aufweist: 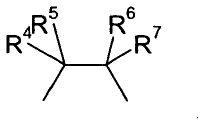 worin R⁴,
   - R⁵, R⁶ und R⁷: unabhängig voneinander Wasserstoff, Alkyl, Heteroaryl, Alkenyl, Alkinyl, Aryl oder ein Substituent mit Donor- oder Akzeptorwirkung bedeuten, bevorzugt Wasserstoff, Alkyl oder Aryl.

Unter einer Gruppe oder einem Substituenten mit Donor- oder Akzeptorwirkung sind im Sinne der vorliegenden Anmeldung die folgenden Gruppen zu verstehen:

Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen, mit Donor- oder Akzeptorwirkung sind Halogenreste, bevorzugt F, Cl, Br, besonders bevorzugt F, Alkoxyreste, Aryloxyreste, Carbonylreste, Esterreste, sowohl Oxycarbonyl als auch Carbonyloxy, Aminreste, Amidreste, CH₂F-Gruppen, CHF₂-Gruppen, CF₃-Gruppen, CN-Gruppen, Thiogruppen, Sulfonsäuregruppen, Sulfonsäureestergruppen, Boronsäuregruppen, Boronsäureestergruppen, Phosphonsäuregruppen, Phosphonsäureestergruppen, Phosphinreste, Sulfoxidreste, Sulfonylreste, Sulfidreste, Heteroarylreste, Nitrogruppen, OCN, Boranreste, Silylgruppen, Stannatreste, Iminogruppen, Hydrazinreste, Hydrazonreste, Oximreste, Nitrosogruppen, Diazogruppen, Phosphinoxidgruppen, Hydroxygruppen oder SCN-Gruppen. Ganz besonders bevorzugt sind F, Cl, CN, Aryloxy, Alkoxy, Sulfonyl und Heteroaryl.
Die Gruppierung 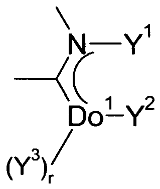 ist sowohl in den symmetrischen Carbenliganden (IIb) als auch in den unsymmetrischen Carbenliganden (IIa) bevorzugt ausgewählt aus der Gruppe bestehend aus 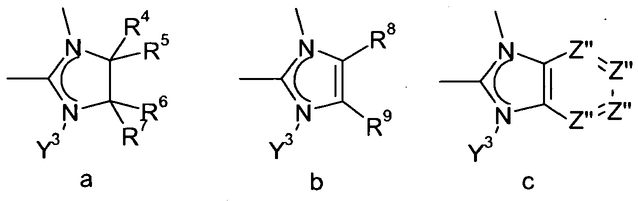 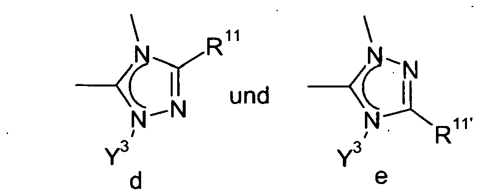 worin die Symbole die folgenden Bedeutungen aufweisen:
- Z": unabhängig voneinander CR¹⁰ oder N; bevorzugt sind 0 bis 3 der Gruppen Z" N, besonders bevorzugt 0 bis 2, ganz besonders bevorzugt 0 oder 1, wobei die übrigen Gruppen Z" CR¹⁰ bedeuten;
- R⁴, R⁵, R⁶, R⁷, R⁸, R⁹, R¹¹ und R^{11'}: Wasserstoff, Alkyl, Aryl, Heteroaryl, Alkinyl oder Alkenyl oder ein Substituent mit Donor- oder Akzeptorwirkung, bevorzugt Wasserstoff, Alkyl, Heteroaryl oder Aryl;
- R¹⁰: Wasserstoff, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom, bevorzugt N, enthalten kann, oder R¹⁰ bedeutet einen Rest mit Donor- oder Akzeptorwirkung; wobei bevorzugt mindestens ein Rest R¹⁰ H bedeutet, besonders bevorzugt mindestens zwei Reste R¹⁰ H bedeuten, ganz besonders bevorzugt drei oder vier Reste R¹⁰ H bedeuten;
weiterhin können R⁴ oder R⁵ in der Gruppierung a, R⁸ in der Gruppierung b, einer der Reste R¹⁰ in der Gruppierung c und R¹¹ in der Gruppierung d mit R¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten, wobei Beispiele betreffend bevorzugt geeignete Brücken vorstehend gezeigt sind;

Y³ bedeutet in mindestens einem ersten Carbenliganden (IIa) (unsymmetrischer Carbenligand):
Wasserstoff, ein Alkyl-, Alkinyl- oder Alkenylrest;
und
Y³ bedeutet in mindestens einem zweiten Carbenliganden (IIb) (symmetrischer Carbenligand): 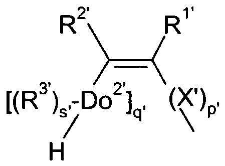 wobei Do^{2'}, q', s', R^{3'}, R^{1'}, R^{2'}, X' und p' unabhängig die gleichen Bedeutungen wie Do², q, s, R³, R¹, R², X und p aufweisen.

Die in den erfindungsgemäßen heteroleptischen Carbenkomplexen gegebenenfalls vorhandenen weiteren Carbenliganden (wenn n in den Carbenkomplexen der Formel I > 2 ist) können entweder symmetrisch oder unsymmetrisch sein. Die Gruppierung 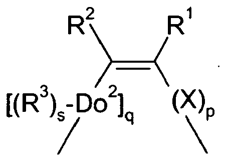 des Carbenliganden der Formel II weist sowohl in den symmetrischen Carbenliganden (IIb) als auch in den unsymmetrischen Carbenliganden (IIa) bevorzugt die Struktur 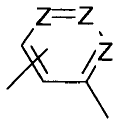 auf, worin die Symbole die folgenden Bedeutungen aufweisen:
- Z: unabhängig voneinander CR¹² oder N, wobei 0 bis 3 der Symbole Z N bedeuten können, bevorzugt 0 bis 2, besonders bevorzugt 0 oder 1, und Z in dem Fall, dass 1 Symbol Z N bedeutet, in o-, m- oder p-Position, bevorzugt in o- oder p-Position, zur Verknüpfungsstelle der Gruppierung mit der Guppierung 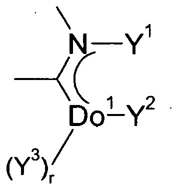 angeordnet sein kann;
- R¹²: in den Gruppen Z unabhängig voneinander H, ein Alkyl-, Aryl-, Heteroaryl-, Alkinyl-, Alkenylrest oder jeweils 2 Reste R¹² bilden gemeinsam einen anellierten Ring, der gegebenenfalls mindestens ein Heteroatom, bevorzugt N, enthalten kann, oder R¹² bedeutet einen Rest mit Donor- oder Akzeptorwirkung; bevorzugt H oder ein Rest mit Donor- oder Akzeptorwirkung;
weiterhin kann die Gruppe der Struktur 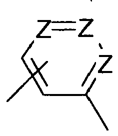 über den aromatischen Grundkörper oder über einen der Reste R¹² mit Y¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten.

Der Rest Y³ bedeutet in den unsymmetrischen Carbenliganden (IIa) erfindungsgemäß Wasserstoff, ein Alkyl-, Alkinyl- oder Alkenylrest, wobei, wenn in den Carbenliganden der allgemeinen Formel II Do¹ C oder Si ist und r 2 bedeutet, beide Reste Y³ die vorstehend genannten Bedeutungen aufweisen. In einer bevorzugten Ausführungsform ist Do¹ N und r 1. Bevorzugte Alkyl-, Alkinyl- und Alkenylreste sind vorstehend genannt. Besonders bevorzugt ist der Rest Y³ in den unsymmetrischen Carbenliganden ein Alkylrest, ganz besonders bevorzugt Methyl, Ethyl, iso-Propyl, n-Propyl, n-Butyl, iso-Butyl oder tert-Butyl, insbesondere besonders bevorzugt Methyl oder iso-Propyl.

Der Rest Y³ bedeutet in den symmetrischen Carbenliganden (IIb) erfindungsgemäß: 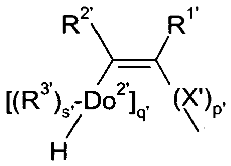 wobei Do^{2'} , q', s', R^{3'}, R^{1'}, R^{2'}, X' und p' unabhängig die gleichen Bedeutungen wie Do², q, s, R³, R¹, R², X und p - die bereits vorstehend definiert sind - aufweisen, und wenn Do¹ C oder Si ist und r 2 bedeutet, mindestens einer der beide Resten Y³ die vorstehend genannten Bedeutungen aufweist; der zweite Rest Y³ kann die vorstehend genannte Bedeutung oder die bezüglich des unsymmetrischen Carbenliganden für Y³ genannten Bedeutungen aufweisen. In einer bevorzugten Ausführungsform ist Do¹ N und r 1, d.h. der Rest Y³ weist die vorstehend genannte Bedeutung auf.

In einer bevorzugten Ausführungsform der vorliegenden Erfindung weist die Gruppe 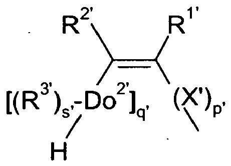 in den symmetrischen Carbenliganden die folgende Bedeutung auf: 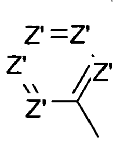 worin die Symbole die folgenden Bedeutungen aufweisen:
- Z': unabhängig voneinander CR^{12'} oder N, wobei 0 bis 5 der Symbole Z' N bedeuten können, bevorzugt 0 bis 4, besonders bevorzugt 0 bis 3, ganz besonders bevorzugt 0 bis 2, insbesondere ganz besonders bevorzugt 0 oder 1, und Z' in dem Fall, dass 1 Symbol Z' N bedeutet, in o-, m- oder p-Position, bevorzugt in o- oder p-Position, zur Verknüpfungsstelle der Gruppierung mit der Gruppierung 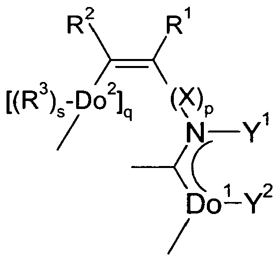 angeordnet sein kann;
- R^{12'}: in den Gruppen Z' unabhängig voneinander H, ein Alkyl-, Aryl-, Heteroaryl-, Alkinyl-, Alkenylrest oder jeweils 2 Reste R^{12'} bilden gemeinsam einen anellierten Ring, der gegebenenfalls mindestens ein Heteroatom, bevorzugt N, enthalten kann, oder R^{12'} bedeutet einen Rest mit Donor- oder Akzeptorwirkung; bevorzugt H oder ein Rest mit Donor- oder Akzeptorwirkung;
weiterhin kann die Gruppe der Struktur 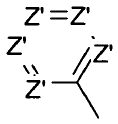 über den aromatischen Grundkörper oder über einen der Reste R^{12'} mit Y¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰ R³¹: H, Alkyl, Aryl, Heteroaryl, Alkenyl, Alkinyl
bedeuten.

Falls in den heteroleptischen Carbenkomplexen der allgemeinen Formel I n > 2 ist, z.B. n = 3 für M¹ = Ir(III), kann der weitere Rest bzw. können die weiteren Reste Y³ entweder die bezüglich des ersten (unsymmetrischen) Carbenliganden (IIa) genannten Bedeutungen oder die bezüglich des zweiten (symmetrischen) Carbenliganden (IIb) genannte Bedeutung aufweisen.

Weiterhin können Y³ und Y² in jedem der n Carbenliganden der allgemeinen Formel II über eine Brücke miteinander verknüpft sein, wobei die Brücke die folgenden Bedeutungen aufweisen kann:

Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
- y: 2 bis 10;
und
- R²⁵, R²⁶, R²⁷, R²⁸, R²⁹, R³², R³³: H, Alkyl, Aryl, Heteroaryl, Alkenyl, Alkinyl
bedeuten.

In einer ganz besonders bevorzugten Ausführungsform betrifft die vorliegende Erfindung heteroleptische Carbenkomplexe der Formel I, worin der mindestens eine erste (unsymmetrische) Carbenligand ausgewählt ist aus der Gruppe bestehend aus: 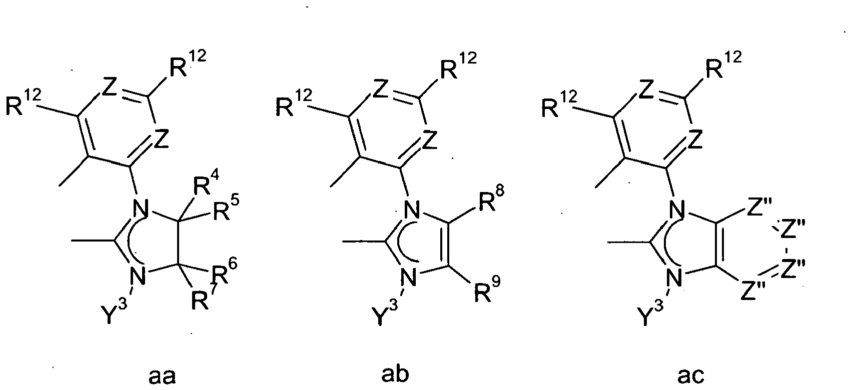 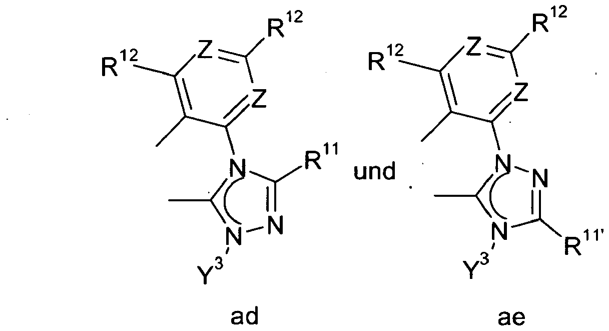 worin die Symbole die folgenden Bedeutungen aufweisen:
- Z: gleich oder verschieden CR¹² oder N;
- Z": gleich oder verschieden CR¹⁰ oder N;
- R¹²: unabhängig voneinander H, ein Alkyl-, Aryl-, Heteroaryl-, Alkinyl- oder Alkenylrest, oder jeweils 2 Reste R¹² bilden gemeinsam einen anellierten Ring, der gegebenenfalls mindestens ein Heteroatom enthalten kann, oder R¹² bedeutet einen Rest mit Donor- oder Akzeptorwirkung;
- R⁴, R⁵, R⁶, R⁷, R⁸, R⁹, R¹¹ und R^{11'}: Wasserstoff, Alkyl, Aryl, Heteroaryl, Alkinyl oder Alkenyl oder ein Rest mit Donor- oder Akzeptorwirkung;
- R¹⁰: in den Gruppen Z" unabhängig voneinander H, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 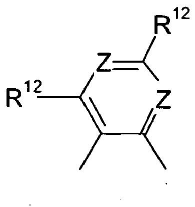 über den aromatischen Grundkörper oder über einen der Reste R¹² mit R⁴ oder R⁵ oder dem Kohlenstoffatom, mit dem R⁴ und R⁵ verknüpft sind, in der Gruppierung aa, R⁸ oder dem Kohlenstoffatom, mit dem R⁸ verknüpft ist, in der Gruppierung ab, einen der Reste R¹⁰ oder einem der Kohlenstoffatome, mit dem R¹⁰ verknüpft ist, in der Gruppierung ac und R¹¹ oder dem Kohlenstoffatom, mit dem R¹¹ verknüpft ist, in der Gruppierung ad über eine Brücke verknüpft sein, wobei die Brücke die folgenden Bedeutungen aufweisen kann:

Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten;
wobei in den Fällen, worin die Gruppe der Struktur 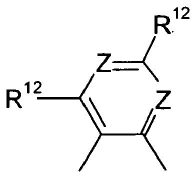 über eine Brücke mit dem Kohlenstoffatom, mit dem R⁴ und R⁵ verknüpft sind (Gruppierung aa), dem Kohlenstoffatom, mit dem R⁸ verknüpft ist (Gruppierung ab), einem der Kohlenstoffatome, mit dem R¹⁰ verknüpft ist (Gruppierung ac) oder dem Kohlenstoffatom, mit dem R¹¹ verknüpft ist (Gruppierung ad), verknüpft ist, der jeweilige Rest R⁴ oder R⁵, R⁸, einer der Reste R¹⁰ oder R¹¹ durch eine Bindung zu der Brücke ersetzt ist;
- Y³: ein Alkyl-, Alkinyl- oder Alkenylrest.

In einer weiteren ganz besonders bevorzugten Ausführungsform betrifft die vorliegende Erfindung heteroleptische Carbenkomplexe der Formel I, worin der mindestens eine zweite (symmetrische) Carbenligand ausgewählt ist aus der Gruppe bestehend aus: 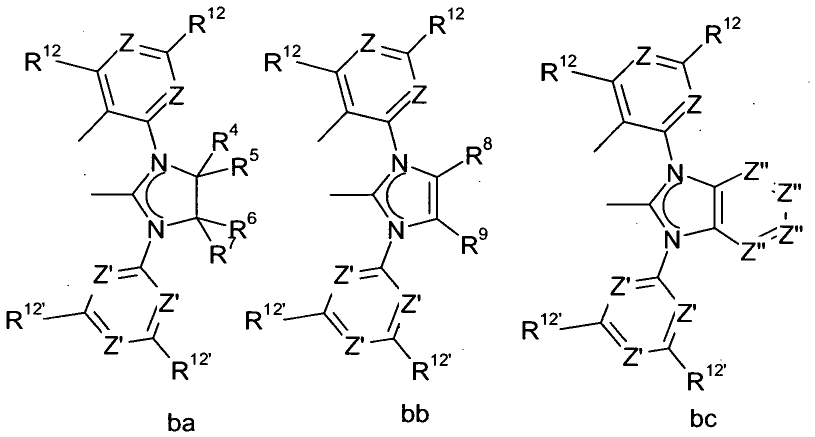 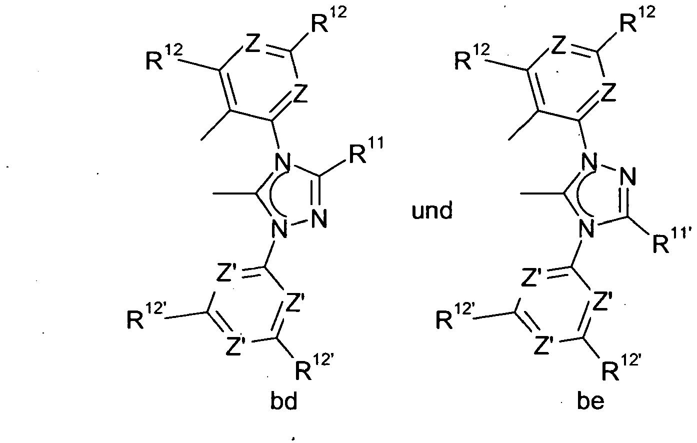 worin die Symbole die folgenden Bedeutungen aufweisen:
- Z: gleich oder verschieden CR¹² oder N;
- Z': gleich oder verschieden CR^{12'} oder N;
- Z": gleich oder verschieden CR¹⁰ oder N;
- R¹², R^{12'}: gleich oder verschieden jeweils unabhängig voneinander H, ein Alkyl-, Aryl-, Heteroaryl-, Alkinyl- oder Alkenylrest, oder jeweils 2 Reste R¹² bzw. R^{12'} bilden gemeinsam einen anellierten Ring, der gegebenenfalls mindestens ein Heteroatom enthalten kann, oder R¹² bzw. R^{12'} bedeutet einen Rest mit Donor- oder Akzeptorwirkung;
- R⁴, R⁵, R⁶, R⁷, R⁸, R⁹, R¹¹ und R^{11'}: Wasserstoff, Alkyl, Aryl, Heteroaryl, Alkinyl oder Alkenyl oder ein Rest mit Donor- oder Akzeptorwirkung;
- R¹⁰: in den Gruppen Z" unabhängig voneinander H, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 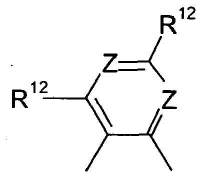 über den aromatischen Grundkörper oder über einen der Reste R¹² mit R⁴ oder R⁵ oder dem Kohlenstoffatom, mit dem R⁴ und R⁵ verknüpft sind, in der Gruppierung ba, R⁸ oder dem Kohlenstoffatom, mit dem R⁸ verknüpft ist, in der Gruppierung bb, einen der Reste R¹⁰ oder einem der Kohlenstoffatome, mit dem R¹⁰ verknüpft ist, in der Gruppierung bc und R¹¹ oder dem Kohlenstoffatom, mit dem R¹¹ verknüpft ist, in der Gruppierung bd über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten;
wobei in den Fällen, worin die Gruppe der Struktur 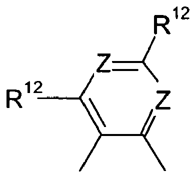 über eine Brücke mit dem Kohlenstoffatom, mit dem R⁴ und R⁵ verknüpft sind (Gruppierung ba), dem Kohlenstoffatom, mit dem R⁸ verknüpft ist (Gruppierung bb), einem der Kohlenstoffatome, mit dem R¹⁰ verknüpft ist (Gruppierung bc) oder dem Kohlenstoffatom, mit dem R¹¹ verknüpft ist (Gruppierung bd), verknüpft ist, der jeweilige Rest R⁴ oder R⁵, R⁸, einer der Reste R¹⁰ oder R¹¹ durch eine Bindung zu der Brücke ersetzt ist.

Ganz besonders bevorzugt sind heteroleptische Carbenkomplexe der Formel I, die mindestens einen ersten (unsymmetrischen) Carbenliganden gemäß der vorstehend erwähnten ganz besonders bevorzugten Ausführungsform und mindestens einen zweiten (symmetrischen) Carbenliganden gemäß der vorstehenden weiteren ganz besonders bevorzugten Ausführungsform enthalten. Wenn n in den erfindungsgemäßen heteroleptischen Carbenkomplexen der Formel I > 2 ist, ist der eine bzw. sind die mehreren weitere(n) Carbenligand(en) in einer weiter bevorzugten Ausführungsform ebenfalls entweder symmetrische oder unsymmetrische Carbenkomplexe gemäß den vorstehend genannten ganz besonders bevorzugten Ausführungsformen.

Das Metallatom M¹ ist in den erfindungsgemäßen heteroleptischen Carbenkomplexen der allgemeinen Formel I besonders bevorzugt ausgewählt aus der Gruppe bestehend aus Ir, Os, Rh und Pt, wobei Os(II), Rh(III), Ir(III) und Pt(II) bevorzugt sind. Besonders bevorzugt ist Ir(III). Ganz besonders bevorzugt sind heteroleptische Carbenkomplexe, worin M¹ Ir(III) und n 3 ist.

Die erfindungsgemäßen heteroleptischen Carbenkomplexe weisen somit in einer ganz besonders bevorzugten Ausführungsform die Formeln (Ii) und (Iii) auf: 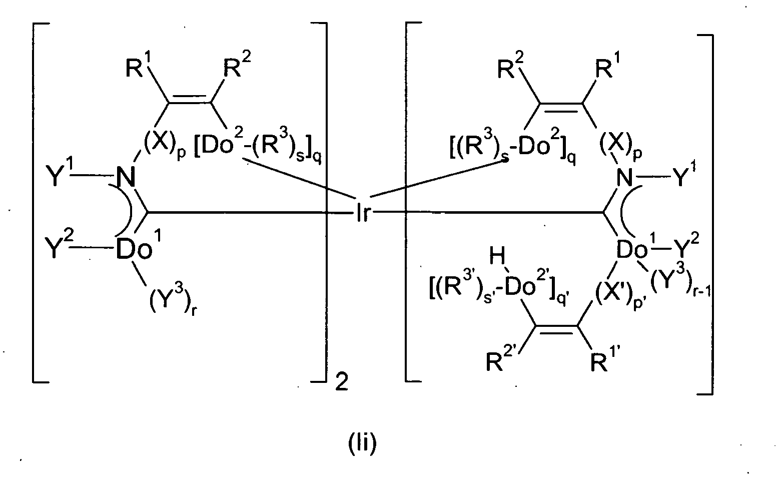 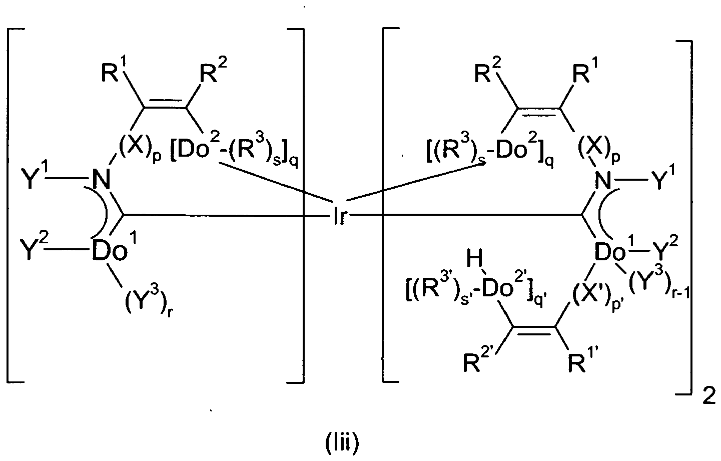 wobei die Symbole in den Carbenkomplexen der allgemeinen Formeln (Ii) und (Iii) die folgenden Bedeutungen aufweisen:
- Do¹: Donoratom ausgewählt aus der Gruppe bestehend aus C, P, N, O, S und Si, bevorzugt P, N, O und S; wobei in dem Carbenliganden 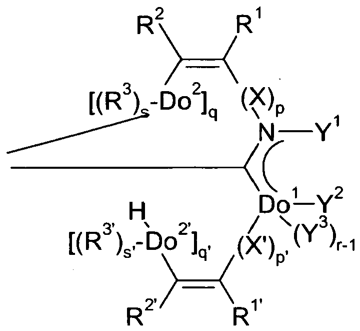 Do¹ nicht O oder S bedeutet;
- Do², Do²: unabhängig voneinander Donoratom ausgewählt aus der Gruppe bestehend aus C, N, P, O und S;
- r: 2, wenn Do¹ C oder Si ist, 1, wenn Do¹ N oder P ist und 0, wenn Do¹ O oder S ist;
- s, s': 2, wenn Do² oder Do² C ist, 1, wenn Do² oder Do^{2'} N oder P ist und 0, wenn Do² oder Do^{2'} O oder S ist;
- X, X': unabhängig voneinander Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
- w: 2 bis 10;
- R¹³, R¹⁴, R¹⁵, R¹⁶, R¹⁷: H, Alkyl, Aryl, Heteroaryl, Alkenyl, Alkinyl;
- p, p': unabhängig voneinander 0 oder 1;
- q, q': unabhängig voneinander 0 oder 1;
- Y¹, Y²: jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
- R¹ R², R^{1'}, R^{2'}: unabhängig voneinander Wasserstoff, Alkyl-, Aryl-, Heteroaryl-, Alkipyl- oder Alkenylreste, oder
R¹ und R² bzw. R^{1'} und R^{2'} bilden gemeinsam eine Brücke mit insgesamt drei bis fünf Atomen, wovon 1 bis 5 Atome Heteroatome sein können und die restlichen Atome Kohlenstoffatome sind, so dass die Gruppe 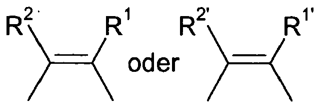 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann und der fünf- bis siebengliedrige Ring gegebenenfalls mit einem oder mehreren weiteren Ringen, bevorzugt sechsgliedrigen aromatischen Ringen, anelliert sein kann;
weiterhin können Y¹ und R¹ bzw. Y² und R^{1'} über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten;
- R³: Wasserstoff, ein Alkyl-, Aryl-, Heteroaryl-, Alkinyl- oder Alkenylrest;
- Y³: Wasserstoff, ein Alkyl-, Alkinyl- oder Alkenylrest;
weiterhin können Y³ und Y² über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
- y: 2 bis 10;
und
- R²⁵, R²⁶, R²⁷, R²⁸, R²⁹, R³², R³³: H, Alkyl, Aryl, Heteroaryl, Alkenyl, Alkinyl
bedeuten;
wobei die Reste, Gruppen und Indizes R¹, R², Y¹, Y², Do¹, Do², Y³, X, R³, p, q, r, s, R¹, R^{2'}, Do^{2'}, R^{3'}, p', q', s' in den verschiedenen Carbenliganden jeweils gleich oder verschieden sein können.

Somit betrifft eine bevorzugte Ausführungsform der Erfindung heteroleptische Ir(III)-Carbenkomplexe der Formel (Ii), die zwei unsymmetrische und einen symmetrischen Carbenliganden aufweisen, und eine weitere bevorzugte Ausführungsform der Erfindung heteroleptische Ir(III)-Carbenkomplexe der Formel (Iii), die zwei symmetrische und einen unsymmetrischen Carbenliganden aufweisen. Die zwei unsymmetrischen Carbenliganden in den Carbenkomplexen der Formel (Ii) und die zwei symmetrischen Carbenliganden in den Carbenkomplexen der Formel (Iii) können jeweils gleich oder verschieden sein. Bevorzugt sind die zwei unsymmetrischen Carbenliganden in den Carbenkomplexen der Formel (Ii) und die zwei symmetrischen Carbenliganden in den Carbenkomplexen der Formel (Iii) jeweils gleich. Bevorzugte und ganz besonders bevorzugte symmetrische und bevorzugte und ganz besonders bevorzugte unsymmetrische Carbenliganden sind vorstehend genannt.

Ganz besonders bevorzugte Ligandkombinationen der in den heteroleptischen Carbenkomplexen der Formeln li und Iii (M¹ Ir(III) und n 3) ganz besonders bevorzugt eingesetzten unsymmetrischen Liganden aa bis ae und symmetrischen Liganden ba bis be sind in der nachstehenden Tabelle aufgeführt:

| *unsymmetrischer Carbenligand* | *symmetrischer Carbenligand* | | | | |
|---|---|---|---|---|---|
| | ba | bb | bc | bd | be |
| aa | +¹⁾ | + | + | + | + |
| ab | + | + | + | + | + |
| ac | + | + | + | + | + |
| ad | + | + | + | + | + |
| ae | + | + | + | + | + |

| | | | | | |
|---|---|---|---|---|---|
| 1) "+" bedeutet mögliche Kombination von symmetrischen und unsymmetrischen Carbenliganden | | | | | |

In den Carbenkomplexen der Formel li beträgt die Zahl der unsymmetrischen Liganden aa bis ae 2 und die Zahl der symmetrischen Liganden ba bis be 1, und in den Carbenkomplexen der Formel Iii beträgt die Zahl der unsymmetrischen Liganden aa bis ae 1 und die Zahl der symmetrischen Liganden ba bis be 2. Insbesondere ganz besonders bevorzugt sind die folgenden Ligandkombinationen: unsymmetrischer Carbenligand: ab - symmetrischer Carbenligand: bb; unsymmetrischer Carbenligand: ab - symmetrischer Carbenligand: bc; unsymmetrischer Carbenligand: ac - symmetrischer Carbenligand: bb; unsymmetrischer Carbenligand: ac - symmetrischer Carbenligand: bc.

Besonders bevorzugt sind heteroleptische Carbenkomplexe der Formel li, die zwei unsymmetrische und einen symmetrischen Carbenliganden der Formel II aufweisen.

Die erfindungsgemäßen heteroleptischen Carbenkomplexe der Formel I können grundsätzlich analog zu dem Fachmann bekannten Verfahren hergestellt werden, wobei zu berücksichtigen ist, dass die erfindungsgemäßen heteroleptischen Carbenkomplexe der Formel I mindestens zwei verschiedene Carbenliganden tragen. Geeignete Verfahren zur Herstellung von Carbenkomplexen sind zum Beispiel in den Übersichtsartikeln W. A. Hermann et al., Advances in Organometallic Chemistry, 2001 Vol. 48, 1 bis 69, W. A. Hermann et al., Angew. Chem. 1997, 109, 2256 bis 2282 und G. Bertrand et al. Chem. Rev. 2000, 100, 39 bis 91 und der darin zitierten Literatur aufgeführt, sowie in WO 2005/113704, WO 2005/019373 und in der nicht vorveröffentlichten europäischen Anmeldung mit dem Aktenzeichen EP 06 101 109.4.

In einer Ausführungsform werden die erfindungsgemäßen heteroleptischen Carbenkomplexe der Formel I durch Deprotonierung von den Carbenliganden entsprechenden Ligandvorläufern und anschließende Umsetzung mit geeigneten, das gewünschte Metall enthaltenden, Metallkomplexen hergestellt.

Geeignete Ligandvorläufer der symmetrischen und unsymmetrischen Carbenliganden sind dem Fachmann bekannt. Bevorzugt handelt es sich um kationische Vorstufen.

In einer bevorzugten Ausführungsform betrifft die vorliegende Erfindung ein Verfahren zur Herstellung der erfindungsgemäßen heteroleptischen Carbenkomplexe der allgemeinen Formel I, wobei die Herstellung den folgenden Schritt umfasst:

Umsetzung von mindestens 2 Ligandvorläufern der allgemeinen Formel (III) 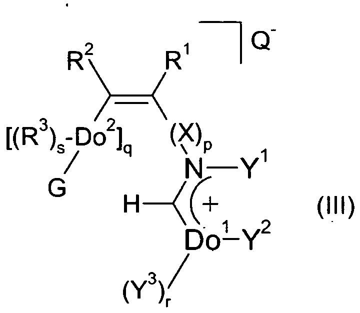 worin
- Q-: ein monoanionisches Gegenion, bevorzugt Halogenid, Pseudohalogenid, BF₄⁻, BPh₄⁻, PF₆⁻, AsF₆⁻ oder SbF₆⁻;
und
- G: wenn Do² = C ist oder q = 0 ist, H bedeutet, und wenn Do² = N, S, O oder P ist, H oder ein freies Elektronenpaar des Heteroatoms bedeutet;
bedeuten, und
die weiteren Symbole in dem Ligandvorläufer der allgemeinen Formel III die folgenden Bedeutungen aufweisen:
- Do¹: Donoratom ausgewählt aus der Gruppe bestehend aus C, P, N, O, S und Si, bevorzugt P, N, O und S;
- Do²: Donoratom ausgewählt aus der Gruppe bestehend aus C, N, P, O und S;
- r: 2, wenn Do¹ C oder Si ist, 1, wenn Do¹ N oder P ist und 0, wenn Do¹ O oder S ist;
- s: 2, wenn Do² C ist, 1, wenn Do² N oder P ist und 0, wenn Do² O oder S ist;
- X: Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
- w: 2 bis 10;
- R¹³, R¹⁴, R¹⁵, R¹⁶, R¹⁷: H, Alkyl, Aryl, Heteroaryl, Alkenyl, Alkinyl;
- p: 0 oder 1;
- q: 0 oder 1;
- Y¹, Y²: jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
- R¹, R²: unabhängig voneinander Wasserstoff, Alkyl-, Aryl-, Heteroaryl-, Alkinyl- oder Alkenylreste, oder
- R¹ und R²: bilden gemeinsam eine Brücke mit insgesamt drei bis fünf Atomen, wovon 1 bis 5 Atome Heteroatome sein können und die restlichen Atome Kohlenstoffatome sind, so dass die Gruppe 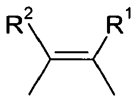 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann und der fünf- bis siebengliedrige Ring gegebenenfalls mit einem oder mehreren weiteren Ringen, bevorzugt sechsgliedrigen aromatischen Ringen, anelliert sein kann;
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂. SiR³⁰R³¹, CO, CO-O, O-CO ersetzt sein können, wobei
- x: 2 bis 10;
und
- R¹⁸, R¹⁹, R²⁰, R²¹, R²², R³⁰, R³¹: H, Alkyl, Aryl, Heteroaryl, Alkenyl, Alkinyl
bedeuten;
- R³: Wasserstoff, ein Alkyl-, Aryl-, Heteroaryl-, Alkinyl- oder Alkenylrest;
wobei
die mindestens 2 Ligandvorläufer der allgemeinen Formel III verschiedene Bedeutungen Y³ aufweisen,
wobei
Y³ in mindestens einem ersten Ligandvorläufer (IIIa) die folgende Bedeutung aufweist: Wasserstoff, ein Alkyl-, Alkinyl- oder Alkenylrest, wobei, wenn Do¹ C oder Si ist und r 2 bedeutet, beide Reste Y³ die vorstehend genannten Bedeutungen aufweisen;
und
Y³ in mindestens einem zweiten Ligandvorläufer (IIIb) die folgende Bedeutung aufweist: 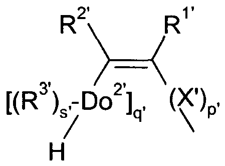 wobei Do^{2'}, q^{'}, s^{'}, R^{3'}, R^{1'}, R^{2'}, X^{'} und p^{'} unabhängig die gleichen Bedeutungen wie Do², q, s, R³, R¹, R², X und p aufweisen, und
wenn Do¹ C oder Si ist und r 2 bedeutet, mindestens einer der beide Resten Y³ die vorstehend genannte Bedeutung aufweist; der zweite Rest Y³ kann die vorstehend genannte Bedeutung oder die bezüglich des ersten Ligandvorläufers für Y³ genannten Bedeutungen aufweisen;
mit einem Metallkomplex enthaltend mindestens ein Metall M^{1'}, wobei M^{1'} die folgenden Bedeutungen aufweist:
- M^{1'}: Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metallatom möglichen Oxidationsstufe.

Bevorzugt wird als Metall M^{1'} Ir, besonders bevorzugt Ir(I) oder Ir(III) eingesetzt.

Bevorzugte Definitionen für Do¹, Y¹, Y², Do², q, s, R³, R¹, R², X und p und Do^{2'}, q^{'}, s^{'}, R^{3'}, R^{1'}, R^{2'}, X und p^{'} in den Ligandvorläufern der allgemeinen Formel III sind die bezüglich der Carbenliganden der allgemeinen Formel II genannten Definitionen. Bevorzugte Ligandvorläufer der Formel III entsprechen den bevorzugten symmetrischen (IIb) und unsymmetrischen (IIa) Carbenliganden.

Im Sinne der vorliegenden Anmeldung sind unter unsymmetrischen Ligandvorläufern (IIIa) (entsprechend unsymmetrischen Carbenliganden) solche Ligandvorläufer der allgemeinen Formel III zu verstehen, worin Y³ Wasserstoff, ein Alkyl-, Alkinyl- oder Alkenylrest bedeutet, wobei, wenn Do¹ C oder Si ist und r 2 bedeutet, beide Reste Y³ die vorstehend genannten Bedeutungen aufweisen.

Unter symmetrischen Ligandvorläufern (IIIb) (entsprechend symmetrischen Carbenliganden) sind solche Ligandvorläufer der allgemeinen Formel III zu verstehen, worin Y³ die folgende Bedeutung aufweist: 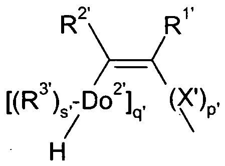 wobei Do^{2'}, q^{'}, s^{'}, R^{3'}, R^{1'}, R^{2'}, X^{'} und p^{'} unabhängig die gleichen Bedeutungen wie Do², q, s, R³, R¹, R², X und p aufweisen, und
wenn Do¹ C oder Si ist und r 2 bedeutet, mindestens einer der beide Resten Y³ die vorstehend genannte Bedeutung aufweist; der zweite Rest Y³ kann die vorstehend genannte Bedeutung oder die bezüglich des ersten Ligandvorläufers für Y³ genannten Bedeutungen aufweisen.

Die Herstellung der erfindungsgemäßen heteroleptischen Carbenkomplexe ist grundsätzlich durch gleichzeitige Umsetzung von symmetrischen und unsymmetrischen Ligandvorläufern der allgemeinen Formel III mit einem Metallkomplex enthaltend mindestens ein Metall M^{1'} möglich ("Eintopfverfahren") oder durch sequentielle Umsetzung. Die sequentielle Umsetzung kann entweder durch Umsetzung des Metallkomplexes mit einem symmetrischen Ligandvorläufer (IIIb) in einem ersten Schritt erfolgen, wobei zunächst als Zwischenstufe ein Carbenkomplex, der mindestens einen symmetrischen Carbenliganden entweder der allgemeinen Formel IIb oder als nicht-cyclometallierte Form und mindestens eine weitere Koordinationsmöglichkeit (wobei die weitere Koordinationsmöglichkeit entweder durch eine freie Koordinationsstelle am Metall M^{1'} oder durch die Verdrängung anderer Liganden vorliegt) für mindestens einen weiteren bidentaten Carbenliganden aufweist, gebildet wird, oder durch Umsetzung des Metallkomplexes mit einem unsymmetrischen Ligandvorläufer (IIIa) in einem ersten Schritt, wobei zunächst als Zwischenstufe ein Carbenkomplex, der mindestens einen unsymmetrischen Carbenliganden entweder der allgemeinen Formel IIa oder als nicht-cyclometallierte Form und mindestens eine weitere Koordinationsmöglichkeit (wobei die weitere Koordinationsmöglichkeit entweder durch eine freie Koordinationsstelle am Metall M^{1'} oder durch die Verdrängung anderer Liganden vorliegt) für mindestens einen weiteren bidentaten Carbenliganden aufweist, gebildet wird. In einem auf den ersten Schritt folgenden zweiten Schritt erfolgt eine Umsetzung des jeweiligen im ersten Schritt erhaltenen Carbenkomplexes mit einem unsymmetrischen Carbenliganden (wenn im ersten Schritt ein symmetrischer Carbenligand eingesetzt wurde) bzw. mit einem symmetrischen Carbenliganden (wenn im ersten Schritt ein unsymmetrischer Carbenligand eingesetzt wurde).

In dem besonders bevorzugten Fall, dass das Metall M¹ in den erfindungsgemäßen heteroleptischen Carbenkomplexen der Formel I Ir(III) mit einer Koordinationszahl von 6 ist, ergeben sich bei einer sequentiellen Umsetzung z.B. die folgenden besonders bevorzugten Möglichkeiten:
*(ia) Carbenkomplex der allgemeinen Formel Ii*
   (iaa) Umsetzung eines Metallkomplexes enthaltend mindestens ein Metall M^{1'}, worin das mindestens eine Metall M^{1'} Ir ist, mit einer im Verhältnis zu Ir mindestens doppelt stöchiometrischen Menge eines unsymmetrischen Ligandvorläufers (IIla), wobei ein Di-Carbenkomplex gebildet wird, der zwei unsymmetrische Carbenliganden und eine weitere Koordinationsstelle für einen weiteren bidentaten Carbenliganden aufweist, und
   (iab) anschließende Umsetzung des erhaltenen Di-Carbenkomplexes mit einer im Verhältnis zu Ir mindestens stöchiometrischen Menge eines symmetrischen Ligandvorläufers
      (IIIb), wobei ein heteroleptischer Ir-Carbenkomplex der allgemeinen Formel li erhalten wird.
(ib) *Carbenkomplex der allgemeinen Formel Ii*
   (iba) Umsetzung eines Metallkomplexes enthaltend mindestens ein Metall M^{1'}, worin das mindestens eine Metall M^{1'} Ir ist, mit einer im Verhältnis zu Ir mindestens stöchiometrischen Menge eines symmetrischen Ligandvorläufers (IIIb), wobei ein Mono-Carbenkomplex gebildet wird, der einen symmetrischen Carbenliganden und zwei weitere Koordinationsstellen für zwei weitere bidentate Carbenliganden aufweist, und
   (ibb) anschließende Umsetzung des erhaltenen Mono-Carbenkomplexes mit einer im Verhältnis zu Ir mindestens doppelt stöchiometrischen Menge eines unsymmetrischen Ligandvorläufers (IIIa), wobei ein heteroleptischer Ir-Carbenkomplex der allgemeinen Formel Ii erhalten wird.
   (iia) *Carbenkomplex der allgemeinen Formel Iii*
   (iiaa) Umsetzung eines Metallkomplexes enthaltend mindestens ein Metall M^{1'}, worin das mindestens eine Metall M^{1'} Ir ist, mit einer im Verhältnis zu Ir mindestens doppelt stöchiometrischen Menge eines symmetrischen Ligandvorläufers (IIIb), wobei ein Di-Carbenkomplex gebildet wird, der zwei symmetrische Carbenliganden und eine weitere Koordinationsstelle für einen weiteren bidentaten Carbenliganden aufweist, und
   (iiab) anschließende Umsetzung des erhaltenen Di-Carbenkomplexes mit einer im Verhältnis zu Ir mindestens stöchiometrischen Menge eines unsymmetrischen Ligandvorläufers (IIIa), wobei ein heteroleptischer Ir-Carbenkomplex der allgemeinen Formel Iii erhalten wird.
   (iib) *Carbenkomplex der allgemeinen Formel Iii*
   (iiba) Umsetzung eines Metallkomplexes enthaltend mindestens ein Metall M^{1'}, worin das mindestens eine Metall M^{1'} Ir ist, mit einer im Verhältnis zu Ir mindestens stöchiometrischen Menge eines unsymmetrischen Ligandvorläufers (IIIa), wobei ein Mono-Carbenkomplex gebildet wird, der einen unsymmetrischen Carbenliganden und zwei weitere Koordinationsstellen für zwei weitere bidentate Carbenliganden aufweist, und
   (iibb) anschließende Umsetzung des erhaltenen Mono-Carbenkomplexes mit einer im Verhältnis zu Ir mindestens doppelt stöchiometrischen Menge eines symmetrischen Ligandvorläufers (IIIb), wobei ein heteroleptischer Ir-Carbenkomplex der allgemeinen Formel Iii erhalten wird.

In den in den Schritten (iaa), (iba), (iiaa) und (iiba) gebildeten Zwischenstufen können die jeweiligen Carbenliganden entweder in cyclometallierter Form oder in nicht cyclometallierter Form vorliegen.

Die vorstehend erwähnten Mono- und Di-Carbenkomplexe können ggf. isoliert werden oder "in situ", d.h. ohne Aufarbeitung, mit dem weiteren Carbenliganden umgesetzt werden.

Die Herstellung der Ligandvorläufer der Formel III erfolgt nach dem Fachmann bekannten Verfahren. Geeignete Verfahren sind z.B. in WO 2005/019373 und der darin zitierten Literatur, z.B. Organic Letters, 1999, 1, 953-956; Angewandte Chemie, 2000, 112, 1672-1674 genannt. Weitere geeignete Verfahren sind z.B. in T. Weskamp et al., J. Organometal. Chem. 2000, 600, 12-22; G. Xu et al., Org. Lett. 2005, 7, 4605-4608 ; V. Lavallo et al., Angew. Chem. Int. Ed. 2005, 44, 5705-5709 genannt. Einige der geeigneten Ligandvorläufer sind kommerziell erhältlich.

Bei dem Metallkomplex enthaltend mindestens ein Metall M^{1'} handelt es sich um einen Metallkomplex enthaltend mindestens ein Metall ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, ganz besonders bevorzugt Ir, in jeder für das entsprechende Metallatom möglichen Oxidationsstufe, bevorzugt Ir(I) oder Ir(III). Geeignete Metallkomplexe sind dem Fachmann bekannt. Beispiele für geeignete Metallkomplexe sind Pt(cod)Cl₂, Pt(cod)Me₂, Pt(acac)₂, Pt(PPh₃)₂Cl₂, PtCl₂, [Rh(cod)Cl]₂, Rh(acac)CO(PPh₃), Rh(acac)(CO)₂, Rh(cod)₂BF₄, RhCl(PPh₃)₃, RhCl₃ x n H₂O, Rh(acac)₃, [Os(CO)₃I₂]₂, [Os₃(CO)₁₂], OsH₄(PPH₃)₃, CP₂Os, Cp*₂Os, H₂OsCl₆ x 6H₂O, OsCl₃ x H₂O), sowie [(µ-Cl)Ir(η⁴-1,5-cod)]₂, [(µ-Cl)Ir(η²-coe)₂]₂, Ir(acac)₃, IrCl₃ x n H₂O, (tht)₃IrCl₃, Ir(η³-Allyl)₃, Ir(η³-Methallyl)₃, worin cod Cyclooctadien, coe Cycloocten, acac Acetylacetonat und tht Tetrahydrothiophen bedeuten. Die Metallkomplexe können gemäß dem Fachmann bekannten Verfahren hergestellt werden bzw. sind kommerziell erhältlich.

Bei der Herstellung von Iridium(III)-Komplexen der allgemeinen Formel I (M¹ in Formel I ist Ir), die gemäß der vorliegenden Anmeldung besonders bevorzugt sind, können die vorstehend genannten Iridium(I)- oder (III)-Komplexe eingesetzt werden, insbesondere -[(µ-Cl)Ir(η⁴-1,5-cod)]₂, [(µ-Cl)Ir(η²-coe)₂]₂, Ir(acac)₃, IrCl₃ x n H₂O, (tht)₃IrCl₃, Ir(η³-Allyl)₃, Ir(η³-Methallyl)₃, worin cod Cyclooctadien, coe Cycloocten, acac Acetylacetonat und tht Tetrahydrothiophen bedeuten.

Im Anschluss an die Umsetzung wird der erfindungsgemäße heteroleptische Carbenkomplex nach dem Fachmann bekannten Verfahren aufgearbeitet und ggf. gereinigt. Üblicherweise erfolgen die Aufarbeitung und Reinigung durch Extraktion, Säulenchromatographie und/oder Umkristallisation gemäß dem Fachmann bekannten Verfahren.

Im Folgenden ist ein Verfahren zur Herstellung der erfindungsgemäßen heteroleptischen Carbenkomplexe der allgemeinen Formel I am Beispiel der vorstehend erwähnten Umsetzung (ia) zur Herstellung von heteroleptischen Carbenkomplexen der allgemeinen Formel Ii beispielhaft dargestellt:

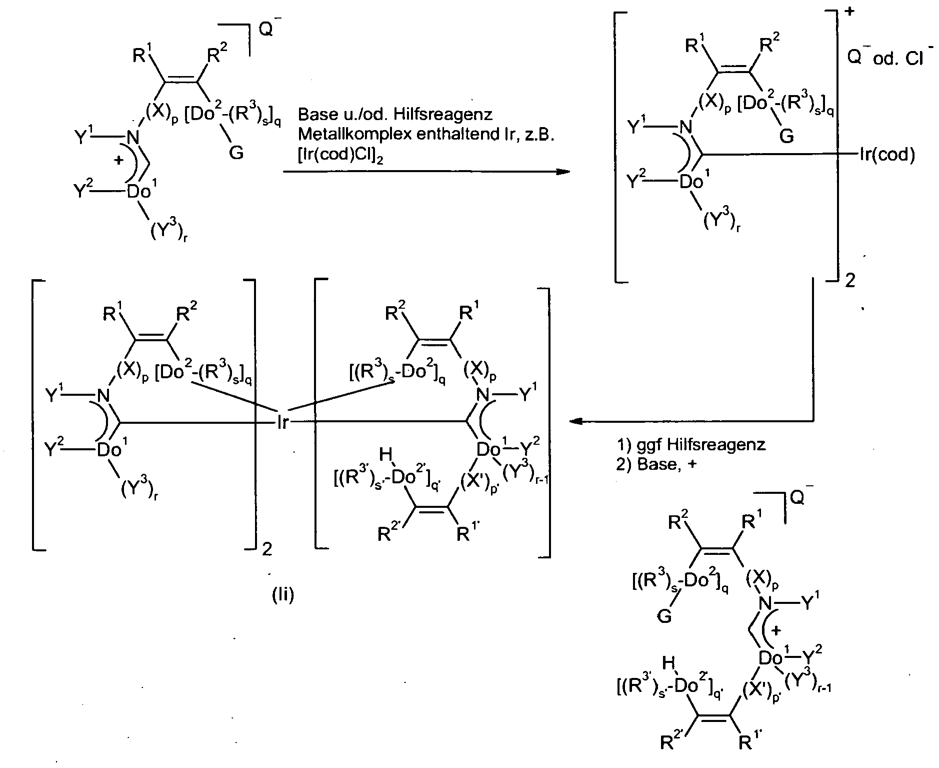

Ein weiterer Syntheseweg (iia) zur Herstellung der erfindungsgemäßen heteroleptischen Carbenkomplexe ist im Folgenden beispielhaft dargestellt:

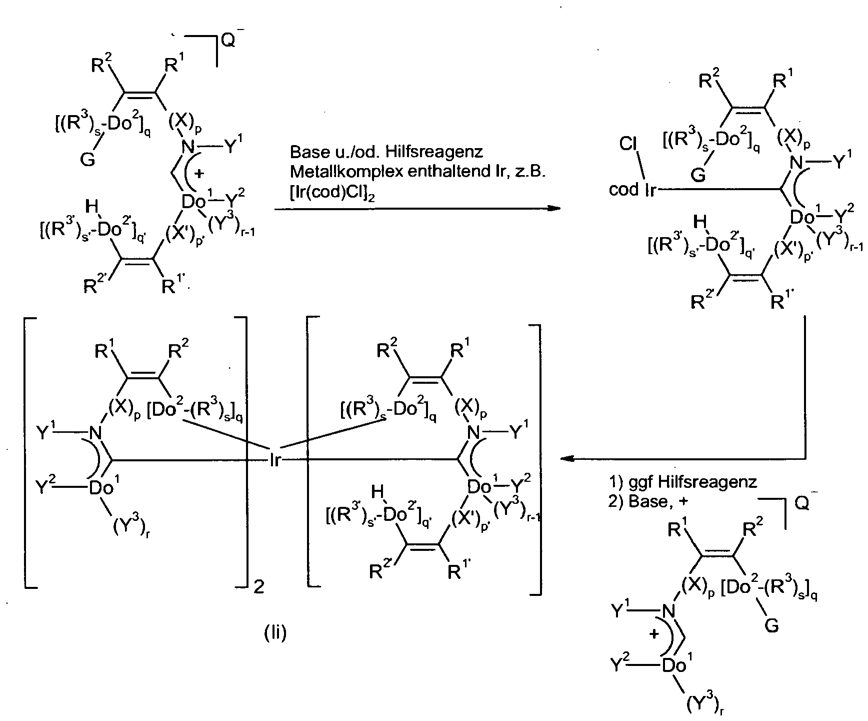

Des Weiteren können die erfindunsgemäßen heteroleptischen Carbenkomplexe z. B. analog zu WO 2005/113704 hergestellt werden, wobei die folgende Zwischenstufe durchlaufen wird:

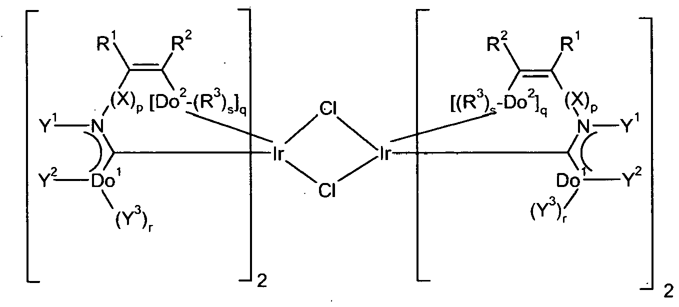

Die Symbole und Reste in den vorstehend gezeigten allgemeinen Formeln wurden bereits vorstehend definiert.

Die erfindungsgemäßen heteroleptischen Carbenkomplexe eignen sich hervorragend als Emittersubstanzen, da sie eine Emission (Elektrolumineszenz) im sichtbaren Bereich des elektromagnetischen Spektrums aufweisen. Mit Hilfe der erfindungsgemäßen heteroleptischen Carbenkomplexe als Emittersubstanzen ist es möglich, Verbindungen bereit zu stellen, die Elektrolumineszenz im roten, grünen sowie im blauen Bereich des elektromagnetischen Spektrums mit sehr guter Effizienz zeigen. Dabei ist die Quantenausbeute hoch und die Stabilität der erfindungsgemäßen heteroleptischen Carbenkomplexe im Device hoch.

Des Weiteren sind die erfindungsgemäßen heteroleptischen Carbenkomplexe als Elektronen-, Excitonen- oder Lochblocker oder Lochleiter, Elektronenleiter, Lochinjektionsschicht oder Matrixmaterial in OLEDs geeignet, in Abhängigkeit von den eingesetzten Liganden und dem eingesetzten Zentralmetall.

Organische Licht-emittierende Dioden (OLEDs) sind grundsätzlich aus mehreren Schichten aufgebaut:
1. Anode (1)
2. Löcher-transportierende Schicht (2)
3. Licht-emittierende Schicht (3)
4. Elektronen-transportierende Schicht (4)
5. Kathode (5)

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die heteroleptischen Carbenkomplexe gemäß der vorliegenden Anmeldung können in verschiedenen Schichten eines OLEDs eingesetzt werden. Ein weiterer Gegenstand der vorliegenden Erfindung ist daher die Verwendung der erfindungsgemäßen heteroleptischen Carbenkomplexe in organischen Leuchtdioden (OLEDs), sowie ein OLED enthaltend mindestens einen erfindungsgemäßen heteroleptischen Carbenkomplex.

Die erfindungsgemäßen heteroleptischen Carbenkomplexe werden bevorzugt in der Licht-emittierenden Schicht, besonders bevorzugt als Emittermoleküle, eingesetzt. Ein weiterer Gegenstand der vorliegenden Erfindung ist daher eine Licht-emittierende Schicht enthaltend mindestens einen heteroleptischen Carbenkomplex, bevorzugt als Emittermolekül. Bevorzugte heteroleptische Carbenkomplexe sind vorstehend genannt.

Die erfindungsgemäßen heteroleptischen Carbenkomplexe können in Substanz - ohne weitere Zusätze - in der Licht-emittierenden Schicht oder einer anderen Schicht des OLEDs, bevorzugt in der Licht-emittierenden Schicht, vorliegen. Es ist jedoch ebenfalls möglich und bevorzugt, dass neben den erfindungsgemäßen heteroleptischen Carbenkomplexen weitere Verbindungen in den Schichten enthaltend mindestens einen erfindungsgemäßen heteroleptischen Carbenkomplex, bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten heteroleptischen Carbenkomplexes zu verändern. Des Weiteren kann - in einer bevorzugten Ausführungsform - ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CDP=CBP) oder tertiäre aromatische Amine.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß, bevorzugt als Emittersubstanzen, verwendeten heteroleptischen Carbenkomplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N; N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beispiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löchertransportierenden Schicht (2);
- eine Blockschicht für Elektronen und/oder Excitonen zwischen der Löchertransportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sowie geeignete OLED-Aufbauten sind dem Fachmann bekannt und z.B. in WO2005/113704 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinander folgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen erfindungsgemäßen heteroleptischen Carbenkomplex ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (2) 500 bis 5000 Å, bevorzugt 1000 bis 2000 Å; Löcher-transportierende Schicht (3) 50 bis 1000 Å, bevorzugt 200 bis 800 Å, Licht-emittierende Schicht (4) 10 bis 1000 Å, bevor-zugt 100 bis 800 Å, Elektronen transportierende Schicht (5) 50 bis 1000 Å, bevorzugt 200 bis 800 Å, Kathode (7) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäßen heteroleptischen Carbenkomplexe in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Digitalkameras, Fahrzeugen sowie Zielanzeigen an Bussen und Bahnen.

Weiterhin können die erfindungsgemäßen heteroleptischen Carbenkomplexe in OLEDs mit inverser Struktur eingesetzt werden. Bevorzugt werden die erfindungsgemäßen heteroleptischen Carbenkomplexe in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die vorstehend beschriebenen erfindungsgemäßen heteroleptischen Carbenkomplexe können neben dem Einsatz in OLEDs als Färbemittel eingesetzt werden, die bei Einstrahlung von Licht im sichtbaren Bereich des elektromagnetischen Spektrums emittieren (Photolumineszenz).

Ein weiterer Gegenstand der vorliegenden Anmeldung ist daher die Verwendung der vorstehend beschriebenen erfindungsgemäßen heteroleptischen Carbenkomplexe zur Massenfärbung polymerer Materialien.

Geeignete polymere Materialien sind Polyvinylchlorid, Celluloseacetat, Polycarbonate, Polyamide, Polyurethane, Polyimide, Polybenzimidazole, Melaminharze, Silikone, Polyester, Polyether, Polystyrol, Polymethylmethacrylat, Polyethylen, Polypropylen, Polyvinylacetat, Polyacrylnitril, Polybutadien, Polychlorbutadien, Polyisopren bzw. die Copolymere der aufgeführten Monomere.

Des Weiteren können die vorstehend beschriebenen erfindungsgemäßen heteroleptischen Carbenkomplexe in den folgenden Anwendungen eingesetzt werden:
- Anwendung der erfindungsgemäßen heteroleptischen Carbenkomplexe als oder in Küpenfarbstoffe(n), zum Beispiel zur Färbung von Naturstoffen, Beispiele sind Papier, Holz, Stroh, Leder, Felle oder natürliche Fasermaterialien wie Baumwolle, Wolle, Seide, Jute, Sisal, Hanf, Flachs oder Tierhaare (zum Beispiel Rosshaar) und deren Umwandlungsprodukte wie zum Beispiel die Viskosefaser, Nitratseide oder Kupferrayon (Reyon)
- Anwendung der erfindungsgemäßen heteroleptischen Carbenkomplexe als Farbmittel, zum Beispiel zur Färbung von Farben, Lacken und anderen Anstrichstoffen, Papierfarben, Druckfarben, Tinten und andere Farben für Mal- und Schreib-Zwecke.

- Anwendung der erfindungsgemäßen heteroleptischen Carbenkomplexe als Pigmentfarbstoffe, zum Beispiel zur Färbung von Farben, Lacken und anderen Anstrichsstoffen, Papierfarben, Druckfarben, Tinten und andere Farben für Mal- und Schreib-Zwecke.
- Anwendung der erfindungsgemäßen heteroleptischen Carbenkomplexe als Pigmente in der Elektrophotographie: zum Beispiel für Trockenkopiersysteme (Xerox-Verfahren) und Laserdrucker.
- Anwendung der erfindungsgemäßen heteroleptischen Carbenkomplexe für Sicherheitsmarkierungs-Zwecke, wobei die große chemische und photochemische Beständigkeit und gegebenenfalls auch die Lumineszenz der Substanzen von Bedeutung ist. Bevorzugt ist dies für Schecks, Scheckkarten, Geldscheine Coupons, Dokumente, Ausweispapiere und dergleichen, bei denen ein besonderer, unverkennbarer Farbeindruck erzielt werden soll.
- Anwendung der erfindungsgemäßen heteroleptischen Carbenkomplexe als Zusatz zu anderen Farben, bei denen eine bestimmte Farbnuance erzielt werden soll, bevorzugt sind besonders leuchtende Farbtöne.
- Anwendung der erfindungsgemäßen heteroleptischen Carbenkomplexe zum Markieren von Gegenständen zum maschinellen Erkennen dieser Gegenstände über die Lumineszenz, bevorzugt ist die maschinelle Erkennung von Gegenständen zum Sortieren, zum Beispiel auch für das Recycling von Kunststoffen.
- Anwendung der erfindungsgemäßen heteroleptischen Carbenkomplexe als Lumineszenzfarbstoffe für maschinenlesbare Markierungen, bevorzugt sind alphanumerische Aufdrucke oder Barcodes.
- Anwendung der erfindungsgemäßen heteroleptischen Carbenkomplexe zur Frequenzumsetzung von Licht, zum Beispiel um aus kurzwelligem Licht längerwelliges, sichtbares Licht zu machen.
- Anwendung der erfindungsgemäßen heteroleptischen Carbenkomplexe in Anzeigeelementen für vielerlei Anzeige-, Hinweis- und Markierungszwecke, zum Beispiel in passiven Anzeigeelementen, Hinweis- und Verkehrszeichen, wie Ampeln.
- Anwendung der erfindungsgemäßen heteroleptischen Carbenkomplexe in Tintenstrahldruckern, bevorzugt in homogener Lösung als lumineszierende Tinte.
- Anwendung der erfindungsgemäßen heteroleptischen Carbenkomplexe als Ausgangsmaterial für supraleitende organische Materialien.
- Anwendung der erfindungsgemäßen heteroleptischen Carbenkomplexe für Feststoff-Lumineszenz-Markierungen.
- Anwendung der erfindungsgemäßen heteroleptischen Carbenkomplexe für dekorative Zwecke.
- Anwendung der erfindungsgemäßen heteroleptischen Carbenkomplexe zu Tracer-Zwecken, zum Beispiel in der Biochemie, Medizin, Technik und Naturwissenschaft. Hierbei können die Farbstoffe kovalent mit Substraten verknüpft sein oder über Nebenvalenzen wie Wasserstoffbrückenbindungen oder hydrophobe Wechselwirkungen (Adsorption).
- Anwendung der erfindungsgemäßen heteroleptischen Carbenkomplexe als Lumineszenzfarbstoffe in hochempfindlichen Nachweisverfahren (siehe C. Aubert, J. Fünfschilling, I. Zschocke-Gränacher und H. Langhals, Z. Analyt. Chem. 320 (1985) 361).
- Anwendung der erfindungsgemäßen heteroleptischen Carbenkomplexe als Lumineszenzfarbstoffe in Szintillatoren.
- Anwendung der erfindungsgemäßen heteroleptischen Carbenkomplexe als Farbstoffe oder Lumineszenzfarbstoffe in optischen Lichtsammelsystemen.
- Anwendung der erfindungsgemäßen heteroleptischen Carbenkomplexe als Farbstoffe oder Lumineszenzfarbstoffe in Lumineszenz-Solarkollektoren (siehe Langhals, Nachr. Chem. Tech. Lab. 28 (1980) 716).
- Anwendung der erfindungsgemäßen heteroleptischen Carbenkomplexe als Farbstoffe oder Lumineszenzfarbstoffe in Lumineszenz-aktivierten Displays (siehe W. Greubel und G. Baur, Elektronik 26 (1977) 6).
- Anwendung der erfindungsgemäßen heteroleptischen Carbenkomplexe als Farbstoffe oder Lumineszenzfarbstoffe in Kaltlichtquellen zur lichtinduzierten Polymerisation zur Darstellung von Kunststoffen.
- Anwendung der erfindungsgemäßen heteroleptischen Carbenkomplexe als Farbstoffe oder Lumineszenzfarbstoffe zur Materialprüfung, zum Beispiel bei der Herstellung von Halbleiterschaltungen.
- Anwendung der erfindungsgemäßen heteroleptischen Carbenkomplexe als Farbstoffe oder Lumineszenzfarbstoffe zur Untersuchung von Mikrostrukturen von integrierten Halbleiterbauteilen.
- Anwendung der erfindungsgemäßen heteroleptischen Carbenkomplexe als Farbstoffe oder Lumineszenzfarbstoffe in Photoleitern.
- Anwendung der erfindungsgemäßen heteroleptischen Carbenkomplexe als Farbstoffe oder Lumineszenzfarbstoffe in fotografischen Verfahren.
- Anwendung der erfindungsgemäßen heteroleptischen Carbenkomplexe als Farbstoffe oder Lumineszenzfarbstoffe in Anzeige-, Beleuchtungs- oder Bildwandlersystemen, bei denen die Anregung durch Elektronen, Ionen oder UV-Strahlung erfolgt, zum Beispiel in Lumineszenzanzeigen, Braunschen Röhren oder in Leuchtstoffröhren.
- Anwendung der erfindungsgemäßen heteroleptischen Carbenkomplexe als Farbstoffe oder Lumineszenzfarbstoffe als Teil einer integrierten Halbleiterschaltung, die Farbstoffe als solche oder in Verbindung mit anderen Halbleitern zum Beispiel in Form einer Epitaxie.
- Anwendung der erfindungsgemäßen heteroleptischen Carbenkomplexe als Farbstoffe oder Lumineszenzfarbstoffe in Chemilumineszenzsystemen, zum Beispiel in Chemilumineszenz-Leuchtstäben, in Lumineszenzimmunessays oder anderen Lumineszenznachweisverfahren.
- Anwendung der erfindungsgemäßen heteroleptischen Carbenkomplexe als Farbstoffe oder Lumineszenzfarbstoffe als Signalfarben, bevorzugt zum optischen Hervorheben von Schriftzügen und Zeichnungen oder anderen graphischen Produkten, zum Kennzeichnen von Schildern und anderen Gegenständen, bei denen ein besonderer optischer Farbeindruck erreicht werden soll.
- Anwendung der erfindungsgemäßen heteroleptischen Carbenkomplexe als Farbstoffe oder Lumineszenzfarbstoffe in Farbstoff-Lasern, bevorzugt als Lumineszenzfarbstoffe zur Erzeugung von Laserstrahlen.
- Anwendung der erfindungsgemäßen heteroleptischen Carbenkomplexe als aktive Substanzen für eine nichtlineare Optik, zum Beispiel für die Frequenzverdopplung und die Frequenzverdreifachung von Laserlicht.
- Anwendung der erfindungsgemäßen heteroleptischen Carbenkomplexe als Rheologieverbesserer.
- Anwendung der erfindungsgemäßen heteroleptischen Carbenkomplexe als Farbstoffe in photovoltaischen Anordnungen zur Umwandlung elektromagnetischer Strahlung in elektrische Energie.

Die nachfolgenden Beispiele erläutern die Erfindung zusätzlich.

### Beispiele

### a) Synthese von Komplex K I

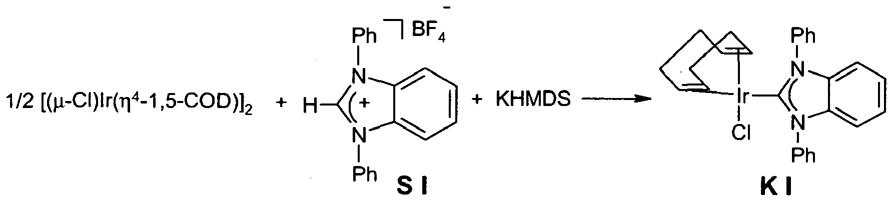

In einem 11-Dreihalskolben werden 16.11 g (45 mmol) Benzimidazoliumsalz S I in 250 ml Toluol suspendiert und auf -8°C abgekühlt. Dann werden 90 ml Bis(trimethylsilyl)kaliumamid (KHMDS, 0.5M in Toluol, 45 mmol) innerhalb von 30 min zugesetzt. Das Gemisch wird eine Stunde bei Raumtemperatur gerührt und danach innerhalb von 30 min bei -78°C zu einer Lösung von 15.12 g (22.5 mmol) [(µ-Cl)Ir(η⁴-1,5-COD)]₂ in 400 ml Toluol getropft. Die Reaktionsmischung wird 1.5 h bei Raumtemperatur gerührt und anschließend 18 h am Rückfluss erhitzt. Nach dem Abkühlen wird der Niederschlag abfiltriert und mit Toluol gewaschen. Die vereinigten Toluolphasen werden zur Trockene eingeengt und säulenchromatographisch gereinigt. Man erhält 13.4 g (49 %) gelbes Pulver.

¹H-NMR (CD₂Cl₂, 500 MHz): δ = 7.96 (m, 4H), 7.51 (m, 6H), 7.25 (m, 2H), 7.18 (m, 2H) (je CH_{Ph}), 4.31 (m, 2H, CH_{cod}), 2.43 (m, 2H, CH_{cod}), 1.61 (m, 2H), 1.34 (m, 4H), 1.17 (m, 2H) (je CH_{2,cod}).

¹³C-NMR (CD₂Cl₂, 125 MHz): δ = 191.5 (NCN), 137.0, 135.0 (Cq), 128.1, 127.8, 127.1, 122.5, 110.0 (CH_{Ph}), 84.5, 51.4 (je CH_{cod}), 32.1, 28.1 (je CH_{2,cod}).

### b) Synthese von Komplex K II

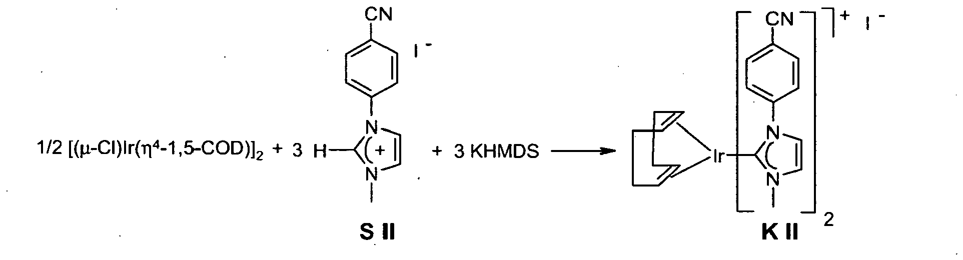

13.74 g (44.16 mmol) Imidazoliumiodid **S II** werden in 200 ml THF suspendiert und bei -8°C innerhalb von 30 min mit 88.32 ml Bis(trimethylsilyl)kaliumamid (0.5M in Toluol, 44.16 mmol) versetzt. Die Suspension wird eine Stunde bei Raumtemperatur gerührt und anschließend bei -78°C innerhalb von 30 min zu einer Lösung von 4.94 g (7.36 mmol) [(µ-Cl)Ir(η⁴-1,5-COD)]₂ in 360 ml THF getropft. Es wird 1.5 h bei Raumtemperatur und 17 h unter Rückfluss gerührt. Nach dem Abkühlen wird der Niederschlag abfiltriert, mit THF, H₂O und Methanol gewaschen und getrocknet. Man erhält 4.02 g (34 %) orangefarbenes Pulver.

¹H-NMR (DMSO, 500 MHz): δ = 8.09 (d, ³*J*_{H,H} = 7.8 Hz, 4H, CHₚₕ), 7.53 (d, ³*J*_{H,H} = 7.8 Hz, 4H, CHₚₕ), 7.46 (s, 2H, NCHCHN), 7.34 (s, 2H, NCHCHN), 4.64 (m, 2H, CH_{cod}), 3.58 (m, 2H, CH_{cod}), 3.06 (s, 6H, NCH₃), 2.33-2.01 (m, 4H, CH_{2, cod}), 1.76-1.1.59 (m, 4H, CH₂, _{cod}).

### c) Synthese von Komplex K III (Weg 1)

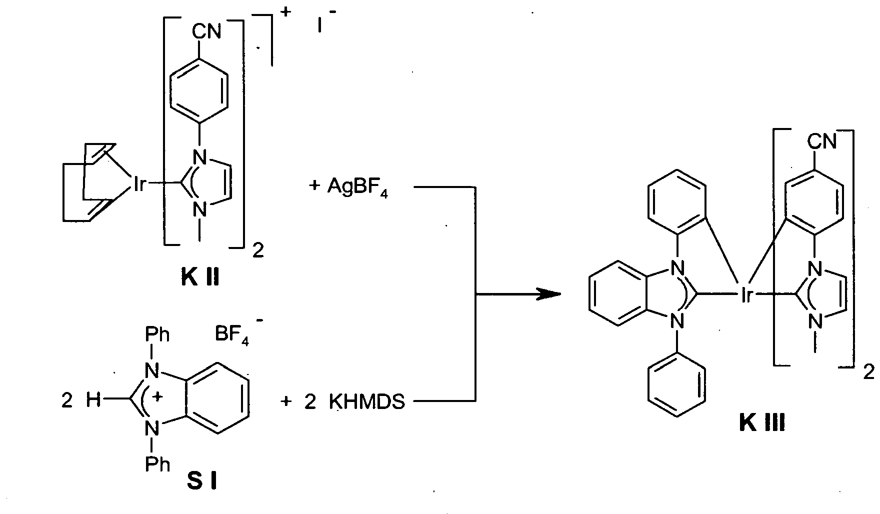

1.24 g (3.46 mmol) Benzimidazoliumsalz S I werden in 90 ml Dioxan suspendiert. Dann werden 6.9 ml Bis(trimethylsilyl)kaliumamid (KHMDS, 0.5M in Toluol, 3.45 mmol) innerhalb von 10 min zugesetzt. Das Gemisch wird eine halbe Stunde bei Raumtemperatur gerührt und danach innerhalb von 20 min zu einem Gemisch aus 1.37 g (1.73 mmol) **K II** und 0.34 g (1.73 mmol) Silbertetrafluoroborat in 90 ml Dioxan getropft. Die Reaktionsmischung wird eine Stunde bei Raumtemperatur gerührt und anschließend 21 h am Rückfluss erhitzt. Nach dem Abkühlen wird der Niederschlag abfiltriert und mit Dioxan gewaschen. Das Filtrat wird vom Lösungsmittel befreit und mit Methylenchlorid extrahiert. Aus dem Extrakt erhält man nach säulenchromatographischer Aufreinigung 0.38 g (27 %) gelbes Pulver.

### d) Synthese von Komplex K III (Weg 2)

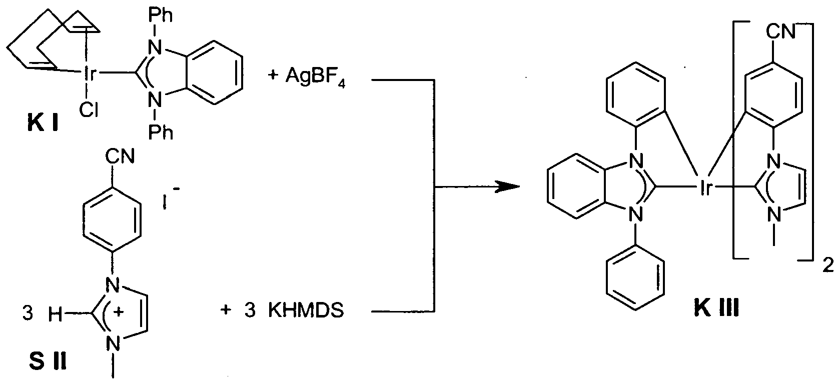

2.31 g (7.38 mmol) Imidazoliumsalz **S II** werden in 135 ml Dioxan suspendiert. Dann werden 14.8 ml Bis(trimethylsilyl)kaliumamid (KHMDS, 0.5M in Toluol, 7.40 mmol) innerhalb von 10 min zugesetzt. Das Gemisch wird eine Stunde bei Raumtemperatur gerührt und danach innerhalb von 20 min zu einem Gemisch aus 1.5 g (2.46 mmol) **K I** und 0.48 g (2.46 mmol) Silbertetrafluoroborat in 90 ml Dioxan getropft. Die Reaktionsmischung wird eine Stunde bei Raumtemperatur gerührt und anschließend 21 h am Rückfluss erhitzt. Nach dem Abkühlen wird der Niederschlag abfiltriert und mit Dioxan gewaschen. Das Filtrat wird vom Lösungsmittel befreit und mit Methylenchlorid extrahiert. Aus dem Extrakt erhält man nach säulenchromatographischer Aufreinigung 0.70 g (34 %) leicht gelbliches Pulver.

¹H-NMR (CD₂Cl₂, 500 MHz): δ = 2.44 (s, 3H), 3.21 (s, 3H), 6.21-6.23 (m, 1 H), 6.26 (d, *J* = 2.1 Hz, 1H), 6.51 (dd, *J* = 7.3 Hz, *J* = 1.5 Hz, 1 H), 6.59-6.60 (m, 1 H), 6.72 (dt, *J* = 7.3 Hz, *J* = 1.1 Hz, 1 H), 6.77 (d, *J* = 2.3 Hz, 1H), 6.81-6.82 (m, 1 H), 6.85-6.87 (m, 1H), 7.06-7-19 (m, 4H), 7.21-7.26 (m, 3H), 7.28-7.33 (m, 2H), 7.35-7.39 (m, 2H), 7.43-7.49 (m, 2H), 7.98 (d, *J* = 7.9 Hz, 1 H), 8.25 (d, *J* = 8.2 Hz, 1H).

¹³C-NMR (CD₂Cl₂, 126 MHz): δ = 36.5 (CH₃), 37.5 (CH₃), 108.02 (Cq, CN), 108.04 (Cq, CN),110.5 (CH), 110.9 (CH), 111.2 (CH), 111.7 (CH), 113.0 (CH), 114.6 (CH), 115.1 (CH), 121.0 (Cq), 121.1 (Cq), 121.66 (CH), 121.73 (CH), 121.8 (CH), 122.7 (CH), 123.8 (CH), 125.3 (CH), 126.3 (CH), 126.5 (CH), 126.7 (CH), 128.6 (CH), 128.8 (CH), 129.1 (CH), 130.0 (CH), 132.7 (Cq), 137.4 (CH), 138.2 (Cq), 138.4 (Cq), 140.2 (CH), 141.3 (CH), 147.2 (Cq), 149.1 (Cq), 149.7 (Cq), 150.7 (Cq), 151.17 (Cq), 151.23 (Cq), 176.6 (Cq, NCN), 177.5 (Cq, NCN), 187.1 (Cq, NCN).

### e) Optische Spektroskopie

Photolumineszenz (Polymethylmethacrylat (PMMA)-Filme, dotiert mit 2 Gew.-% des jeweiligen Carbenkomplexes)

| | Emissionswellenlänge | Quantenausbeute |
|---|---|---|
| 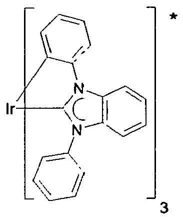 | 390 nm | 15% |
| 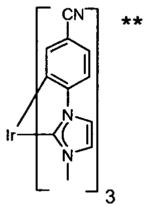 | 460 nm | 78 % |
| 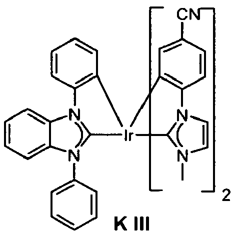 | 450 nm | 78 % |

| | | |
|---|---|---|
| * zur Herstellung siehe Ir-Komplex (7) in der Anmeldung WO 05/019373 ** zur Herstellung siehe deutsche Anmeldung mit dem Aktenzeichen 102004057072.8, angemeldet am: 25.11.2004, Titel: "Verwendung von Übergangsmetall-Carbenkomplexen in organischen Licht-emittierenden Dioden (OLEDs)" | | |

### f) Herstellung einer OLED

Das als Anode verwendete ITO-Substrat wird zuerst mit kommerziellen Reinigungsmitteln für die LCD-Produktion (Deconex^{®} 20NS und Neutralisationsmittel 25ORGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektionseigenschaften des ITOs.

Danach werden die nachfolgend genannten organischen Materialien mit einer Rate von ca. 2-3 nm/min bei etwa 10⁻⁷ mbar auf das gereinigte Substrat aufgedampft. Als Lochleiter und Excitonenblocker wird Ir(dpbic)₃ mit einer Dicke von 20 nm auf das Substrat aufgebracht. 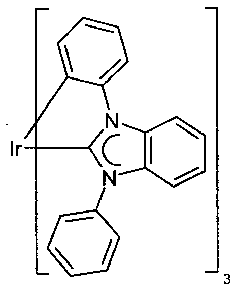 (zur Herstellung siehe Ir-Komplex (7) in der Anmeldung WO 05/019373).

Anschließend wird eine Mischung aus 30 Gew.-% der Verbindung 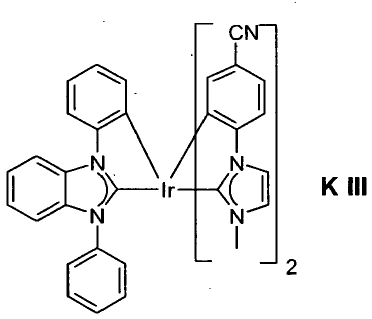 und 70 Gew.-% der Verbindung 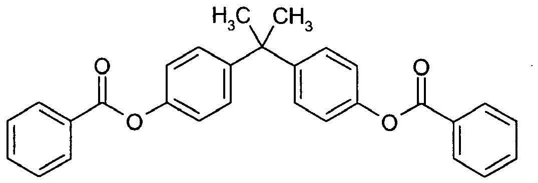 (zur Herstellung siehe deutsche Anmeldung mit dem Aktenzeichen 102005014284.2, angemeldet am: 24.03.2005, Titel: "Verwendung von Verbindungen, welche aromatische oder heteroaromatische über Carbonyl-Gruppen enthaltende Gruppen verbundene Ringe enthalten, als Matrixmaterialien in organischen Leuchtdioden") in einer Dicke von 20 nm aufgedampft, wobei erstere Verbindung als Emitter, letztere als Matrixmaterial fungiert.

Anschließend wird das Material 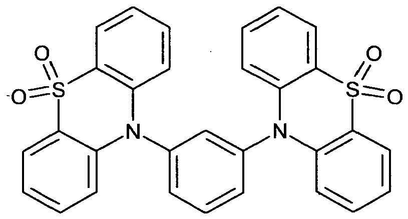 (zur Herstellung siehe deutsche Anmeldung mit dem Aktenzeichen 102004057073.6, angemeldet am: 25.11.2004, Titel: "Verwendung von Phenothiazin-S-oxiden und -S,S-dioxiden als Matrixmaterialien für organische Leuchtdioden")
mit einer Dicke von 9 nm als Excitonen- und Lochblocker aufgedampft.

Als nächstes wird ein Elektronentransporter TPBI (1,3,5-Tris(N-phenylbenzylimidazol-2-yl)benzol) in einer Dicke von 40 nm, eine 0,75 nm dicke Lithiumfluorid-Schicht und abschliessend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

Für das beschriebene OLED ergeben sich die folgenden elektrooptischen Daten:

| | |
|---|---|
| Emissionsmaximum | 456 nm |
| CIE(x, y) | 0,155; 0,12 |
| Photometrischer Wirkungsgrad bei 4 V | 9,6 cd/A |
| Leistungseffizienz bei 4 V | 7,5 Im/W |
| Externe Quantenausbeute bei 4 V | 9,7 % |
| Leuchtdichte bei 7V | 1500 cd/m² |

## Patentansprüche

1. Heteroleptische Carbenkomplexe der allgemeinen Formel (I)
M¹[carben]ₙ (I)
enthaltend mindestens zwei verschiedene Carbenliganden,
worin die Symbole die folgenden Bedeutungen aufweisen:
M¹ Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metallatom möglichen Oxidationsstufe;
n Zahl der Carbenliganden, wobei n mindestens 2 ist;
wobei n von der Oxidationsstufe und Koordinationszahl des eingesetzten Metallatoms und von der Zähnigkeit sowie von der Ladung der Liganden carben abhängig ist;
carben Carbenligand der allgemeinen Formel (II) 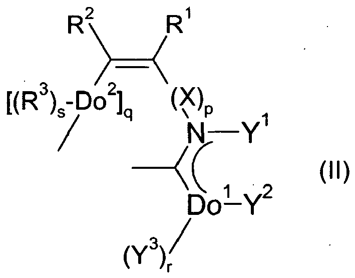 wobei die Symbole in dem Carbenliganden der allgemeinen Formel II die folgenden Bedeutungen aufweisen:
Do¹ Donoratom ausgewählt aus der Gruppe bestehend aus C, P, N, O, S und Si, bevorzugt P, N, O und S;
Do² Donoratom ausgewählt aus der Gruppe bestehend aus C, N, P, O und S;
r 2, wenn Do' C oder Si ist, 1, wenn Do¹ N oder P ist und 0, wenn Do¹ O oder S ist;
s 2, wenn Do² C ist, 1, wenn Do² N oder P ist und 0, wenn Do² O oder S ist;
X Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
w 2 bis 10;
R¹³, R¹⁴, R¹⁵, R¹⁶, R¹⁷ H, Alkyl, Aryl, Heteroaryl, Alkenyl, Alkinyl;
p 0 oder 1;
q 0 oder 1;
Y¹, Y² jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R² unabhängig voneinander Wasserstoff, Alkyl-, Aryl-, Heteroaryl-, Alkinyl-oder Alkenylreste, oder R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 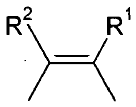 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann, und der fünf- bis siebengliedrige Ring gegebenenfalls mit einem oder mehreren weiteren Ringen anelliert sein kann;
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸ R¹⁹, R²⁰, R²¹, R²², R³⁰, R³¹ H, Alkyl, Aryl, Heteroaryl, Alkenyl, Alkinyl
bedeuten;
R³ Wasserstoff, ein Alkyl-, Aryl-, Heteroaryl-, Alkinyl- oder Alkenylrest;
**dadurch gekennzeichnet, dass** die mindestens 2 Carbenliganden verschiedene Bedeutungen Y³ aufweisen, wobei
Y³ in mindestens einem ersten Carbenliganden (IIa) die folgende Bedeutung aufweist:
Wasserstoff, ein Alkyl-, Alkinyl- oder Alkenylrest,
wobei, wenn Do¹ C oder Si ist und r 2 bedeutet, beide Reste Y³ die vorstehend genannten Bedeutungen aufweisen;
und
Y³ in mindestens einem zweiten Carbenliganden (IIb) die folgende Bedeutung aufweist: 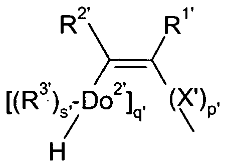 wobei Do^{2'}, q^{'}, s^{'}, R^{3'}, R^{1'}, R^{2'}, X^{'} und p^{'} unabhängig die gleichen Bedeutungen wie Do², q, s, R³, R¹, R², X und p aufweisen, und
wenn Do¹ C oder Si ist und r 2 bedeutet, mindestens einer der beide Resten Y³ die vorstehend genannte Bedeutung aufweist; der zweite Rest Y³ kann die vorstehend genannte Bedeutung oder die bezüglich des ersten Carbenliganden für Y³ genannten Bedeutungen aufweisen;
und
Y³ in einem dritten oder weiteren Carbenliganden in heteroleptischen Carbenkomplexen der allgemeinen Formel I worin n > 2 ist, entweder die in dem ersten Carbenliganden (IIa) genannten Bedeutungen oder die in dem zweiten Carbenliganden (IIb) genannten Bedeutungen aufweist;
weiterhin können Y³ und Y² in jedem der n Carbenliganden über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
y 2 bis 10;
und
R²⁵, R²⁶, R²⁷, R²⁸, R²⁹, R³², R³³ H, Alkyl, Aryl, Heteroaryl, Alkenyl, Alkinyl
bedeuten.

2. Carbenkomplexe nach Anspruch 1, **dadurch gekennzeichnet, dass** die Gruppierung 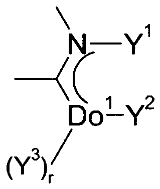 ausgewählt ist aus der Gruppe bestehend aus 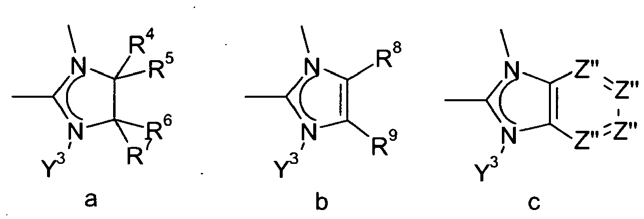 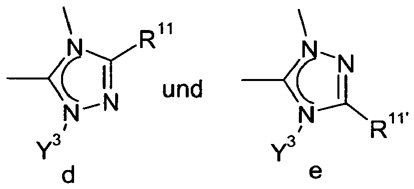 worin die Symbole die folgenden Bedeutungen aufweisen:
Z" unabhängig voneinander CR¹⁰ oder N;
R⁴, R⁵, R⁶, R⁷, R⁸, R⁹, R¹¹ und R^{11'} Wasserstoff, Alkyl, Aryl, Heteroaryl, Alkinyl oder Alkenyl oder ein Substituent mit Donor- oder Akzeptorwirkung;
R¹⁰ Wasserstoff, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung; wobei bevorzugt mindestens ein Rest R¹⁰ H bedeutet, besonders bevorzugt mindestens zwei Reste R¹⁰ H bedeuten, ganz besonders bevorzugt drei oder vier Reste R¹⁰ H bedeuten;
weiterhin können R⁴ oder R⁵ in der Gruppierung a, R⁸ in der Gruppierung b, einer der Reste R¹⁰ in der Gruppierung c und R¹¹ in der Gruppierung d mit R¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
wobei
Y³ in mindestens einem ersten Carbenliganden (IIa) die folgende Bedeutung aufweist:
Wasserstoff, ein Alkyl-, Alkinyl- oder Alkenylrest;
und
Y³ in mindestens einem zweiten Carbenliganden (IIb) die folgende Bedeutung aufweist: 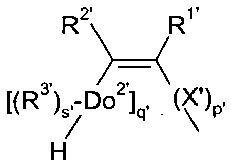 wobei Do^{2'}, q^{'}, s^{'}, R^{3'}, R^{1'}, R^{2'}, X^{'} und p^{'} unabhängig die gleichen Bedeutungen wie Do², q, s, R³, R¹, R², X und p aufweisen.

3. Carbenkomplexe nach Anspruch 1 oder 2, **dadurch gekennzeichnet, dass** die Gruppierung 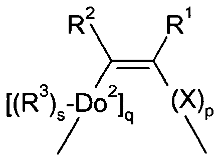 die Struktur 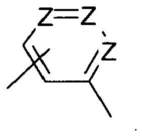 bedeutet,
worin die Symbole die folgenden Bedeutungen aufweisen:
Z unabhängig voneinander CR¹² oder N, wobei 0 bis 3 Symbole Z N bedeuten können;
R¹² in den Gruppen Z unabhängig voneinander H, ein Alkyl-, Aryl-, Heteroaryl-, Alkinyl-, Alkenylrest, oder jeweils 2 Reste R¹² bilden gemeinsam einen anellierten Ring, der gegebenenfalls mindestens ein Heteroatom enthalten kann, oder R¹² bedeutet einen Rest mit Donor- oder Akzeptorwirkung;
weiterhin kann die Gruppe der Struktur 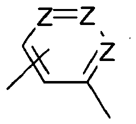 über den aromatischen Grundkörper oder über einen der Reste R¹² mit Y¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten.

4. Carbenkomplexe nach einem der Ansprüche 1 bis 3, **dadurch gekennzeichnet, dass** der mindestens eine erste Carbenligand (IIa) ausgewählt ist aus der Gruppe bestehend aus 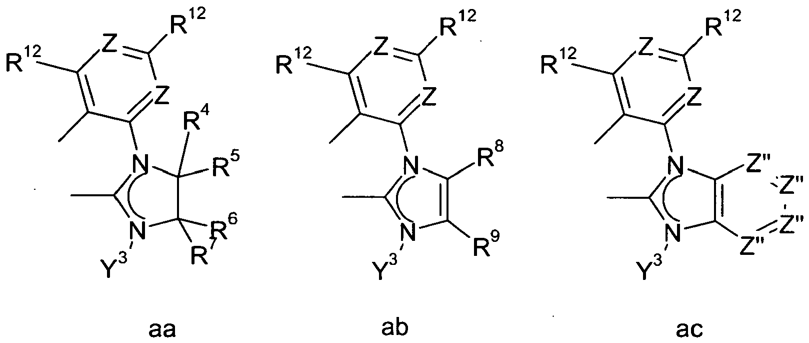 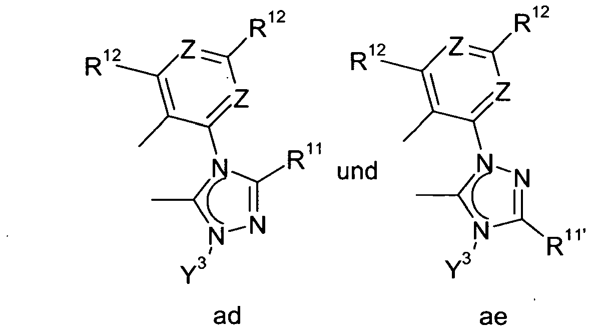 worin die Symbole die folgenden Bedeutungen aufweisen:
Z gleich oder verschieden CR¹² oder N;
Z" gleich oder verschieden CR¹⁰ oder N;
R¹² unabhängig voneinander H, ein Alkyl-, Aryl-, Heteroaryl-, Alkinyl- oder Alkenylrest, oder jeweils 2 Reste R¹² bilden gemeinsam einen anellierten Ring, der gegebenenfalls mindestens ein Heteroatom enthalten kann, oder R¹² bedeutet einen Rest mit Donor- oder Akzeptorwirkung;
R⁴, R⁵, R⁶, R⁷, R⁸, R⁹, R¹¹ und R^{11'} Wasserstoff, Alkyl, Aryl, Heteroaryl, Alkinyl oder Alkenyl oder ein Rest mit Donor- oder Akzeptorwirkung;
R¹⁰ in den Gruppen Z" unabhängig voneinander H, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 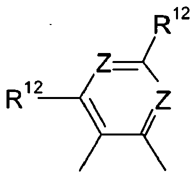 über den aromatischen Grundkörper oder über einen der Reste R¹² mit R⁴ oder R⁵ oder dem Kohlenstoffatom, mit dem R⁴ und R⁵ verknüpft sind, in der Gruppierung aa, R⁸ oder dem Kohlenstoffatom, mit dem R⁸ verknüpft ist, in der Gruppierung ab, einen der Reste R¹⁰ oder einem der Kohlenstoffatome, mit dem R¹⁰ verknüpft ist, in der Gruppierung ac und R¹¹ oder dem Kohlenstoffatom, mit dem R¹¹ verknüpft ist, in der Gruppierung ad über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
wobei in den Fällen, worin die Gruppe der Struktur 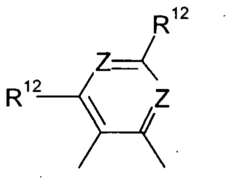 über eine Brücke mit dem Kohlenstoffatom, mit dem R⁴ und R⁵ verknüpft sind (Gruppierung aa), dem Kohlenstoffatom, mit dem R⁸ verknüpft ist (Gruppierung ab), einem der Kohlenstoffatome, mit dem R¹⁰ verknüpft ist (Gruppierung ac) oder dem Kohlenstoffatom, mit dem R¹¹ verknüpft ist (Gruppierung ad), verknüpft ist, der jeweilige Rest R⁴ oder R⁵, R⁸, einer der Reste R¹⁰ oder R¹¹ durch eine Bindung zu der Brücke ersetzt ist;
Y³ ein Alkyl-, Alkinyl- oder Alkenylrest.

5. Carbenkomplexe nach einem der Ansprüche 1 bis 4, **dadurch gekennzeichnet, dass** der mindestens eine zweite Carbenligand (IIb) ausgewählt ist aus der Gruppe bestehend aus 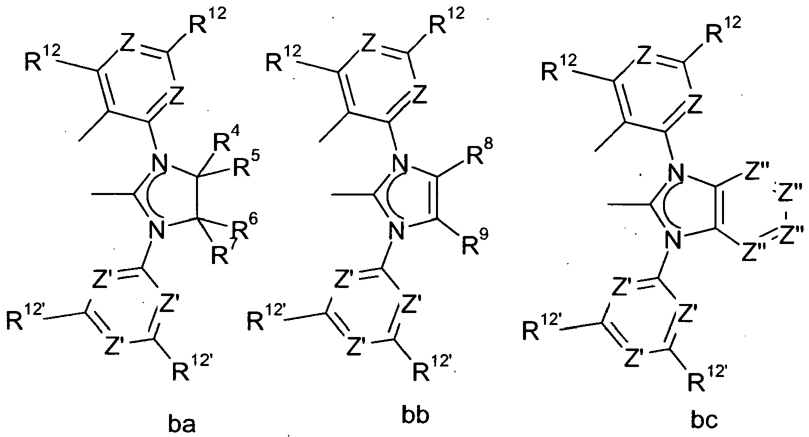 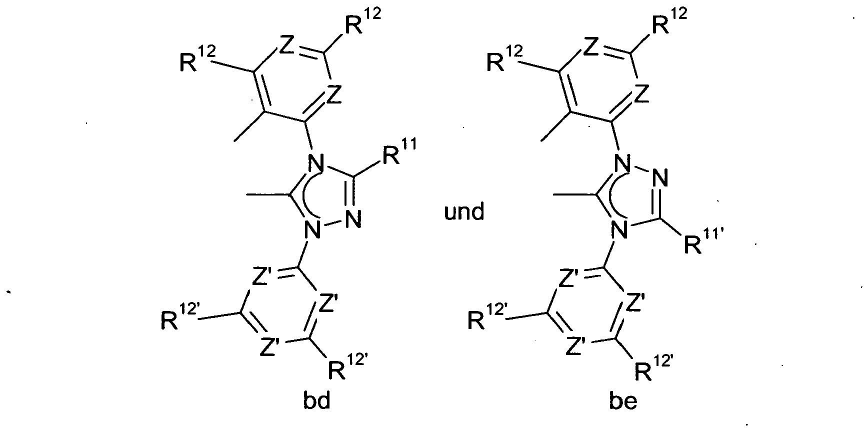 worin die Symbole die folgenden Bedeutungen aufweisen:
Z gleich oder verschieden CR¹² oder N;
Z' gleich oder verschieden CR^{12'} oder N;
Z" gleich oder verschieden CR¹⁰ oder N;
R¹², R^{12'} gleich oder verschieden jeweils unabhängig voneinander H, ein Alkyl-, Aryl-, Heteroaryl-, Alkinyl- oder Alkenylrest, oder jeweils 2 Reste R¹² bzw. R^{12'} bilden gemeinsam einen anellierten Ring, der gegebenenfalls mindestens ein Heteroatom enthalten kann, oder R¹² bzw. R^{12'} bedeutet einen Rest mit Donor- oder Akzeptorwirkung;
R⁴, R⁵, R⁶, R⁷, R⁸, R⁹, R¹¹ und R^{11'} Wasserstoff, Alkyl, Aryl, Heteroaryl, Alkinyl oder Alkenyl oder ein Rest mit Donor- oder Akzeptorwirkung;
R¹⁰ in den Gruppen Z" unabhängig voneinander H, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 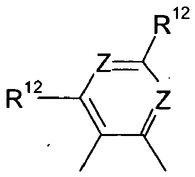 über den aromatischen Grundkörper oder über einen der Reste R¹² mit R⁴ oder R⁵ oder dem Kohlenstoffatom, mit dem R⁴ und R⁵ verknüpft sind, in der Gruppierung ba, R⁸ oder dem Kohlenstoffatom, mit dem R⁸ verknüpft ist, in der Gruppierung bb, einen der Reste R¹⁰ oder einem der Kohlenstoffatome, mit dem R¹⁰ verknüpft ist, in der Gruppierung bc und R¹¹ oder dem Kohlenstoffatom, mit dem R¹¹ verknüpft ist, in der Gruppierung bd über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
wobei in den Fällen, worin die Gruppe der Struktur 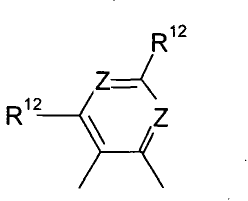 über eine Brücke mit dem Kohlenstoffatom, mit dem R⁴ und R⁵ verknüpft sind (Gruppierung ba), dem Kohlenstoffatom, mit dem R⁸ verknüpft ist (Gruppierung bb), einem der Kohlenstoffatome, mit dem R¹⁰ verknüpft ist (Gruppierung bc) oder dem Kohlenstoffatom, mit dem R¹¹ verknüpft ist (Gruppierung bd), verknüpft ist, der jeweilige Rest R⁴ oder R⁵, R⁸, einer der Reste R¹⁰ oder R¹¹ durch eine Bindung zu der Brücke ersetzt ist.

6. Carbenkomplexe nach einem der Ansprüche 1 bis 5, **dadurch gekennzeichnet, dass** M¹ Ir(III) und n 3 ist.

7. Carbenkomplexe nach Anspruch 6 ausgewählt aus Carbenkomplexen der Formeln (Ii) und (Iii) 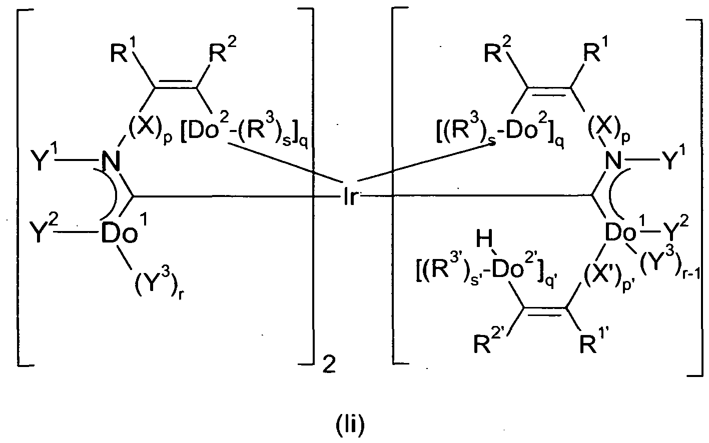 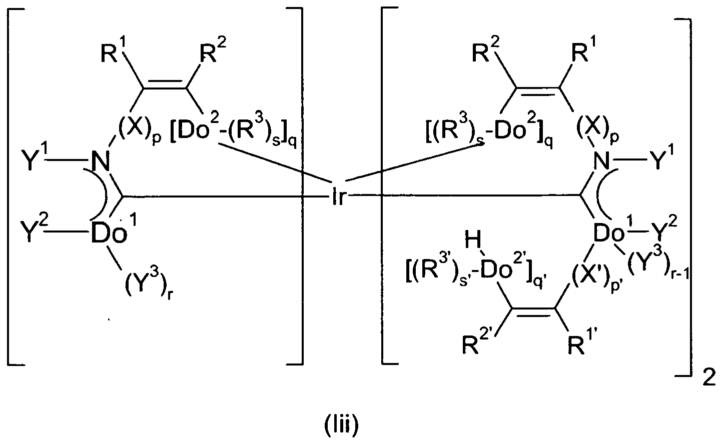 wobei die Symbole in den Carbenkomplexen der allgemeinen Formeln (Ii) und (I-ii) die folgenden Bedeutungen aufweisen:
Do¹ Donoratom ausgewählt aus der Gruppe bestehend aus C, P, N, O, S und Si, bevorzugt P, N, O und S; wobei in dem Carbenliganden 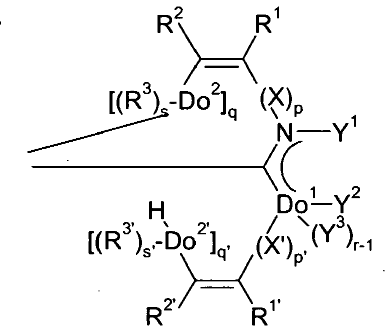
Do¹ nicht O oder S bedeutet;
Do², Do^{2'} unabhängig voneinander Donoratom ausgewählt aus der Gruppe bestehend aus C, N, P, O und S;
r 2, wenn Do' C oder Si ist, 1, wenn Do¹ N oder P ist und 0, wenn Do¹ O oder S ist;
s, s' 2, wenn Do² oder Do^{2'} C ist, 1, wenn Do² oder Do^{2'} N oder P ist und 0, wenn Do² oder Do^{2'} O oder S ist;
X, X' unabhängig voneinander Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
w 2 bis 10;
R¹³, R¹⁴, R¹⁵, R¹⁶, R¹⁷ H, Alkyl, Aryl, Heteroaryl, Alkenyl, Alkinyl;
p, p' unabhängig voneinander 0 oder 1;
q, q' unabhängig voneinander 0 oder 1;
Y¹, Y² jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R², R^{1'}, R^{2'} unabhängig voneinander Wasserstoff, Alkyl-, Aryl-, Heteroaryl-, Alkinyl-oder Alkenylreste, oder R¹ und R² bzw. R^{1'} und R^{2'} bilden gemeinsam eine Brücke mit insgesamt drei bis fünf Atomen, wovon 1 bis 5 Atome Heteroatome sein können und die restlichen Atome Kohlenstoffatome sind, so dass die Gruppe 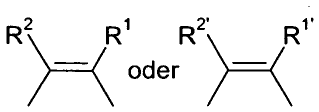 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann und der fünf- bis siebengliedrige Ring gegebenenfalls mit einem oder mehreren weiteren Ringen anelliert sein kann;
weiterhin können Y¹ und R¹ bzw. Y² und R^{1'} über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
R³ Wasserstoff, ein Alkyl-, Aryl-, Heteroaryl-, Alkinyl- oder Alkenylrest;
Y³ Wasserstoff, ein Alkyl-, Alkinyl- oder Alkenylrest;
weiterhin können Y³ und Y² über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
y 2 bis 10;
und
R²⁵, R²⁶, R²⁷, R²⁸, R²⁹, R³², R³³ H, Alkyl, Aryl, Heteroaryl, Alkenyl, Alkinyl
bedeuten;
wobei die Reste, Gruppen und Indizes R¹, R², Y¹, Y², Do¹, Do², Y³, X, R³, p, q, r, s, R^{1'}, R^{2'} , Do^{2'}, R^{3'}, p', q', s' in den verschiedenen Carbenliganden jeweils gleich oder verschieden sein können.

8. Verfahren zur Herstellung von heteroleptischen Carbenkomplexen der allgemeinen Formel I nach einem der Ansprüche 1 bis 7, **dadurch gekennzeichnet, dass** die Herstellung den folgenden Schritt umfasst:
Umsetzung von mindestens 2 Ligandvorläufern der allgemeinen Formel (III) 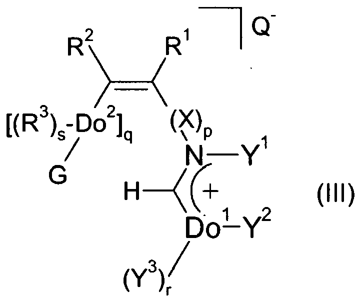 worin
Q- ein monoanionisches Gegenion, bevorzugt Halogenid, Pseudohalogenid, BF₄⁻, BPh₄⁻, PF₆⁻, AsF₆⁻ oder SbF₆⁻;
und
G wenn Do² = C oder q = 0 ist, H bedeutet, und wenn Do² = N, S, O oder P ist, H oder ein freies Elektronenpaar des Heteroatoms bedeutet;
bedeuten, und
die weiteren Symbole in dem Ligandvorläufer der allgemeinen Formel III die folgenden Bedeutungen aufweisen:
Do¹ Donoratom ausgewählt aus der Gruppe bestehend aus C, P, N, O, S und Si, bevorzugt P, N, O und S;
Do² Donoratom ausgewählt aus der Gruppe bestehend aus C, N, P, O und S;
r 2, wenn Do¹ C oder Si ist, 1, wenn Do¹ N oder P ist und 0, wenn Do¹ O oder S ist;
s 2, wenn Do² C ist, 1, wenn Do² N oder P ist und 0, wenn Do² O oder S ist;
X Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵,O,S, SO, SO₂, CO, CO-O, O-CO ersetzt sein können;
w 2 bis 10;
R¹³, R¹⁴, R¹⁵, R¹⁶ R¹⁷ H, Alkyl, Aryl, Heteroaryl, Alkenyl, Alkinyl;
p 0 oder 1;
q 0 oder 1;
Y¹, Y² jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R² unabhängig voneinander Wasserstoff, Alkyl-, Aryl-, Heteroaryl-, Alkinyl-oder Alkenylreste,
oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 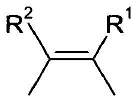 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann und der fünf- bis siebengliedrige Ring gegebenenfalls mit einem oder mehreren weiteren Ringen anelliert sein kann.
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
R³ Wasserstoff, ein Alkyl-, Aryl-, Heteroaryl-, Alkinyl- oder Alkenylrest;
wobei
die mindestens 2 Ligandvorläufer der allgemeinen Formel III verschiedene Bedeutungen Y³ aufweisen,
wobei
Y³ in mindestens einem ersten Ligandvorläufer (IIIa) die folgende Bedeutung aufweist:
Wasserstoff, ein Alkyl-, Alkinyl- oder Alkenylrest,
wobei, wenn Do¹ C oder Si ist und r 2 bedeutet, beide Reste Y³ die vorstehend genannten Bedeutungen aufweisen;
und
Y³ in mindestens einem zweiten Ligandvorläufer (IIIb) die folgende Bedeutung aufweist: 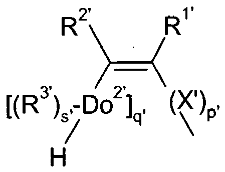 wobei Do^{2'} , q', s', R^{3'}, R^{1'}, R^{2'}, X' und p' unabhängig die gleichen Bedeutungen wie Do², q, s, R³, R¹, R², X und p aufweisen, und
wenn Do¹ C oder Si ist und r 2 bedeutet, mindestens einer der beide Resten Y³ die vorstehend genannte Bedeutung aufweist; der zweite Rest Y³ kann die vorstehend genannte Bedeutung oder die bezüglich des ersten Ligandvorläufers für Y³ genannten Bedeutungen aufweisen;
mit einem Metallkomplex enthaltend mindestens ein Metall M^{1'}, wobei M^{1'} die folgenden Bedeutungen aufweist:
M^{1'} Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metallatom möglichen Oxidationsstufe.

9. Verfahren nach Anspruch 8, **dadurch gekennzeichnet, dass** als Metall M^{1'} Ir, bevorzugt Ir(I) oder Ir(III) eingesetzt wird.

10. Verwendung von heteroleptischen Carbenkomplexen gemäß einem der Ansprüche 1 bis 7 oder hergestellt gemäß Anspruch 8 oder 9 in organischen Leuchtdioden.

11. Organische Leuchtdiode enthaltend mindestens einen heteroleptischen Carbenkomplex gemäß einem der Ansprüche 1 bis 7 oder hergestellt gemäß Anspruch 8 oder 9.

12. Licht-emittierende Schicht enthaltend mindestens einen heteroleptischen Carbenkomplex gemäß einem der Ansprüche 1 bis 7 oder hergestellt gemäß Anspruch 8 oder 9.

13. Organische Leuchtdiode enthaltend mindestens eine Licht-emittierende Schicht nach Anspruch 12.

14. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen enthaltend mindestens eine organische Leuchtdiode gemäß Anspruch 11 oder 13.

## Claims

1. A heteroleptic carbene complex of the general formula (I)
M¹ [carbene]ₙ (I)
comprising at least two different carbene ligands,
in which the symbols are each defined as follows:
M¹ is a metal atom selected from the group consisting of Ir, Co, Rh, Ni, Pd, Pt, Fe, Ru, Os, Cr, Mo, W, Mn, Tc, Re, Cu and Au, preferably Ir, Os, Ru, Rh, Pd, Co and Pt, more preferably Ir, Pt, Rh and Os, in any oxidation state possible for the corresponding metal atom;
n is the number of carbene ligand, where n is at least 2;
where n is dependent on the oxidation state and coordination number of the metal atom used and on the denticity and on the charge of the carbene ligands;
carbene is a carbene ligand of the general formula (II) 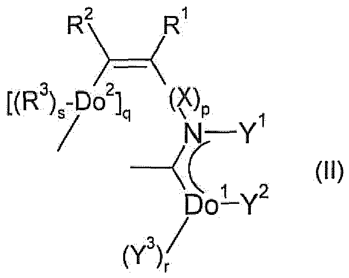 where the symbols in the carbene ligand of the general formula II are each defined as follows:
Do¹ is a donor atom selected from the group consisting of C, P, N, O, S and Si, preferably P, N, O and S;
Do² is a donor atom selected from the group consisting of C, N, P, O and S;
r is 2 when Do¹ is C or Si, is 1 when Do¹ is N or P, and is 0 when Do¹ is 0 or S;
s is 2 when Do² is C, is 1 when Do² is N or P, and is 0 when Do2 is O or S;
X is a spacer selected from the group consisting of silylene, alkylene, arylene, heteroarylene, alkynylene, alkenylene, NR¹³, PR¹⁴, BR¹⁵, O, S, SO, SO₂, CO, CO-O, O-CO and (CR¹⁶R¹⁷)_{w}, where one or more nonadjacent (CR¹⁶R^{l7}) groups may be replaced by NR¹³, PR¹⁴, BR¹⁵, O, S, SO, SO₂, CO, CO-O, O-CO;
w is from 2 to 10;
R¹³, R¹⁴, R¹⁵, R¹⁶, R¹⁷ are each H, alkyl, aryl, heteroaryl, alkenyl, alkynyl;
P is 0 or 1;
q is 0 or 1;
Y¹, Y² are each independently hydrogen or a carbon group selected from the group consisting of alkyl, aryl, heteroaryl, alkynyl and alkenyl groups; or Y¹ and Y² together form a bridge between the donor atom Do¹ and the nitrogen atom N, said bridge having at least two atoms of which at least one is a carbon atom,
R¹, R² are each independently hydrogen, alkyl, aryl, heteroaryl, alkynyl or alkenyl radicals, or R¹ and R² together form a bridge having a total of from three to five atoms, of which from 1 to 5 atoms may be heteroatoms and the remaining atoms are carbon atoms, so that the group 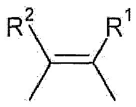 forms a five- to seven-membered ring which - in addition to the double bond already present - may optionally have one further double bond or - in the case of a six- or seven-membered ring - two further double bonds, and may optionally be substituted by alkyl or aryl groups and/or groups with donor or acceptor action, and may optionally comprise at least one heteroatom, and the five- to seven-membered ring may optionally be fused to one or more further rings;
in addiction, Y¹ and R¹ may be bonded to one another via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
R³ is hydrogen, an alkyl, aryl, heteroaryl, alkynyl or alkenyl radical;
wherein the at least 2 carbene ligand have different definitions of Y³, where
Y³ in at least one first carbene ligand (IIa) is defined as follow:
hydrogen, an alkyl, alkynyl or alkenyl radical, where, when Do¹ is C or Si and r is 2, the two Y³ radicals are each as defined above;
and
Y³ in at least one second carbene ligand (IIb) is defined as follows: 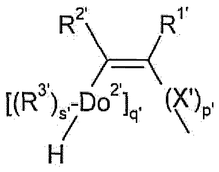 where Do²', q', s' R^{3'}, R^{1'}, R^{2'}, X' and p' are each independently as defined for Do², q, s, R³, R¹, R², and p, and
when Do¹ is C or Si and r is 2, at least one of the two Y³ radicals is as defined above; the second Y³ radical may be as defined above or be defined as specifies for Y³ with regard to the first carbene ligand;
and
Y³ in a third or further carbene ligand in heteroleptic carbene complexes of the general formula I in which n is > 2 is either as defined in the first carbene ligand (IIa) or as defined in the second carbene ligand (IIb);
in addiction, Y³ and Y² in each of the n carbene ligands may be bonded to one another via a bridge, where the bridge may be defined as follows:
alkylene, arylene, heteroarylene, alkynylene, alkenylene, NR²⁵, PR²⁶, BR²⁷, O, S, SO, SO₂, SiR³²R³³, CO, CO-O, O-CO and (CR²⁸R²⁹)_{y}, where one or more nonadjacent CCR²⁸R²⁹) groups may be replaced by NR²⁵, PR²⁶, BR²⁷, O, S, SO, SO₂, SiR¹²R³³, CO, CO-O, O-CO, where
y is from 2 to 10;
and
R²⁵, R²⁶, R²⁷, R²⁸, R²⁹, R³², R³³ are each H, alkyl, aryl, heteroaryl, alkenyl, alkynyl.

2. The carbene complex according to claim 1, wherein the moiety 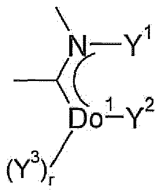 is selected from the group consisting of 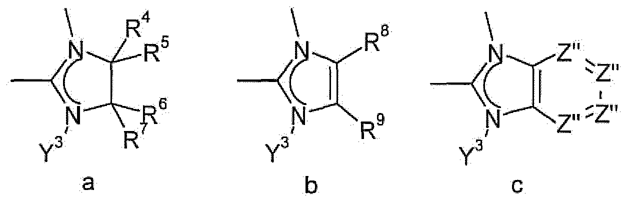 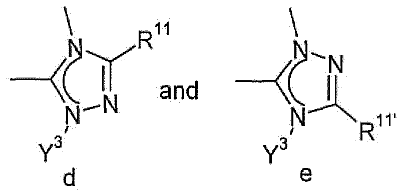 in which the symbols are each defined as follow:
Z" are each independently CR¹⁰ or N;
R⁴, R⁵, R⁶, R⁷, R⁸, R⁹, R¹¹ and R^{11'} are each hydrogen, alkyl, aryl, heteroaryl, alkynyl or alkenyl or a Substituent with donor or acceptor action;
R¹⁰ is hydrogen, alkyl, aryl, heteroaryl, alkynyl or alkenyl, or in each case 2 R¹⁰ radicals together form a fused ring which may optionally comprise at least one heteroatom, or R¹⁰ is a radical with donor or acceptor action, where at least one R¹⁰ radical is preferably H, more preferably at least two R¹⁰ radicals are each H, most preferable three or four R¹⁰ radicals are each H;
in addition, R⁴ or R⁵ in the moiety a, R⁸ in the moiety b, one of the R¹⁰ radicals in the moiety c and R¹¹ in the moiety d may be bonded to R¹ via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
where
Y³ in at least one first carbene ligand (IIa) is defined as follows:
hydrogen, an alkyl, alkynyl or alkenyl radical;
and
Y³ in at least one second carbene ligand (IIb) is defined as follows: 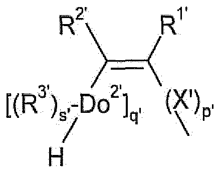 where Do^{2'}, q', s', R^{3'},R^{1'}, R^{2'}, X' and p' are each independently as defined for Do², q, s, R³, R¹, R², X and p.

3. The carbene complex according to claim 1 or 2, wherein the moiety 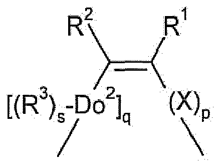 has the structure 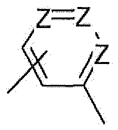 in which the symbols are each defined as follows:
Z are each independently CR¹² or N, where from 0 to 3 Z symbols may be N;
R¹² in the Z groups are each independently H, an alkyl, aryl, heteroaryl, alkynyl, alkenyl radical, or in each case 2 R¹² radicals together form a fused ring which may optionally comprise at least one heteroatom, or R¹² is a radical with donor or acceptor action;
in addiction, the group of the structure 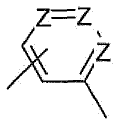 via the aromatic base structure or via one of the R¹² radicals, may be bonded to Y¹ via a bridge,
where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹
are each H, alkyl, aryl, heteroaryl, alkenyl, alkynyl.

4. The carbene complex according to any of claims 1 to 3, wherein the at least one first carbene ligand (IIa) is selected from the group consisting of 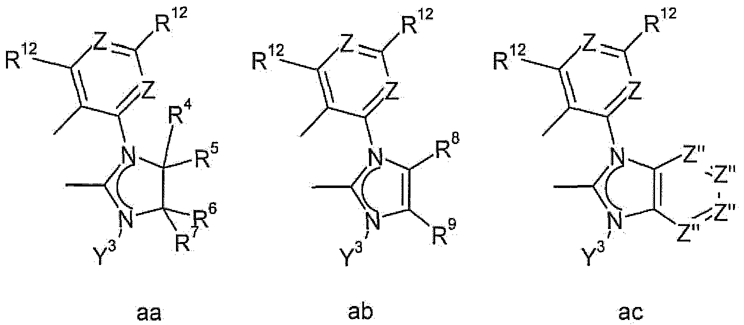 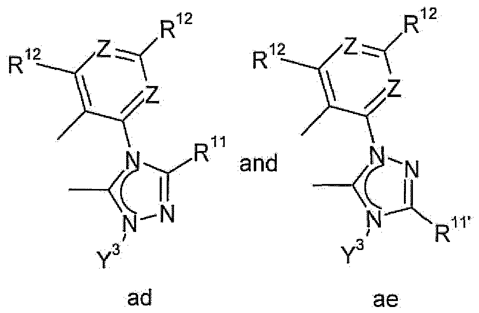 where the symbols are each defined as follows:
Z is the same or different and is CR¹² or N;
Z'' is the same or different and is CR¹⁰ or N;
R¹² are each independently H, an alkyl, aryl, heteroaryl, alkynyl or alkenyl, radical, or in each case 2 R¹² radicals together form a fused ring which may optionally comprise at least one heteroatom, or R¹² is a radical with donor or acceptor action;
R⁴, R⁵, R⁶, R⁷, R⁸, R⁹, R¹¹ and R^{11'} are each hydrogen, alkyl, aryl, heteroaryl, alkynyl or alkenyl, or a radical with donor or acceptor action;
R¹⁰ in the Z" groups are each independently H, alkyl, aryl, heteroaryl, alkynyl or alkenyl, or in each case 2 R¹⁰ radicals together form a fused ring which may optionally comprise at least one heteroatom, or R¹⁰ is a radical with donor or acceptor action;
in addition, the group of the structure 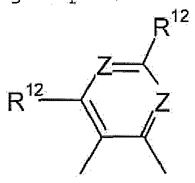 via the aromatic base structure or via one of the R¹² radicals, may be bonded via a bridge to R⁴ or R⁵ or the carbon atom to which R⁴ and R⁵ are bonded in the moiety aa, R⁸ or the carbon atom to which R⁸ is bonded in the moiety ab, one of the R¹⁰ radicals or one of the carbon atoms to which R¹⁰ is bonded in the moiety ac, and R¹¹ or the carbon atom to which R¹¹ is bonded in the moiety ad, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CHO and (CR²¹R²²)ₓ, where one or more nonadjacent CCR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, acryl, heteroaryl, alkenyl, alkynyl;
where, in the cases in which the group of the structure 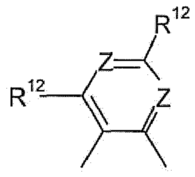 is bonded via a bridge to the carbon atom to which R⁴ and R⁵ are bonded (moiety aa), the carbon atom to which R⁸ is bonded (moiety ab), one of the carbon atoms to which R¹⁰ is bonded (moiety ac) or the carbon atom to which R¹¹ is bonded (moiety ad), the particular R⁴ or R⁵ radical, R⁸, one of the R¹⁰ radicals or R¹¹ is replaced by a bond to the bridge;
Y³ is an alkyl, alkynyl or alkynyl radical.

5. The carbene complex according to any of claims 1 to 4, wherein the at least one second carbene ligand (IIb) is selected from the group consisting of 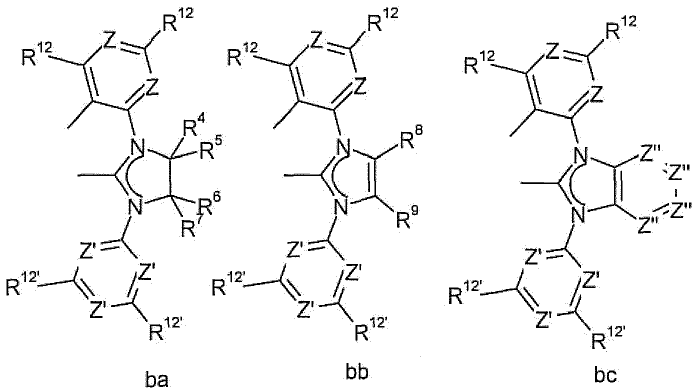 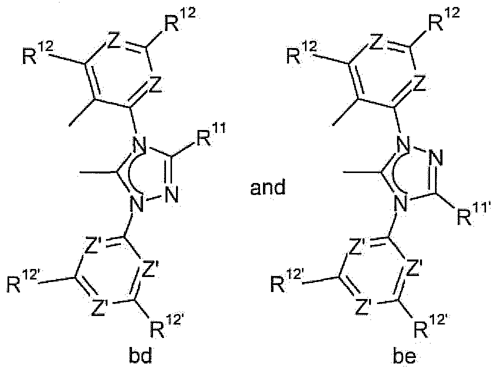 where the symbols are each defined as follows:
Z is the same or different and is CR¹² or N;
Z' is the same or different and is CR^{12'} or N;
Z" is the same or different and is CR¹⁰ or N;
R¹², R^{12'} are the same or different and are each independently H, an alkyl, aryl, heteroaryl, alkynyl or alkenyl radical, or in each case 2 R¹² or R^{12'} radicals together form a fused ring which may optionally comprise at least one heteroatom, or R¹² or R^{12'} is a radical with donor or acceptor action;
R⁴, R⁵, R⁶, R⁷, R⁸, R⁹, R¹¹ and R^{11'} are each hydrogen, alkyl, aryl, heteroaryl, alkynyl or alkenyl, or a radical with donor or acceptor action;
R¹⁰ in the Z" groups are each independently H, alkyl, aryl, heteroaryl, alkynyl or alkenyl, or in each case 2 R¹⁰ radicals together form a fused ring which may optionally comprise at least one heteroatom, or R¹⁰ is a radical with donor or acceptor action;
in addiction, the group of the structure 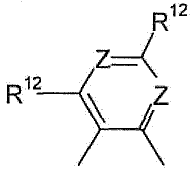 via the aromatic base structure or via one of the R¹² radicals, may be bonded via a bridge to R⁴ or R⁵ or the carbon atom to which R⁴ and R⁵ are bonded in the moiety ba, R⁸ or the carbon atom to which R⁸ is bonded in the moiety bb, one of the R¹⁰ radicals or
one of the carbon atoms to which R¹⁰ is bonded in the moiety bc, and R¹¹ or the carbon atom to which R¹¹ is bonded in the moiety bd, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CHO and (CR²¹R²²)ₓ, where one or more nonadjacent (CR²¹R²² groups may be replaced by NR¹⁸, PR¹⁹, BR²⁰, O, S, SO, SO₂, SiR³¹R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
where, in the cases in which the group of the structure 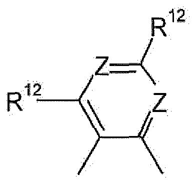 is bonded via a bridge to the carbon atom to which R⁴ and R⁵ are bonded (moiety ba), the carbon atom to which R⁸ is bonded (moiety bb), one of the carbon atoms to which R¹⁰ is bonded (moiety bc) or the carbon atom to which R¹¹ is bonded (moiety bd), the particular R⁴ or R⁵ radical, R⁸, one of the R¹⁰ radicals or R¹¹ is replaced by a bond to the bridge.

6. The carbene complex according to any of claims 1 to 5, wherein M¹ is Ir (III) and n is 3.

7. The carbene complex according to claim 6, selected from carbene complexes of the formulae (Ii) and (Iii) 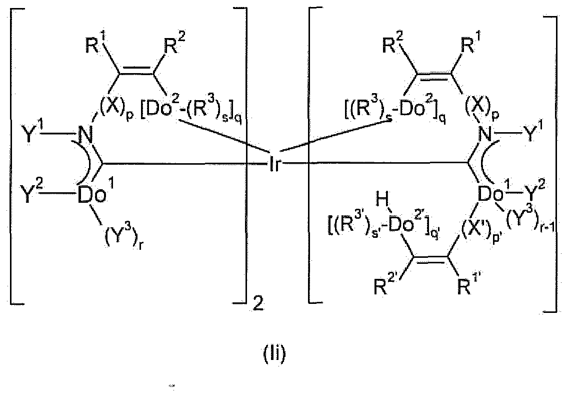 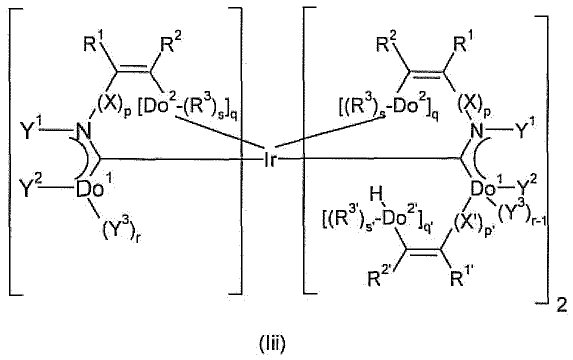 where the symbols in the carbene complexes of the general formulae (Ii) and (Iii) are each defined as follow:
Do¹ is a donor atom selected from the group consisting of C, P, N, O, S any Si, preferable P, N, O and S, where, in the carbene ligand 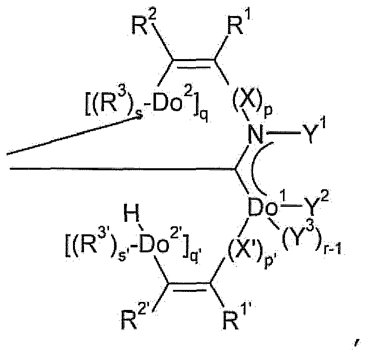 Do¹ is not O or S;
Do², Do^{2'} are each independently a donor atom selected from the group consisting of C, N, P, O and S;
r is 2 when Do¹ is C or Si, is 1 when Do¹ is N or P, and is 0 when Do¹ is O or S;
s, s' are each 2 when Do² or Do^{2'} is C, are each 1 when Do² or Do^{2'} is N or P, and are each 0 when Do² or Do^{2'} is O or S;
X, X' are each independently spacers selected from the group consisting of silylene, alkylene, arylene, heteroarylene, alkynylene, alkenylene, NR¹³, PR¹⁴, BR¹⁵, O, S, SO, SO₂, CO, CO-O, O-CO and (CR¹⁶R¹⁷)_{w}, where one or more nonadjacent (CR¹⁶R¹⁷) groups may be replaced by NR¹³, PR¹⁴, BR¹⁵, O, S, SO, SO₂, CO, CO-O, O-CO;
W is from 2 to 10;
R¹³, R¹⁴, R¹⁵, R¹⁶, R¹⁷ are each H, alkyl, aryl, heteroaryl, alkenyl, alkynyl;
p, p' are each independently 0 or 1;
q, q' are each independently 0 or 1;
Y¹, Y² are each independently hydrogen or a carbon group selected from the group consisting of alkyl, aryl, heteroaryl, alkynyl and alkenyl groups;
or
Y¹ and Y² together form a bridge between the donor atom Do¹ and the nitrogen atom N which has at least two atoms, of which at least one is a carbon atom,
R¹, R²,R^{1'} R^{2'}, are each independently hydrogen, alkyl, aryl, heteroaryl, alkynyl or alkenyl radicals,
or R¹ and R² or R^{1'} and R^{2'} together form a bridge having a total of from three to five atoms, of which 1 to 5 atoms may be heteroatoms and the remaining atoms are carbon atoms, so that the group 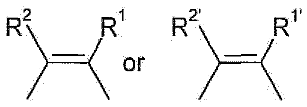
forms a five- to seven-membered ring which optionally - in addiction to the double bond already present - may have one further double bond or - in the case of a six- or seven-membered ring - two further double bonds, and may optionally be substituted by alkyl or aryl groups and/or groups with donor or acceptor action, and may optionally comprise at least one heteroatom, and the five- to seven-membered ring may optionally be fused to one or more further rings;
in addition, Y¹ and R¹ or Y² and R^{1'} may be bonded to one another via a bridge, where the bridge may be defined as follows:
alkylene, arylene, heteroarylene, alkynylene, alkenylene,, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
R³ is hydrogen, an alkyl, aryl, heteroaryl, alkynyl or alkenyl radical;
Y³ is hydrogen, an alkyl, alkynyl or alkenyl radical;
in addiction, Y³ and may be bonded to one another via a bridge, where the bridge may be defined as follows:
alkylene, arylene, heteroarylene, alkynylene, alkenylene, NR²⁵, PR²⁶, BR²⁷, O, S, SO, SO₂, SiR³²R³³, CO, CO-O, O-CO and (CR²⁸R²¹)_{y}, where one or more nonadjacent (CR²⁸R²⁹) groups may be replaced by NR²⁵, PR²⁶, BR²⁷, O, S, SO, SO₂, SiR³²R³³, CO, CO-O, O-CO, where
y is from 2 to 10;
and
R²⁵, R²⁶, R²⁷, R²⁸,R²⁹, R³², R³³ are each H, alkyl, aryl, heteroaryl, alkenyl, alkynyl;
where the radicals, groups and induces R¹, R², Y¹, Y², Do¹, Do², Y³, X, R³, p, q, r, s, R^{1'}, R^{2'}, Do^{2'}, R^{3'} p', q', s' in the different carbene ligands may each be the same or different.

8. A process for preparing heteroleptic carbene complexes of the general formula I according to any of claims 1 to 7, wherein the preparation comprises the following step:
redaction of at least 2 ligand precursors of the general formula (III) 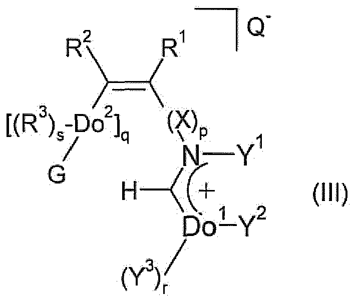 in which
Q⁻ is a monoanionic counterion, preferably halide, pseudohalide, BF₄⁻, BPh₄⁻, PF₆⁻, AsF₆⁻ or SbF₆⁻;
and
G is H when Do² = C or q = 0, and is H or is a free electron pair of the heteroatom when Do² = N, S, O or P;
and
the further symbols in the ligand precursor of the general formula III are each defined as follows:
Do¹ is a donor atom selected from the group consisting of C, P, N, O, S and Si, preferably P, N, O and S;
Do² is a donor atom selected from the group consisting of C, N, P, O and S;
r is 2 when Do¹ is C or Si, is 1 when Do¹ is N or P, and is 0 when Do¹ is O or S;
s is 2 when Do² is C, is 1 when Do² is N or P, and is 0 when Do² is O or S;
X is a spacer selected from the group consisting of silylene, alkylene, arylene, heteroarylene, alkynylene, alkenylene, NR¹³ PR¹⁴, BR¹⁵ O, S, SO, SO₂, CO, CO-O, O-CO and (CR¹⁶R¹⁷)_{w}, where one or more nonadjacent (CR¹⁶R¹⁷) groups may be replaced by NR¹³, PR¹⁴, BR¹⁵, O, S, SO, SO₂, CO, CO-O, O-CO;
w is from 2 to 10;
R¹³, R¹⁴, R¹⁵, R¹⁶, R¹⁷ are each H, alkyl, aryl, heteroaryl, alkenyl, alkynyl;
p is 0 or 1;
q is 0 or 1;
Y¹, Y² are each independently hydrogen or a carbon group selected from the group consisting of alkyl, aryl, heteroaryl, alkynyl and alkenyl groups;
or
Y¹ and Y² together form a bridge between the donor atom Do¹ and the nitrogen atom N, said bridge having at least two atoms of which at least one is a carbon atom,
R¹, R² are each independently hydrogen, alkyl, aryl, heteroaryl, alkynyl or alkenyl radicals,
or
R¹ and R² together form a bridge having a total of from three to five atoms, of which from 1 to 5 atoms may be heteroatoms and the remaining atoms are carbon atoms, so that the group 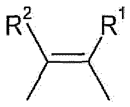 forms a five- to seven-membered ring which - in addiction to the double bond already present - may optionally have one further double bond or - in the case of a six- or seven-membered ring - two further double bounds, and may optionally be substituted by alkyl or aryl groups and/or groups with donor or acceptor action, and may optionally comprise at least one heteroatom, and the five- to seven-membered ring may optionally be fused to one or more further rings;
in addiction, Y¹ and R¹ may be bonded to one another via a bridge, where the bridge may be defined as follows:
alkylene, arylene, heteroarylene, alkynylene, alkenylene, NR¹⁸, PR¹⁹, BR²⁰, 0, S, SO, SO₂, SiR³⁰R³¹, CO, CO-O, O-CO and (GR²¹R²²)ₓ, where one or more nonadjacent (CR²¹R²²) groups may be replaced by NR¹⁸, PR¹⁹, BR²¹, O, S, SO, SO₂, SiR³⁰R³¹, CO, CO-O, O-CO, where
x is from 2 to 10;
and
R¹⁸, R¹⁹, R²⁰, R²¹, R²², R³⁰ R³¹ are each H, alkyl, aryl, heteroaryl, alkenyl, alkynyl;
R³ is hydrogen, an alkyl, aryl, heteroaryl, alkynyl or alkenyl radical;
where
the at least 2 ligand precursors of the general formula III have different definitions of Y³,
where
Y³ in at least one first ligand precursor (IIIa) is defined as follows:
hydrogen, an alkyl, alkynyl or alkenyl radical, where
when Do¹ is C or Si and r is 2, the two Y³ radicals are each as defined above;
and
Y³ in at least one second ligand precursor (IIIb) is defined as follows: 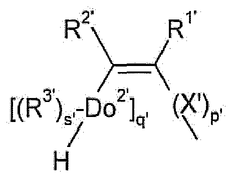 where Do^{2'}, q^{'}, s', R^{3'}, R^{1'}, R^{2'} X' and p' are each independently as defined for Do², q, s, R³, R¹, R²,
X and p, and
when Do¹ is C or Si and r is 2, at least one of the two Y³ radicals is as defined above; the second Y³ radical may be as defined above or be as defined for Y³ with regard to the first ligand precursor;
with a metal complex comprising at least one metal M^{1'}, where M^{1'} is defined as follows:
M^{1'} is a metal atom selected from the group consisting of Ir, Co, Rh, Ni, Pd, Pt, Fe, Ru, Os, Cr, Mo, W, Mn, Tc, Re, Cu and A, preferably Ir, Os, Ru, Rh, Pd, Co and Pt, more preferably Ir, Pt, Rh and Os, in any oxidation state possible for the corresponding metal atom.

9. The process according to claim 8, wherein the metal M^{1'} used is Ir, preferable Ir(I) or Ir(III).

10. The use of heterolepti- carbene complexes according to any of claims 1 to 7 or prepared according to claim 8 or 9 in organic light-emitting diodes.

11. An organic light-emitting diode comprising at least one heteroleptic carbene complex according to any of claims 1 to 7 or prepared according to claim 8 or 9.

12. A light-emitting layer comprising at least one heteroleptic carbene complex according to any of claims 1 to 7 or prepared according to claim 8 or 9.

13. An organic light-emitting diode comprising at least one light-emitting layer according to claim 12.

14. A device selected from the group consisting of stationary visual display units such as visual display units of computers, televisions, visual display units in printers, kitchen appliances and advertising panels, illuminations, information panels and mobile visual display units such as visual display units in cell phones, laptops, digital cameras, vehicles and destination displays on buses and trains, comprising at least one organic light-emitting diode according to claim 11 of 13.

## Revendications

1. Complexes hétéroleptiques de carbone, de formule générale (I)
M¹[carbène]ₙ, (I)
contenant au moins deux ligands carbène différents, formule dans laquelle les symboles ont les significations suivantes :
M¹ représente un atome métallique choisi dans le groupe constitué par Ir, Co, Rh, Ni, Pd, Pt, Fe, Ru, Os, Cr, Mo, W, Mn, Tc, Re, Cu et Au, de préférence Ir, Os, Ru, Rh, Pd, Co et Pt, de façon particulièrement préférée Ir, Pt, Rh et Os, en tout degré d'oxydation possible pour l'atome métallique correspondant ;
n représente le nombre des ligands carbène, n étant au moins 2 ;
n dépendant du degré d'oxydation et de l'indice de coordination de l'atome métallique utilisé et de la denticité ainsi que de la charge des ligands carbènes ;
carbène signifie un ligand carbène de formule générale (II) 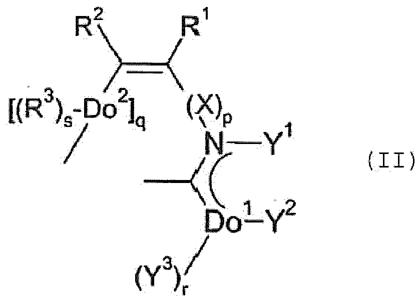 les symboles dans le ligand carbène de formule générale II ayant les significations suivantes :
Do¹ représente un atome donneur choisi dans le groupe constitué par C, P, N, O, S et Si, de préférence P, N, O et S ;
Do² représente un atome donneur choisi dans le groupe constitue par C, N, P, O et S ;
r vaut 2 lorsque Do¹ est C ou Si, 1 lorsque Do¹ est N ou P et 0 lorsque Do¹ est O ou S ;
s vaut 2 lorsque Do² est C, 1 lorsque Do² est N ou P et 0 lorsque Do² est O ou S ;
X représente un espaceur choisi dans l'ensemble constitué par les groupes silylène, alkylène, arylène, hétéroarylène, alcynylène, alcénylène, NR¹³, PR¹⁴, BR¹⁵, O, S, SO, SO₂, CO, CO-O, O-CO et (CR¹⁶R¹⁷)_{w}, un ou plusieurs groupes (CR¹⁶R¹⁷) non contigus pouvant être remplacés par NR¹³, PR¹⁴, BR¹⁵, O, S, SO, SO₂, CO, CO-O, O-CO ;
w vaut de 2 à 10 ;
R¹³, R¹⁴, R¹⁵, R¹⁶, R¹⁷ représentent H, alkyl, aryle, hétéroaryle, alcynyle, alcynyle ;
p vaut 0 ou 1 ;
q vaut 0 ou 1 ;
Y¹, Y² représentent chacun, indépendamment l'un de l'autre, un atome d'hydrogène ou un groupe carboné choisi dans l'ensemble constitué par les groupes alkyle, aryle, hétéroaryle, alcynyle et alcényle, ou Y¹ et Y² forment ensemble un pont entre l'atome donneur Do¹ et l'atome d'azote N, qui comporte au moins deux atomes, dont au moins un est un atome de carbone,
R¹, R² représentent indépendamment l'un de l'autre un atome d'hydrogène, des radicaux alkyle, aryle, hétéroaryle, alcynyle ou alcényle, ou R¹ et R² forment ensemble un pont ayant au total trois à cinq atomes, dont 1 à 5 atomes peuvent être des hétéroatomes et les atomes restants sont des atomes de carbone, de sorte que le groupe 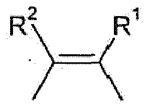 forme un cycle à cinq à sept chaînons, qui peut éventuellement comporter - en plus de la double liaison déjà présente - un - ou dans le cas d'un cycle à six ou sept chaînons - deux autres doubles liaisons et peut éventuellement être substitué par des groupes alkyle ou aryle et/ou des groupes à action de donneur ou d'accepteur et peut éventuellement contenir au moins un hétéroatome, et le cycle à cinq à sept chaînons, peut éventuellement être condensé avec un ou plusieurs autres cycles ;
en outre Y¹ et R¹ peuvent être liés l'un à l'autre par un pont, le pont pouvant avoir les signification suivantes :
alkylène, arylène, hétéroarylène, alcynylène, alcénylène, NR¹⁸, PR¹⁹, BR²⁰, O, S, SO, SO₂, SiR³⁰R³¹, CO, CO-O, O-CO et (CR²¹R²²)ₓ, un ou plusieurs groupes (CR²¹R²²) non contigus pouvant être remplacés par NR¹⁸, PR¹⁹, BR²⁰, O, S, SO, SO₂, SiR³⁰R³¹, CO, CO-O, O-CO,
x valant de 2 à 10 ;
et
R¹⁸, R¹⁹, R²⁰, R²¹, R²², R³⁰, R³¹ représentant H, alkyle, aryle, hétéroaryle, alcényle, alcynyle,
R³ représente un atome d'hydrogène, un radical alkyle, aryle, hétéroaryle, alcynyle ou alcényle ;
caractérisé en ce lesdits au moins 2 ligands carbène ont des significations de Y³ différentes,
Y³ dans au moins un premier ligand carbène (IIa) ayant la signification suivante :
un atome d'hydrogène, un radical alkyle, alcynyle ou alcényle,
lorsque Do¹ est C ou Si et r vaut 2, les deux radicaux Y³ ayant les significations indiquées précédemment
et
Y³ dans au moins un deuxième ligand carbène (IIb) ayant la signification suivante : 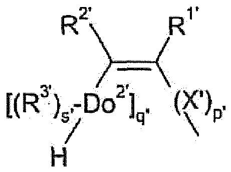 Do^{2'}, q', s', R^{3'}, R^{1'}, R^{2'}, X' et p' ont indépendamment les uns des autres, les mêmes significations que Do², q, s, R³, R¹, R², X et p, et
lorsque Do¹ est C ou Si et r représente 2, au moins l'un des deux radicaux Y³ ayant la signification indiquée précédemment ; le second radical Y³ pouvant avoir la signification indiquée précédemment ou les significations données pour Y³ en ce qui concerne le premier ligand carbène ;
et
Y³ dans un troisième ou autre ligand carbène dans des complexes hétéroleptiques de carbènes de formule générale I dans laquelle n est > 2, ayant soit les significations indiquées dans le premier ligand carbène (IIa)n soit les significations indiquées dans le deuxième ligand carbènes (IIb) ;
en outre Y³ et Y² peuvent dans chacun des n ligands carbène être liés l'un à l'autre par un pont, le pont pouvant avoir les significations suivantes :
alkylène, arylène, hétéroarylène, alcynylène, alcénylène, NR²⁵, PR²⁶, BR²⁷, O, S, SO, SO₂, SiR³²R³³, CO, CO-O, O-CO et (CR²⁸R²⁹)_{y}, un ou plusieurs groupes (CR²⁸R²⁹) non contigus pouvant être remplacés par NR²⁵, PR²⁶ BR²⁷, O, S, SO, SO₂, SiR³²R³³, CO, CO-O, O-CO,
y valant de 2 à 10 ;
et
R²⁵, R²⁶, R²⁷ R²⁸, R²⁹, R³², R³³ représentant H, alkyle, aryle, hétéroaryle, alcényle, alcynyle.

2. Complexes de carbènes selon la revendication 1, **caractérisées en ce que** le groupement 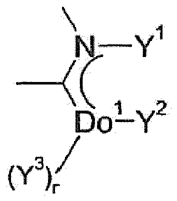 est choisi dans l'ensemble constitué par 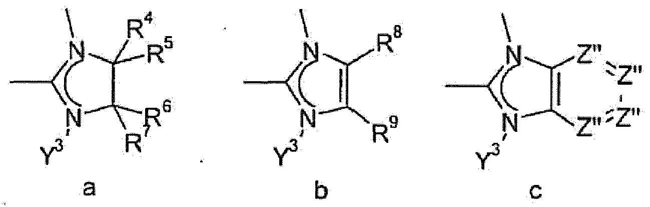 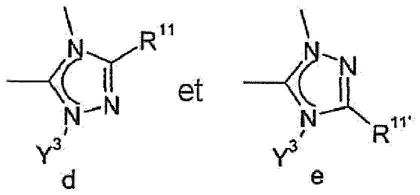 où les symboles ont les significations suivantes
Z" représente chaque fois indépendamment CR¹⁰ ou N ;
R⁴, R⁵, R⁶, R⁷, R⁸, R⁹, R¹¹ et R^{11'} représentent un atome d'hydrogène, un groupe alkyle, aryle, hétéroaryle, alcynyle ou alcényle ou un substituant à action de donneur ou d'accepteur;
R¹⁰ représente un atome d'hydrogène, un groupe alkyle, aryle, hétéroaryle, alcynyle ou alcényle ou chaque fois 2 radicaux R¹⁰ forment ensemble un cycle condensé, qui peut éventuellement contenir au moins un hétéroatomes, ou R¹⁰ représente un radical à action de donneur ou d'accepteur ; de préférence au moins un radical R¹⁰ représentant H, de façon particulièrement préférée au moins deux radicaux R¹⁰ représentant H, de façon tout particulièrement préférée trois ou quatre radicaux R¹⁰ représentant H ;
en outre R⁴ ou R⁵ dans le groupement a, R⁸ dans le groupement b, l'un des radicaux R¹⁰ dans le groupement c et R¹¹ dans le groupement d peuvent être liés à R¹ par un pont, le pont pouvant avoir les significations suivantes :
alkyléne, arylène, hétéroarylène, alcynylène, alcénylène, NR¹⁸, PR¹⁹, BR²⁰, O, S, SO, SO₂, SiR³⁰R³¹, CO, CO-O, O-CO et (CR²¹R²²)ₓ, un ou plusieurs groupes (CR²¹R²²) non contigus pouvant être remplacés par NR¹⁸, PR¹⁹, BR²⁰, O, S, SO, SO₂, SiR³⁰R³¹, CO, CO-O, O-CO,
x valant de 2 à 10 ;
et
R¹⁸, R¹⁹, R²⁰, R²¹, R²², R³⁰, R³¹ représentant H, alkyl, aryle, hétéroaryle, alcényle, alcynyle ;
et
Y³ dans au moins un premier ligand carbène (IIa) ayant la signification suivante :
un atome d'hydrogène, un radical alkyle, alcynyle ou alcényle ;
et
Y³ dans au moins une deuxième ligand carbène (IIb) ayant la signification suivante : 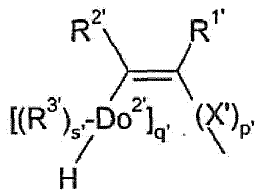 Do^{2'}, q', s', R^{3'}, R^{1'}, R^{2'}, X' et p' ayant indépendamment les mêmes significations que Do², q, s, R³, R¹, R², X et p.

3. Complexes de carbènes selon la revendication 1 ou 2, **caractérisés en ce que** le groupement 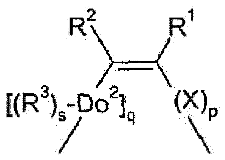 représente la structure 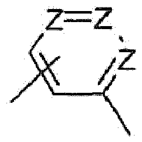 dans laquelle les symboles ont les significations suivantes :
Z représente chaque fois indépendamment CR¹² ou N, 0 à 3 symboles Z pouvant représenter N ;
R¹² dans les groupes Z représentent chacun indépendamment H, un radical alkyle, aryle, hétéroaryle, alcynyle, alcényle, ou chaque fois 2 radicaux R¹² forment ensemble un cycle condensé, qui peut éventuellement contenir au moins un hétéroatomes, ou R¹² représente un radical à action de donneur ou d'accepteur ;
en outre le groupe de structure 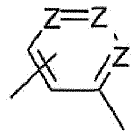 peut être lié, par l'intermédiaire du corps de base aromatique ou par l'intermédiaire d'un des radicaux R¹², à Y¹ par un pont, le pont pouvant avoir les significations suivantes :
alkylène, arylène, hétéroarylène, alcynylène, alcénylène, NR¹⁸, PR¹⁹, BR²⁰, 0, S, SO, SO₂, SiR³⁰R³¹, CO, CO-O, O-CO et (CR⁷¹R²²)ₓ, un ou plusieurs groupes (CR²¹R²²) non contigus pouvant être remplacés par NR¹⁸, PR¹⁹, BR²⁰, O, S, SO, SO₂, SiR³⁰R³¹, CO, CO-O, O-CO,
x valant de 2 à 10 ;
et
R¹⁸, R¹⁹, R²⁰, R²¹, R²², R³⁰, R³¹ représentant H, alkyle, aryle, hétéroaryle, alcényle, alcynyle.

4. Complexes de carbènes selon l'une quelconque des revendications 1 à 3, **caractérisés en ce qu'**au moins un premier ligand carbène (IIa) est choisi dans l'ensemble constitue par 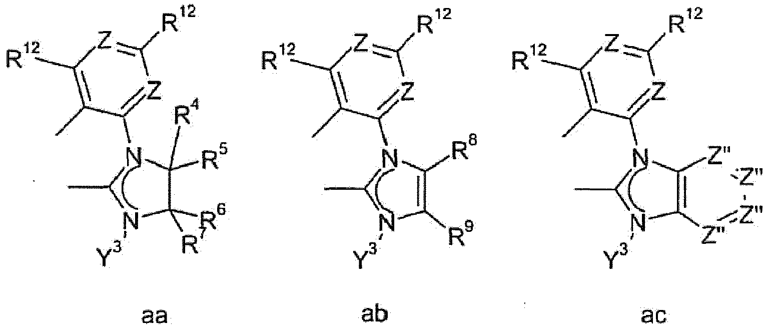 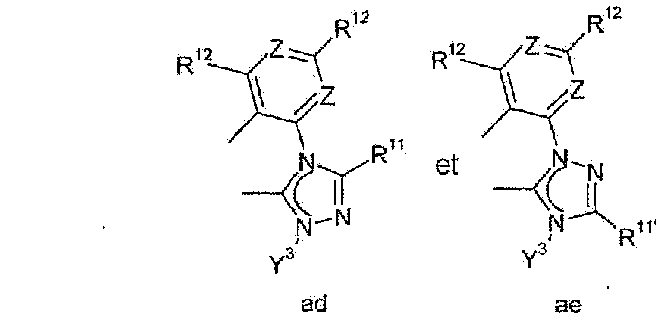 où les symboles ont les significations suivante :
Z le même ou différent, représente CR¹² ou N ;
Z" le même ou différent, représente CR¹⁰ ou N ;
R¹² représente chaque fois indépendamment H, un groupe alkyle, aryle, hétéroaryle, alcynyle ou alcényle ou chaque fois 2 radicaux R¹² forment ensemble un cycle condensé, qui peut éventuellement contenir au moins un hétéroatome, ou R¹² représente un radical à action de donneur ou d'accepteur;
R⁴, R⁵, R⁶ R⁷, R⁸, R⁹, R¹¹ et R^{11'} représentant un atome d'hydrogène, un groupe alkyle, aryle, hétéroaryle, alcynyle ou alcényle ou un radical à action de donneur ou d'accepteur;
R¹⁰ dans les groupes Z" représente chaque fois indépendamment H, un groupe alkyle, aryle, hétéroaryle, alcynyle ou alcényle ou chaque fois 2 radicaux R¹⁰ forment ensemble un cycle condensé, qui peut éventuellement contenir au moins un hétéroatome, ou R¹⁰ représente un radical à action de donneur ou d'accepteur ;
en outre le groupe de structure 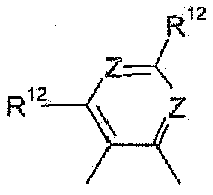 peut être lié, par l'intermédiaire du corps de base aromatique ou par l'intermédiaire d'un des radicaux R¹² par un pont à R⁴ ou R⁵ ou à l'atome de carbone auquel R⁴ et R⁵ sont liés, dans le groupement aa, R⁸ ou à l'atomes de carbone auquel R⁸ est lié, dans le groupement ab, à l'un des radicaux R¹⁰ ou à l'un des atomes de carbone auquel R¹⁰ est lié, dans le groupement ac et R¹¹ ou l'atome de carbone auquel R¹¹ est lié, dans le groupement ad, le pont pouvant avoir les significations suivantes :
alkylène, arylène, hétéroarylène, alcynylène, alcénylène, NR¹⁸, PR¹⁹, BR²⁰, O, S, SO, SO₂, SiR³⁰R³¹, CO, CO-O, O-CO et (CR²¹R²²) un ou plusieurs groupes (CR²¹R²²) non contigus pouvant être remplacés par NR¹⁸ PR¹⁹, BR²⁰, O, S, SO, SO₂, SiR³⁰R³¹, CO, CO-O, O-CO,
x valant de 2 à 10 ;
et
R¹⁸, R¹⁹, R²⁰, R²¹, R²², R³⁰, R³¹ représentant H, alkyle, aryle, hétéroaryle, alcényle, alcynyle ;
dans les cas où le groupe de structure 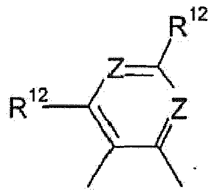 est lié par un pont à l'atome de carbone auquel R⁴ et R⁵ sont liés (groupement aa), à l'atome de carbone auquel R⁸ est lié (groupement ab), à l'un des atomes de carbone auquel R¹⁰ est lié (groupement ac) ou à l'atome de carbone auquel R¹¹ est lié (groupement ad), le radical respectif R⁴ ou R⁵, R⁸, l'un des radicaux R¹⁰ ou R¹¹ est remplacé par une liaison avec le point ;
Y³ représente un radical alkyle, alcynyle ou alcényle.

5. Complexes de carbènes selon l'une quelconque des revendications 1 à 4, **caractérisés en ce qu'**au moins un deuxième ligand carbène (IIb) est choisi dans l'ensemble constitué par 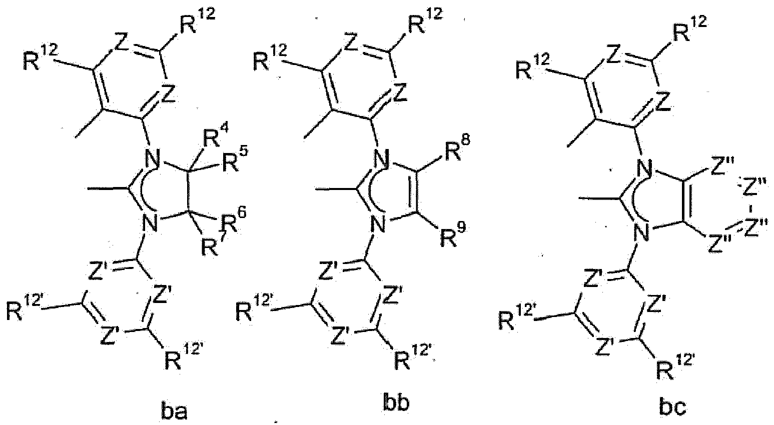 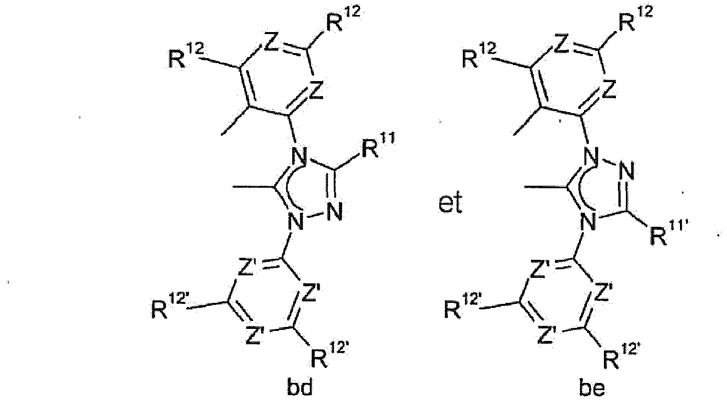 où les symboles ont les significations suivantes :
Z le même ou différent, représente CR¹² ou N ;
Z' le même ou différent, représente CR^{12'} ou N ;
Z'' le même ou différent, représente CR¹⁰ ou N ;
R¹², R^{12'} identiques ou différents, représentent chacun, indépendamment l'un de l'autre, H, un radical alkyle, aryle, hétéroaryle, alcynyle ou alcényle ou chaque fois 2 radicaux R¹² ou R^{12'} forment ensemble un cycle condensé, qui peut éventuellement contenir au moins un hétéroatome, ou R¹² ou R^{12'} représente un radical à action de donneur ou d'accepteur;
R⁴, R⁵, R⁶, R⁷, R⁸, R⁹, R¹¹ et R^{11'} représentent un atome d'hydrogène, un groupe alkyle, aryle, hétéroaryle, alcynyle ou alcényle ou un radical à action de donneur ou d'accepteur ;
R¹⁰ dans les groupes Z" représente chaque fois indépendamment H, un groupe alkyle, aryle, hétéroaryle, alcynyle ou alcényle ou chaque fois 2 radicaux R¹⁰ forment ensemble un cycle condensé, qui peut éventuellement contenir au moins un hétéroatomes, ou R¹⁰ représente un radical à action de donneur ou d'accepteur ;
en outre le groupe de structure 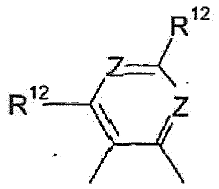 peut être lié, par intermédiaire du corps de base aromatique ou par l'intermédiaire d'un des radicaux R¹², par un pont à R⁴ ou R⁵ ou à l'atome de carbone auquel R⁴ et R⁵ sont liés, dans le groupement ba, R⁸ ou à l'atome de carbone auquel R⁸ est lié, dans le groupement bb, à l'un des radicaux R¹⁰ ou à l'un des atomes de carbone auquel R¹⁰ est lié, dans le groupement bc et R¹¹ ou l'atome de carbone auquel R¹¹ est lié, dans le groupement bd, le pont pouvant avoir les significations suivantes :
alkylène, arylène, hétéroarylène, alcynylène, alcénylène, NR¹⁸, PR¹⁹, BR²⁰, O, S, SO, SO₂, SiR³⁰R³¹, CO, CO-O, 0-CO et (CR²¹R²²)ₓ, un ou plusieurs groupes (CR²¹R²²) non contigus pouvant être remplacés par NR¹⁸, PR¹⁹, BR²⁰, O, S, SO, SO₂, SiR³⁰R³¹, CO, CO-O, O-CO,
x valant de 2 à 10 ;
et
R¹⁸, R¹⁹, R²⁰, R²¹, R²², R³⁰, R³¹ représentant H, alkyle, aryle, hétéroaryle, alcényle, alcynyle ;
dans les cas où le groupe de structure 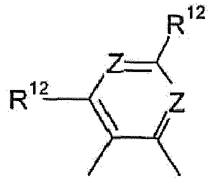 est lié par un pont à l'atome de carbone auquel R⁴ et R⁵ sont liés (groupement ba), à l'atome de carbone auquel R⁸ est lié (groupement bb), à l'un des atomes de carbone auquel R¹⁰ est lié (groupement bc) ou à l'atome de carbone auquel R¹¹ est lié (groupement bd), le radical respectif R⁴ ou R⁵, R⁸, l'un des radicaux R¹⁰ ou R¹¹ est remplacé par une liaison avec le pont ;

6. Complexes de carbènes selon l'une quelconque des revendications 1 à 5, **caractérisés en ce que** M¹ est Ir (III) et n est 3.

7. Complexes de carbènes selon la revendication 6, choisis parmi des complexes de carbènes de formules (Ii) et (Iii) 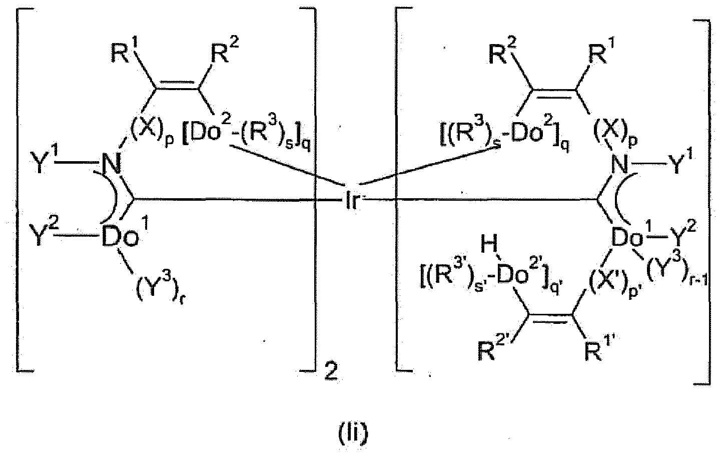 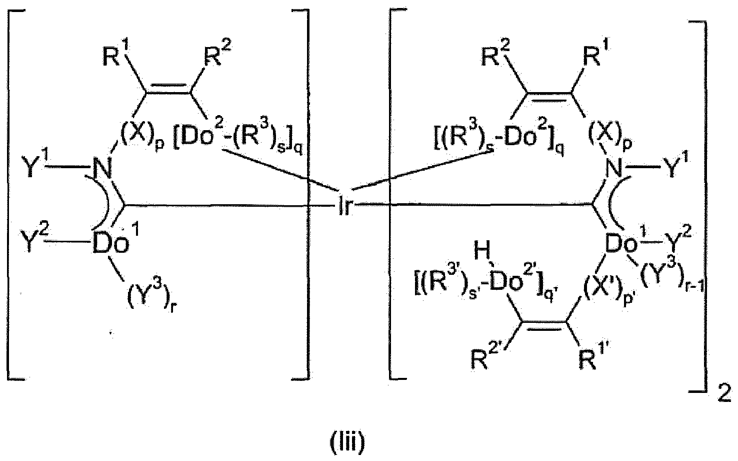 les symboles dans les complexes de carbènes de formules générales (Ii) et (Iii) ayant les significations suivantes :
Do¹ représente un atome donneur choisi dans le groupe constitué par C, P, N, O, S et Si, de préférence P, N, O et S ; dans le ligand carbène 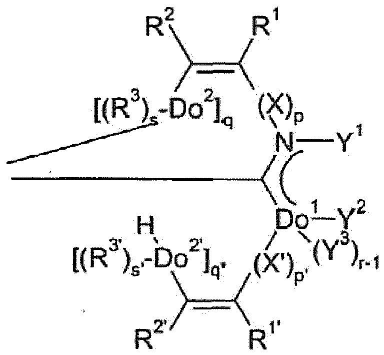 Do¹ ne représentant pas O ni S ;
Do², Do^{2'} représentant indépendamment l'un de l'autre un atome donneur choisi dans le groupe constitué par C, N, P, O et S ;
r vaut 2 lorsque Do¹ est C ou Si, 1 lorsque Do¹ est N ou P et 0 lorsque Do¹ est O ou S ;
s, s' valent 2 lorsque Do² ou Do^{2'} est C, 1 lorsque Do² ou Do^{2'} est N ou P et 0 lorsque Do² ou Do^{2'} est O ou S ;
X, X' représentent, indépendamment l'un de l'autre, un espaceur choisi dans l'ensemble constitué par les groupes silylène, alkylène, arylène, hétéroarylène, alcynylène, alcénylène, NR¹³, PR¹⁴, BR¹⁵, O, S, SO, SO₂, CO, CO-O, O-CO et (CR¹⁶R¹⁷)_{w}, un ou plusieurs groupes (CR¹⁶R¹⁷) non contigus pouvant être remplacés par NR¹³, PR¹⁴, BR¹⁵, O, S, SO, SO₂, CO, CO-O, O-CO ;
w vaut de 2 à 10 ;
R¹³, R¹⁴, R¹⁵, R¹⁶, R¹⁷ représentent H, alkyle, aryle, hétéroaryle, alcényle, alcynyle ;
p, p' valent, indépendamment l'un de l'autre, 0 ou 1 ;
q, q' valent, indépendamment l'un de l'autre, 0 ou 1 ;
Y¹, Y² représentent chacun, indépendamment l'un de l'autre, un atome d'hydrogène ou un groupe carboné choisi dans l'ensemble constitué par les groupes alkyl, aryle, hétéroaryle, alcynyle et alcényle ; ou Y¹ et Y² forment ensemble un pont entre l'atome donneur Do¹ et l'atome d'azote N, qui comporte au moins deux atomes, dont au moins un est un atome de carbone,
R¹, R², R^{1'}, R^{2'} représentent indépendamment l'un de l'autre un atome d'hydrogène, des radicaux alkyl, aryle, hétéroaryle, alcynyle ou alcényle, ou R¹ et R² ou, respectivement, R^{1'} et R^{2'} forment ensemble un pont ayant au total trois à cinq atomes, dont 1 à 5 atomes peuvent être des hétéroatomes et les atomes restants sont des atomes de carbone, de sorte que le groupe 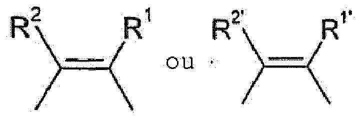 forme un cycle à cinq à sept chaînons, qui peut éventuellement comporter - en plus de la double liaison déjà présente - un - ou dans le cas d'un cycle à six ou sept chaînons - deux autres doubles liaisons et peut éventuellement être substitué par des groupes alkyle ou aryle et/ou des groupes à action de donneur ou d'accepteur et peut éventuellement contenir au moins un hétéroatomes, et le cycle à cinq à sept chaînons peut éventuellement être condensé avec un ou plusieurs autres cycles ;
en outre Y¹ et R¹ ou, respectivement, Y² et R^{1'} peuvent être liés l'un à l'autre par un pont, le pont pouvant avoir les significations suivantes :
alkylène, arylène, hétéroarylène, alcynylène, alcénylène, NR¹⁸, PR¹⁹, BR²⁰, O, S, SO, SO₂, SiR³⁰R³¹, CO, CO-O, 0-CO et (CR²¹R²²)ₓ, un ou plusieurs groupes (CR²¹R²²) non contigus pouvant être remplacés par NR¹⁸, PR¹⁹, BR²⁰, O, S, SO, SO₂, SiR³⁰R³¹, CO, CO-O, O-CO,
x valant de 2 à 10 ;
et
R¹⁸, R¹⁹, R²⁰, R²¹, R²², R³⁰, R³¹ représentant H, alkyle, aryle, hétéroaryle, alcynyle, alcynyle ;
R³ représente un atome d'hydrogène, un radical alkyl, aryle, hétéroaryle, alcynyle ou alcényle ;
Y³ représente un atome d'hydrogène, un radical alkyle, alcynyle ou alcényle ;
en outre Y³ et Y² peuvent être liés l'un à l'autre par un pont, le pont pouvant avoir les significations suivantes :
alkylène, arylène, hétéroarylène, alcynylène, alcénylène, NR²⁵, PR²⁶, BR²⁷, O, S, SO, SO₂, SiR³²R³³, CO, CO-O, O-CO et (CR²⁸R²⁹)_{y}, un ou plusieurs groupes (CR²⁸R²⁹) non contigus pouvant être remplacés par NR²⁵, PR²⁶, BR²⁷, O, S, SO, SO₂, SiR³²R³³, CO, CO-O, O-CO,
y valant de 2 à 10 ;
et
R²⁵, R²⁶, R²⁷, R^{28,} R²⁹, R³², R³³ représentant H, alkyle, aryle, hétéroaryle, alcényle, alcynyle ;
les radicaux, groupes et indices R¹, R², Y¹, Y², Do¹, Do², Y³, X, R³, p, q, r, s, R^{1'}, R^{2'}, Do^{2'}, R^{3'}, p', q', s' dans les divers ligands carbène pouvant chaque fois être identiques ou différents.

8. Procédé pour la préparation de complexes hétéroleptiques de carbènes de formule générale I selon l'une quelconque des revendications 1 à 7, **caractérisé en ce que** la préparation comprend les étapes suivantes :
mise en réaction d'au moins deux précurseurs de ligands de formule générale (III) 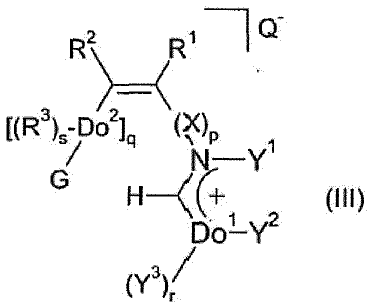 dans laquelle
Q⁻ représente un ion opposé monoanionique, de préférence un halogénure, un pseudo-halogénure, BF₄⁻, BPh₄⁻ , PF₆⁻, AsF₆⁻ ou SbF₆⁻ ;
et
G lorsque Do² est = C ou q = 0, représente H, et lorsque Do₂ est = N, S, O ou P, représente H ou une paire d'électrons libre de l'hétéroatome ;
et
les autres symboles dans le précurseur de ligand de formule générale III ont les significations suivantes :
Do¹ représente un atome donneur choisi dans le groupe constitué par C, P, N, 0, S et Si, de préférence P, N, O et S ;
Do² représente un atome donneur choisi dans le groupe constitué par C, N, P, O et S ;
r vaut 2 lorsque Do¹ est C ou Si, 1 lorsque Do¹ est N ou P et 0 lorsque Do¹ est O ou S ;
s vaut 2 lorsque Do² est C, 1 lorsque Do² est N ou P et 0 lorsque Do² est O ou S ;
X représente un espaceur choisi dans l'ensemble constitué par les groupes silylène, alkylène, arylène, hétéroarylène, alcynylène, alcénylène, NR¹³, PR¹⁴, BR¹⁵, O, S, SO, SO₂, CO, CO-O, O-CO et (CR¹⁶R¹⁷)_{w}, un ou plusieurs groupes (CR¹⁶R¹⁷) non contigus pouvant être remplacés par NR¹³, PR¹⁴, BR¹⁵, O, S, SO, SO₂, CO, CO-O, O-CO ;
w vaut de 2 à 10 ;
R¹³, R¹⁴, R¹⁵, R¹⁶, R¹⁷ représentent H, alkyle, aryle, hétéroaryle, alcényle, alcynyle ;
p vaut 0 ou 1 ;
q vaut 0 ou 1 ;
Y¹, Y² représentent chacun, indépendamment l'un de l'autre, un atome d'hydrogène ou un groupe carboné choisi dans l'ensemble constitué par les groupes alkyle, aryle, hétéroaryle, alcynyle et alcényle ;
ou Y¹ et Y² forment ensemble un pont entre l'atome donneur Do¹ et l'atome d'azote N, qui comporte au moins deux atomes, dont au moins un est un atome de carbone,
R¹, R² représentent indépendamment l'un de l'autre un atome d'hydrogène, des radicaux alkyle, aryle, hétéroaryle, alcynyle ou alcényle, ou R¹ et R² forment ensemble un pont ayant au total trois à cinq atomes, dont 1 à 5 atomes peuvent être des hétéroatomes et les atomes restants sont des atomes de carbone, de sorte que le groupe 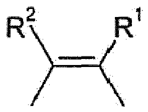 forme un cycle à cinq à sept chaînons, qui peut éventuellement comporter - en plus de la double liaison déjà présenté - un - ou dans le cas d'un cycle à six ou sept chaînons - deux autres doubles liaisons et peut éventuellement être substitué par des groupes alkyle ou aryle et/ou des groupes à action de donneur ou d'accepteur et peut éventuellement contenir au moins un hétéroatomes, et le cycle à cinq à sept chaînons peut éventuellement être condensé avec un ou plusieurs autres cycles ;
en outre Y¹ et R¹ peuvent être liés l'un à l'autre par un pont, le pont pouvant avoir les significations suivantes :
alkylène, arylène, hétéroarylène, alcynylène, alcénylène, NR¹⁸, PR¹⁹, BR²⁰, O, S, SO, SO₂, SiR³⁰R³¹, CO, CO-O, O-CO et (CR²¹R²²)ₓ, un ou plusieurs groupes (CR²¹R²²) non contigus pouvant être remplacés par NR¹⁸, PR¹⁹, BR²⁰, O, S, SO, SO₂, SiR³⁰R³¹, CO, CO-O, 0-cl,
x valant de 2 à 10 ;
et
R¹⁸, R¹⁹, R²⁰ R²¹, R²², R³⁰, R³¹ représentant H, alkyle, aryle, hétéroaryle, alcényle, alcynyle ;
R³ représente un atome d'hydrogène, un radical alkyle, aryle, hétéroaryle, alcynyle ou alcynyle ;
lesdits au moins 2 précurseurs de ligands de formule générale III ayant des significations de Y³ différentes, Y³ dans au moins un premier précurseur de ligand (IIIa) ayant la signification suivante :
un atome d'hydrogène, un radical alkyle, alcynyle ou alcényle,
lorsque Do¹ est C ou Si et r vaut 2, les deux radicaux Y³ ayant les significations indiquées précédemment ;
et
Y³ dans au moins un deuxième précurseur de ligand (IIIb) ayant la signification suivante : 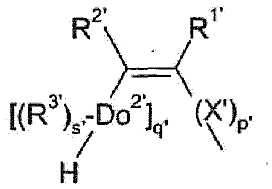 Do^{2'}, q', s', R^{3'}, R^{1'}, R^{2'}, X' et p' ayant indépendamment les mêmes significations que Do², q, s, R³, R¹, R², X et p, et
lorsque Do¹ est C ou Si et r représente 2, au moins l'un des deux radicaux Y³ ayant la signification indiquée précédemment ; le second radical Y³ pouvant avoir la signification indiquée précédemment ou les significations données pour Y³ en ce qui concerne le premier précurseur de ligand ;
avec un complexe métallifère contenant au moins un métal M^{1'}, M^{1'} ayant les significations suivantes :
M^{1'} représente un atome métallique choisi dans le groupe constitué par Ir, Co, Rh, Ni, Pd, Pt, Fe, Ru, Os, Cr, Mo, W, Mn, Tc, Re, Cu et Au, de préférence Ir, Os, Ru, Rh, Pd, Co et Pt, de façon particulièrement préférée Ir, Pt, Rh et Os, en tout degré d'oxydation possible pour l'atome métallique correspondant.

9. Procédé selon la revendication 8, **caractérisé en ce qu'**on utilise comme métal M^{1'} Ir, de préférence Ir(I) ou Ir(III).

10. Utilisation de complexes hétéroleptiques de carbènes selon l'une quelconque des revendications 1 à 7 ou préparés selon la revendication 8 ou 9, dans des diodes électroluminescentes organiques.

11. Diode électroluminescente organique contenant au moins un complexe hetéroleptique de carbènes selon l'une quelconque des revendications 1 à 7 ou préparé selon la revendication 8 ou 9.

12. Couche photoémettrice contenant au moins un complexe hetéroleptique de carbènes selon l'une quelconque des revendications 1 à 7 ou préparé selon la revendication 8 ou 9.

13. Diode électroluminescente organique contenant au moins une couche photoémettrice selon la revendication 12.

14. Dispositif choisi dans le groupe constitué par des écrans fixes tels que des écrans d'ordinateurs, des téléviseurs, des écrans dans des imprimantes, des appareils de cuisine ainsi que des tableaux publicitaires, des éclairages, des tableaux indicateurs et des écrans mobiles tels que des écrans dans des téléphones portables, des ordinateurs portables, des appareils photographiques numériques, des véhicules ainsi que des afficheurs de destination dans des autobus et des trains, contenant au moins une diode électroluminescente organique selon la revendication 11 ou 13.
